Europäisches Patentamt

European Patent Office

Office européen des brevets

(19)

(11) EP 1 492 154 A2

(12) EUROPEAN PATENT APPLICATION

(43) Date of publication:
29.12.2004 Bulletin 2004/53

(51) Int Cl.$^7$: H01J 37/32

(21) Application number: 04102994.3

(22) Date of filing: 28.06.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 26.06.2003 KR 2003042111
01.07.2003 KR 2003044396
07.07.2003 KR 2003045642
16.07.2003 KR 2003048645
26.08.2003 KR 2003059138

(71) Applicant: Adaptive Plasma Technology
Corporation
Suwon-city, Kyungki-do (KR)

(72) Inventors:
• Kim, Nam Hun
Suwon-city, Kyungki-do (KR)
• Kim, Joon Hun
Seoul (KR)

(74) Representative: Stanley, David William
Stanleys,
Intellectual Property,
Kings Court,
12 King Street
Leeds, Yorkshire LS1 2HL (GB)

(54) **Coil for plasma generating source**

(57)    A plasma source coil 200 for use in a plasma chamber receives power from a power supply to generate plasma uniformly in a predetermined reaction space. The plasma source coil 200 includes m (here, m ≥ 2, and m is an integer) unit coils 201 to 204, each of which has a number n of turns (here, n is a positive real number). The unit coils 201 to 204 extend from a coil bushing 210, which is located in the centre of the plasma source coil 200 and has a predetermined radius, and are arranged in a spiral shape around the coil bushing 210.

FIG. 2

EP 1 492 154 A2

**Description**

The present invention relates to plasma source coils for generating plasma and plasma chambers using the same and is concerned particularly, although not exclusively, with such coils and chambers that may be used in semiconductor manufacturing apparatus.

Ultra-Large Scale Integration (ULSI) technology has developed remarkably during the past twenty years. This has been possible because semiconductor manufacturing techniques, which had reached technical limits, could be supported by semiconductor manufacturing apparatuses. A plasma chamber, as one of these semiconductor manufacturing apparatuses, is widely used in various applications covering not only etch processes but also deposition processes.

Plasma chambers are used to generate plasma and to perform etch processes, deposition processes and the like using the generated plasma. The plasma chambers employ various plasma generating sources, which can be categorized into an electron cyclotron resonance (ECR) plasma source, a helicon-wave excited plasma (HWEP) source, a capacitively coupled plasma (CCP) source, or an inductively coupled plasma (ICP) source. The ICP source supplies radio frequency (RF) power to an induction coil to generate a magnetic field. An electric field induced by the magnetic field stores electrons in the centre of a plasma chamber to generate high-density plasma even at low pressure. The ICP source is broadly used since it is structurally simpler than the ECR plasma source or the HWEP source and facilitates the generation of large-area plasma.

In a plasma chamber using the ICP source, a large RF current flows through a coil constituting an inductor of a resonance circuit. Here, the amount of RF current significantly affects the distribution of generated plasma in the plasma chamber. Generally, it is well known that a coil constituting an inductor has its own resistance. Hence, as a current flows through the coil, energy is dissipated due to the coil's resistance and converted to heat. As a result, the amount of current flowing through the coil decreases. If the amount of current flowing through the coil is non-uniform, the plasma generated in the chamber may be non-uniformly distributed.

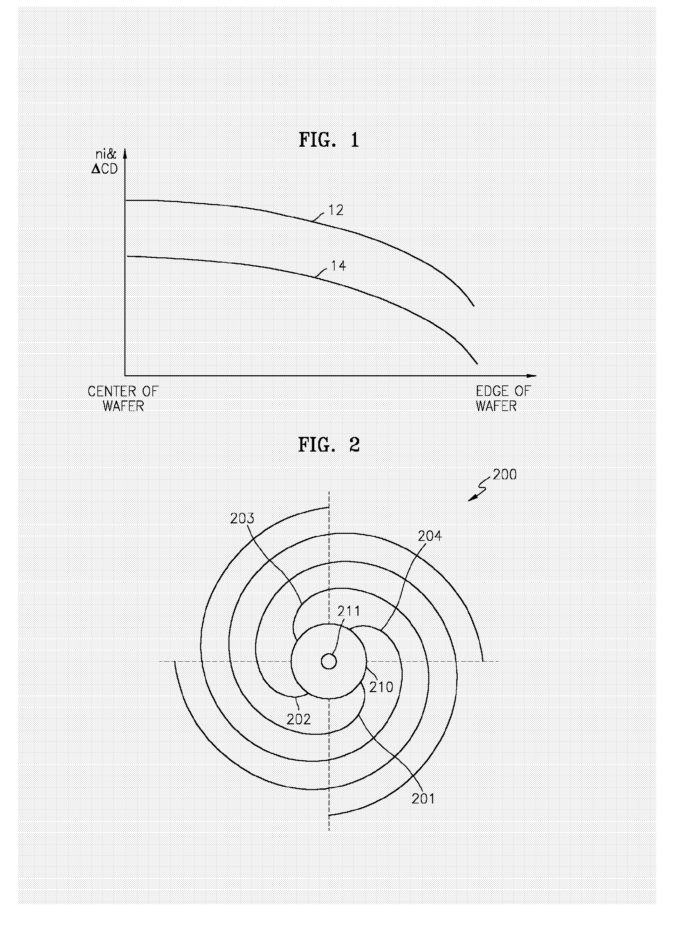

Figure 1 is a graph showing the distribution of the density $n_i$ of plasma and the rate $\Delta CD$ of change in critical dimension (CD) in a conventional semiconductor manufacturing plasma apparatus with a plasma source coil. Hereinafter, a difference between a CD expected before a process is performed and a CD obtained after the process is performed will be referred to as a rate $\Delta CD$ of change in CD.

In Figure 1, as can be seen from curve 12 showing the density $n_i$ of plasma, while the centre of a wafer has the greatest density $n_i$ of plasma, an edge of the wafer has the smallest density $n_i$ of plasma. As can be seen from a curve 14 showing the rate $\Delta CD$ of change in CD, similarly to the density $n_i$ of plasma, while

the centre of the wafer has the greatest rate $\Delta CD$ of change in CD, the edge of the wafer has the smallest rate $\Delta CD$ of change in CD.

Conventionally, many attempts have been made to solve the problem of non-uniform density of plasma by using improved processes. However, various manufacturing processes, such as a lithography process, are bound by technical limits and fail to obtain a uniform density of plasma. Therefore, developing a semiconductor manufacturing plasma apparatus capable of generating uniform plasma on its own is required.

Even if uniform plasma can be generated, the rate $\Delta CD$ of change in CD in the centre of the wafer may still differ from that in the edge of the wafer during, for example, an etch process using a plasma chamber. During the etch process, chemical reactions occur, thus generating by-products. There is a difference in a diffusing speed of removing the by-products between the centre of the wafer and the edge thereof. That is, whereas the diffusing speed of removing by-products is relatively low in the centre of the wafer, the diffusing speed of removing the by-products is relatively high in the edge of the wafer. To solve this problem, the etch rate should be reduced in the edge of the wafer. Also, a plasma source coil having various structures capable of controlling the density of plasma is required.

According to various aspects of the present invention, there are provided plasma source coils and plasma chambers according to the main claims and subclaims 1 to 62 appended hereto.

For a better understanding of the invention, and to show how embodiments of the same may be carried into effect, reference will now be made, by way of example, to the accompanying diagrammatic drawings, in which:

Figure 1 is a graph showing the distribution of the density $n_i$ of plasma and the rate $\Delta CD$ of change in CD in a conventional semiconductor manufacturing plasma apparatus with a plasma source coil;

Figure 2 is a plan view of a plasma source coil according to an embodiment of the present invention;

Figure 3 is a cross-sectional view of a plasma chamber including the plasma source coil of Figure 2;

Figure 4A is a plan view of a plasma source coil according to another embodiment of the present invention;

Figure 4B is a graph showing a variation of an interval between portions of a unit coil according to a radial distance from the centre of a coil in the plasma source coil of Figure 4A;

Figure 5A is a plan view of a plasma source coil according to another embodiment of the present invention;

Figure 5B is a graph showing a variation of a sectional area of a coil according to a radial distance from the centre of the coil in the plasma source coil of Figure 5A;

Figure 5C is a graph showing a variation of an interval between portions of a unit coil according to the radial distance from the centre of the coil in the plasma source coil of Figure 5A;

Figure 6A is a plan view of a plasma source coil according to another embodiment of the present invention;

Figure 6B is a graph showing a variation of a sectional area of a coil according to a radial distance from the centre of the coil in the plasma source coil of Figure 6A;

Figure 6C is a graph showing a variation of an interval between portions of a unit coil according to the radial distance from the centre of the coil in the plasma source coil of Figure 6A;

Figures 7A through 7K are plan views illustrating shapes of coil bushings of the plasma source coils according to embodiments of the present invention;

Figures 8A through 8E show various sectional shapes of unit coils of plasma source coils according to embodiments of the present invention;

Figures 9 and 10 are plan views of plasma source coils according to another embodiment of the present invention;

Figure 11 is a cross-sectional view of a dome of the plasma chamber of Figure 3;

Figures 12 through 45 are cross-sectional views of domes and plasma source coils of plasma chambers according to embodiments of the present invention;

Figure 46 shows a plasma source coil according to another embodiment of the present invention;

Figure 47 is a cross-sectional view of a plasma chamber using the plasma source coil of Figure 46;

Figure 48 is a plan view of a plasma source coil according to another embodiment of the present invention;

Figure 49 is a plan view of a plasma source coil according to another embodiment of the present invention;

Figure 50 is a cross-sectional view of a plasma chamber using the plasma source coil of Figure 49;

Figure 51A is a plan view of a plasma source coil according to another embodiment of the present invention;

Figure 51B is a cross-sectional view taken along line IB-IB' of Figure 51A;

Figures 52 through 67 show plasma source coils according to another embodiments of the present invention;

Figure 68 is a cross-sectional view of a plasma chamber according to another embodiment of the present invention;

Figure 69 shows an example of a plasma source coil of the plasma chamber of Figure 68;

Figure 70 is a cross-sectional view of a plasma chamber according to another embodiment of the present invention;

Figure 71 shows an example of a plasma source coil of the plasma chamber of Figure 70;

Figure 72 is a cross-sectional view of a plasma chamber according to another embodiment of the present invention;

Figure 73 shows an example of a plasma source coil of the plasma chamber of Figure 72;

Figure 74 is a cross-sectional view of a plasma chamber according to another embodiment of the present invention; and

Figure 75 shows an example of a plasma source coil of the plasma chamber of Figure 74.

In the figures, like references denote like or corresponding parts.
Referring to Figure 2, a plasma source coil 200 is made up of a coil bushing 210 located in the centre thereof and a plurality of unit coils 201, 202, 203, and 204, which spirally coil around the coil bushing 210. Although four unit coils 201, 202, 203, and 204 are exemplarily used in the present embodiment, the present invention is not limited to the above description. The plasma source coil 200 can include m coils (here, $m \geq 2$, and m is an integer). Each of the unit coils 201, 202, 203, and 204 has a number n of turns (here, n is a positive real number). The number of turns of each of the unit coils 201, 202, 203, and 204 may not be an integer.

The coil bushing 210 is formed of the same material as the plurality of unit coils 201, 202, 203, and 204. For example, if the unit coils 201, 202, 203, and 204 are formed of copper, the coil bushing 210 can also be formed of copper. The coil bushing 210 may be formed of a different material from the unit coils 201, 202, 203, and 204 according to circumstances, but should be formed of a conductive material anyhow. A support bar 211 is located in the centre of the coil bushing 210 and protrudes perpendicular to a top surface of the coil bushing 210. The support bar 211 is also formed of a conductive material, for example, copper.

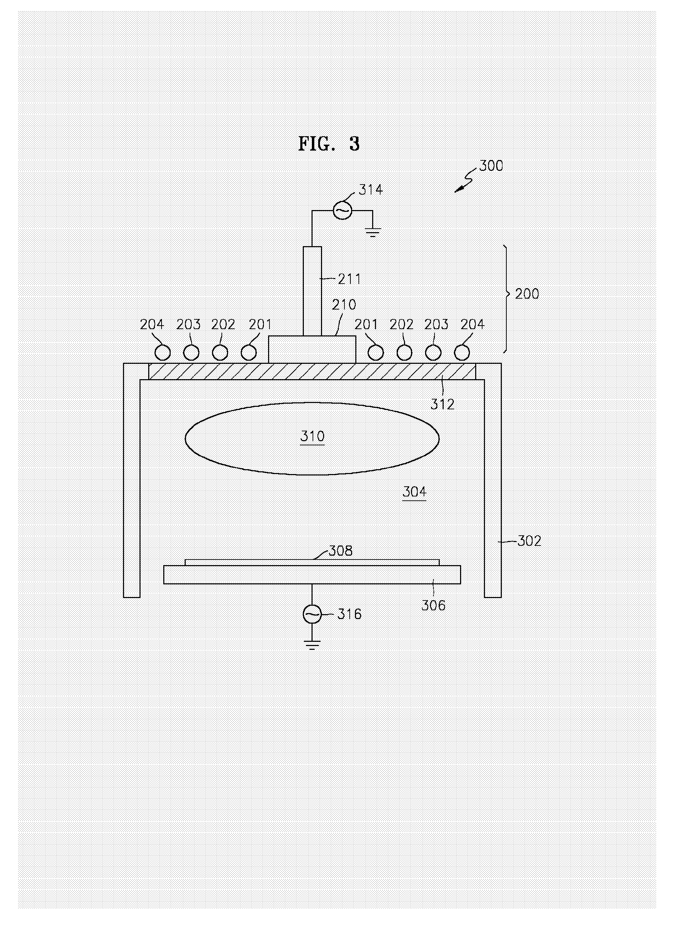

Referring to Figure 3, in a plasma chamber 300 including the plasma source coil 200, a proper size of inner space 304 is defined by outer walls 302 and a dome 312. Although the inner space 304 of the plasma chamber 300 is externally open in the drawing for simplicity, the inner space 304 is externally closed for practical use to maintain vacuum in the plasma chamber 300. A wafer support 306 is located at a lower portion of the inner space 304 to support semiconductor wafers 308 having certain patterns. An RF power supply 316 is connected to the wafer support 306.

The plasma source coil 200 for generating plasma is located on an outer surface of the dome 312. The plane structure of the plasma source coil 200 was described with reference to Figure 2. That is, a coil bushing 210 is located in the centre of a top surface of the dome 312, and unit coils 201, 202, 203, and 204 spirally coil around the coil bushing 211. Although not shown in Figure 3, one terminal of each of the unit coils 201, 202, 203, and 204 is connected to the coil bushing 210, and the other terminal thereof is grounded. A support bar 211 is located in the centre of the coil bushing 210 and protrudes perpendicular to the surface of the coil bushing 210. An RF power supply 314 is connected to the support bar 211. Thus, the RF power supply 314 supplies RF power to the unit coils 201, 202, 203, and 204 via the support bar 211 and the coil bushing 210.

In the plasma chamber 300, the unit coils 201, 202, 203, and 204 receive RF power from the RF power supply 314 to generate an electric field. The electric field passes through the dome 312 and is induced in the inner space 304 of the plasma chamber 300. The electric field induced in the inner space 304 produces gas discharge in the inner space 304 of the plasma chamber 300, thus generating plasma. The resultant neutral radicals react on charged ions thereby to process the surface of a semiconductor wafer 308. In conventional plasma chambers, the density of plasma produced in an inner space has the greatest value in the centre of a wafer and has the smallest value in an edge of the wafer. Unlike the conventional plasma chambers having a non-uniform density of plasma, in the plasma chamber 300 of the present embodiment of invention, the density of plasma is properly reduced in the centre of the wafer 308 due to the coil bushing 210. Thus, the density of plasma becomes uniform inside the entire plasma chamber 300.

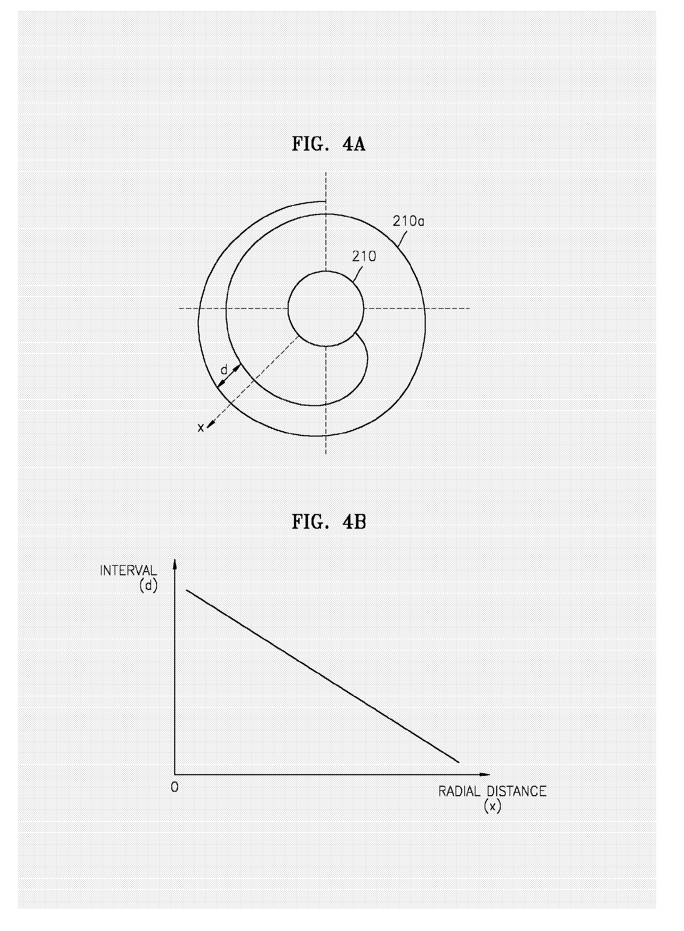

Figure 4A is a plan view of a plasma source coil capable of generating plasma uniformly, according to another embodiment, which exemplarily illustrates only a unit coil. Figure 4B is a graph showing a variation of an interval between portions of a unit coil according to a radial distance from the centre of the coil of Figure 4A.

As shown in Figures 4A and 4B, a unit coil 201a diverges from a coil bushing 210 located in the centre of the entire coil and spirally coils around the coil bushing 210. The unit coil 201a is structured such that as the radial distance from the centre of the coil bushing 210 increases, e.g., in an x direction, an interval d between portions of the unit coil 201a in the x direction decreases. That is, as the radial distance decreases, the interval d increases. Inversely, as the radial distance increases, the interval d decreases. Thus, as the coil 201a extends farther from the centre of the coil bushing 210 in a radial direction, an interval between currents flowing through the coil 201a becomes narrower. Hence, the amount of current per area increases. This makes the density of plasma increase in an edge of a wafer corresponding to a portion of the coil 201a, which is farthest from the centre of the coil bushing 210. Further, since the density of plasma decreases in the centre of the wafer due to the coil bushing 210, the entire wafer can have a uniform density of plasma irrespective of positions. Although only one unit coil 201a is shown in Figure 4A, it is obvious that other unit coils of the same structure as the unit coil 201a can be further included.

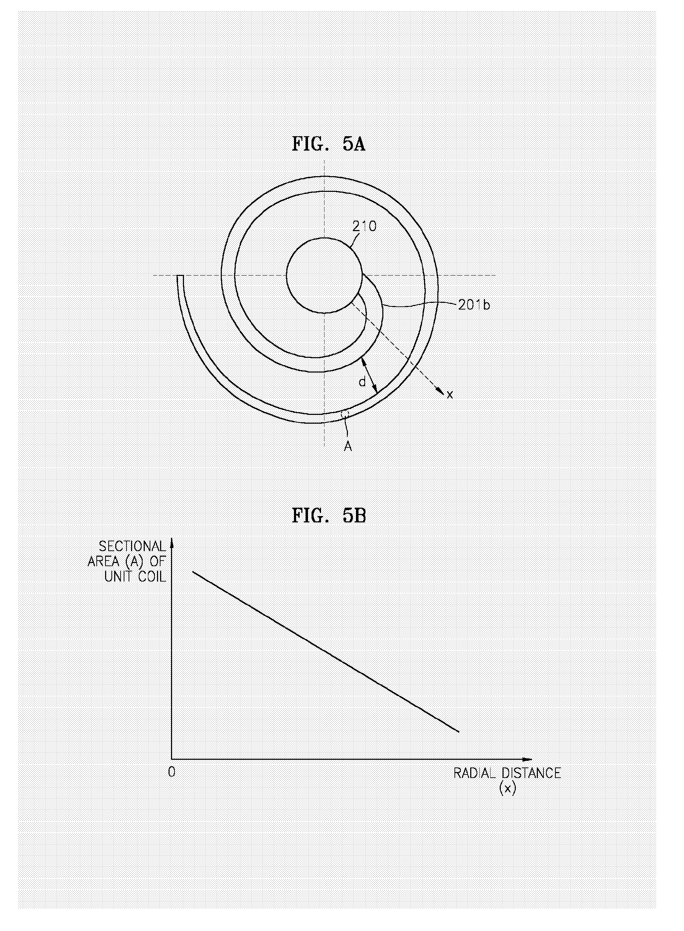

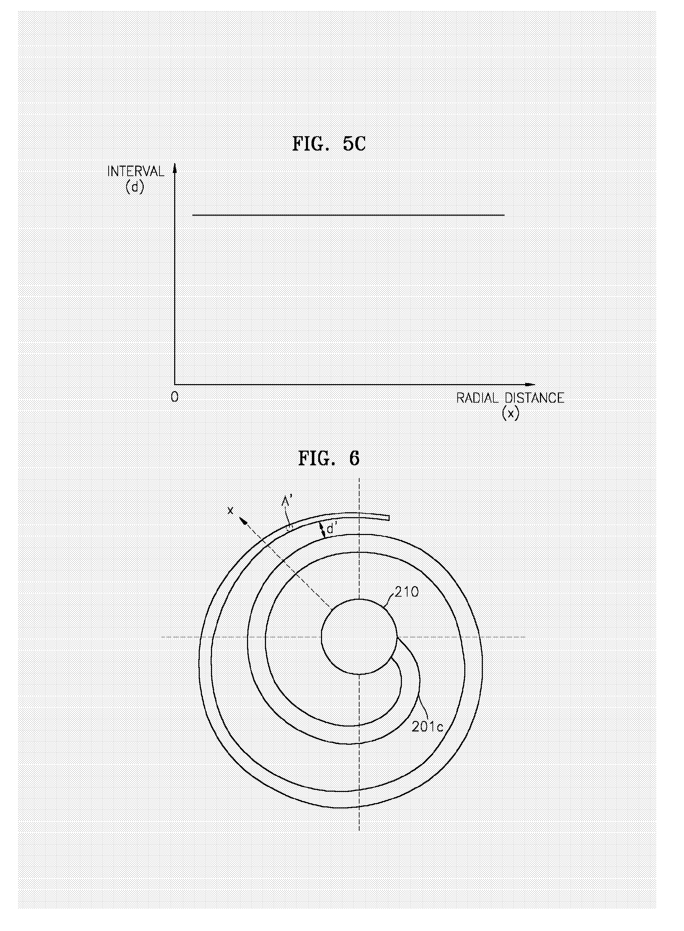

Figure 5A is a plan view of a plasma source coil capable of generating plasma uniformly, according to another embodiment of the present invention, which exemplarily illustrates only one unit coil. Figure 5B is a graph showing a variation of a sectional area of the unit coil according to a radial distance from the centre of the coil of Figure 5A, and Figure 5C is a graph showing a variation of an interval between portions of the unit coil according to the radial distance from the centre of the coil in the plasma source coil of Figure 5A.

Referring to Figures 5A, 5B, and 5C, a unit coil 201b diverges from a coil bushing 210 located in the centre of the plasma source coil and spirally coils around the coil bushing 210. The unit coil 201b is structured such that as the radial distance from the centre of the coil bushing 210 increases, e.g., in an x direction, the sectional area A of the unit coil 201b decreases, but the interval d between portions of the unit coil 201b is held constant. That is, as the radial distance decreases, the sectional area A increases. Inversely, as the radial distance increases, the sectional area A decreases. Thus, even though the amount of current is constant irrespective of the radial distance, as the coil 201b extends farther from the centre of the coil bushing 210 in a radial direction, the density of current flowing through the unit coil 201b increases. This makes the density of plasma increase in an edge of a wafer corresponding to a portion of the coil 201b, which is farthest from the centre of the coil bushing 210. Further, since the density of plasma decreases in the centre of the wafer due to the coil bushing 210, the entire wafer can have a uniform density of plasma irrespective of positions. Although only one unit coil 201b is shown in Figure 5A, it is obvious that other unit coils of the same structure as the unit coil 201b can be further included.

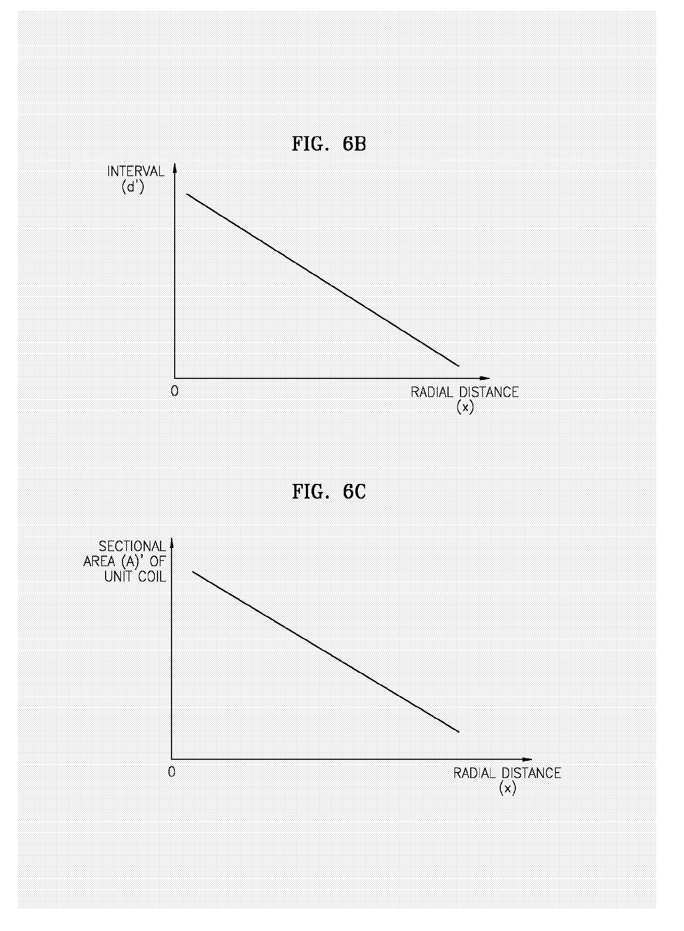

Figure 6A is a plan view of a plasma source coil capable of generating plasma uniformly, according to another embodiment of the present invention, which exemplarily illustrates only one unit coil. Figure 6B is a graph showing a variation of a sectional area of the unit coil according to a radial distance from the centre of the coil of Figure 6A, and Figure 6C is a graph showing a variation of an interval between portions of the unit coil according to the radial distance from the centre of the coil of Figure 6A.

Referring to Figures 6A, 6B, and 6C, a unit coil 201c diverges from a coil bushing 210 located in the centre of the entire coil and spirally coils around the coil bushing 210. The unit coil 201c is structured such that as the radial distance from the centre of the coil bushing 210 increases, e.g., in an x direction, both the interval d' between portions of the unit coil 201c and the sectional area A' of the unit coil 201c decrease. That is, this plasma source coil is obtained by combining the plasma source coils shown in Figures 4A and 5A. Hence, as the coil 201c extends farther from the centre of the coil bushing 210 in a radial direction, the density of current flowing through the unit coil 201c increases most effectively. This makes the density of plasma increase at the highest rate in an edge of a wafer corresponding to a portion of the coil 201c, which is farthest from the centre of the coil bushing 210. Further, since the density of plasma decreases in the centre of the wafer due to the coil bushing 210, the entire wafer can have a uniform density of plasma irrespective of positions. Although only one unit coil 201c is shown in Figure 6A, it is obvious that other unit coils of the same structure as the unit coil 201c can be further included.

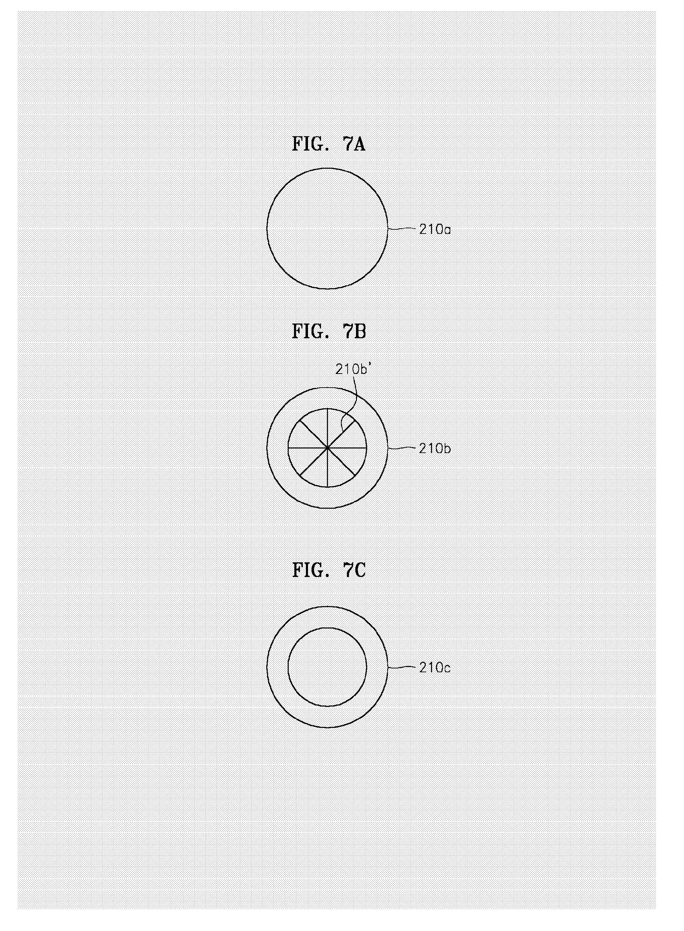

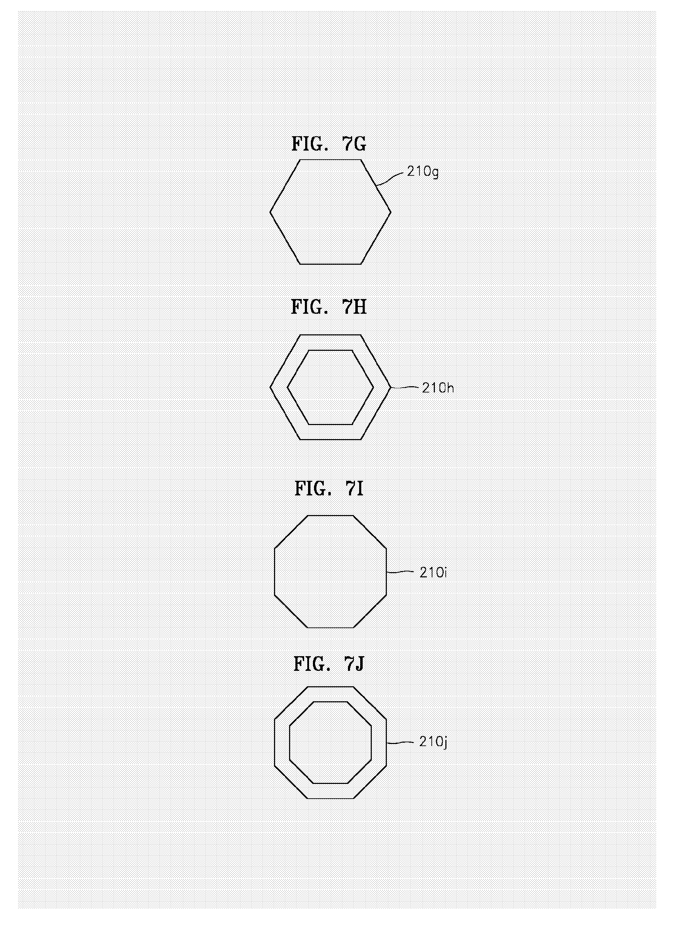

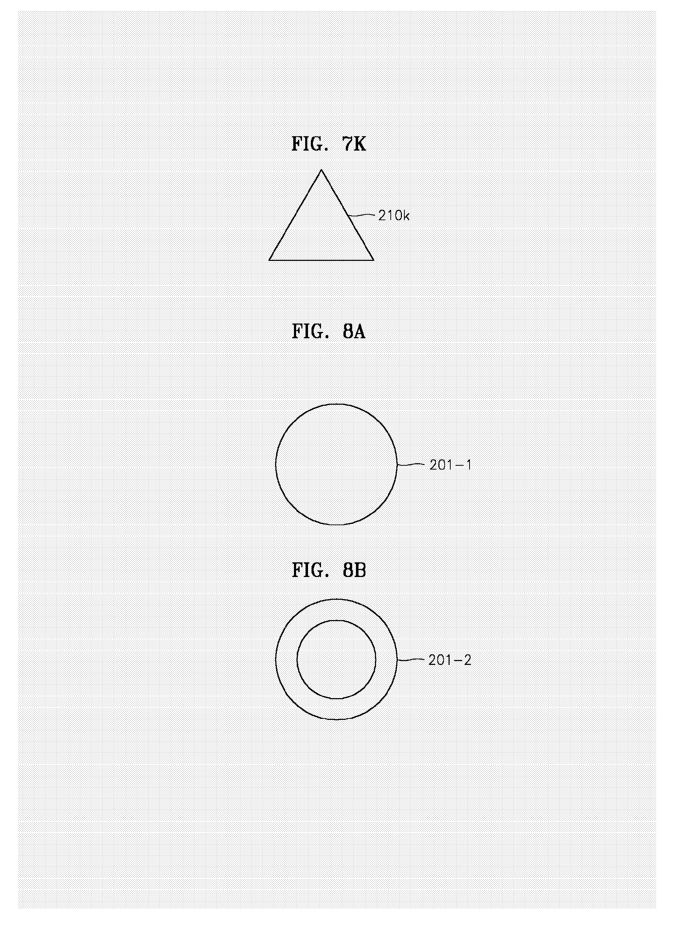

Figures 7A through 7K are plan views illustrating shapes of coil bushings of the plasma source coils according to embodiments of the present invention.

Referring to Figure 7A, a coil bushing 210a can have a simple circular shape. In Figure 7A, the sectional area of the coil bushing 210a can vary, thereby affecting the distribution of the density of plasma inside a plasma chamber, particularly, in the centre of a wafer. The radius of the coil bushing 210a, which determines the sectional area of the coil bushing 210a, also affects the distribution of the density of plasma. Referring to Figure 7B, a coil bushing 210b can have a circular donut shape so as to define a vacant central space. Branches 210b' are located in the vacant central space. Hereinafter, this structure in which the branches 210b' are located in the certain space of the coil bushing 210b as shown in Figure 7B will be referred to as a mesh structure. Referring to Figure 7C, a coil bushing 210c can have a circular donut shape so as to define a vacant central space, but does not include branches in the vacant central space unlike the coil bushing 210b of Figure 7B. The coil bushing 210c of Figure 7C having a completely vacant central space has a greater effect of reducing the density of plasma in the centre of a wafer than the coil bushing 210b of Figure 7B having the branches 210b'.

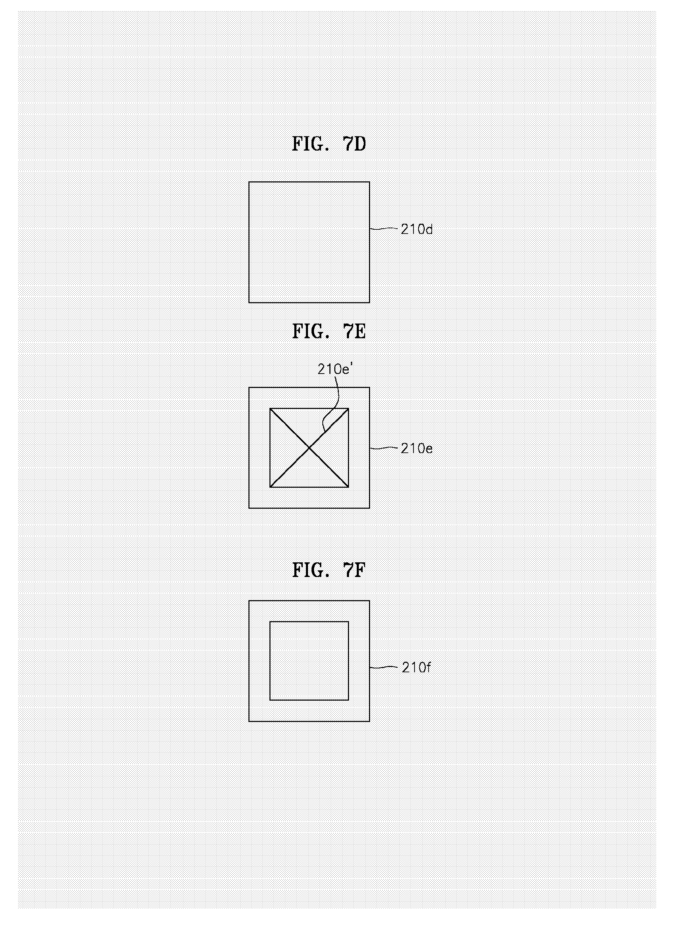

Referring to Figure 7D, a coil bushing 210d can have a simple square shape. In Figure 7D, the sectional area of the coil bushing 210d can vary, thereby affecting the distribution of the density of plasma in the centre of a wafer. Thus, the length and/or the width of the coil bushing 210d, which determine the sectional area of the coil bushing 210d, also affect the distribution of the density of plasma. Referring to Figure 7E, a coil bushing 210e can have a square donut shape so as to define a vacant central space. The coil bushing 210e has a mesh structure in which branches 210e' are located in a vacant central space. Referring to Figure 7F, a coil bushing 210f can have a square donut shape so as to define a vacant central space, but does not include branches in a vacant central space unlike the coil bushing 210e of Figure 7E. The coil bushing 210f of Figure 7F having a completely vacant central space has a greater effect of reducing the density of plasma in the centre of a wafer than the coil bushing 210e of Figure 7E having the branches 210e'.

Referring to Figures 7G through 7K, coil bushings have a polygonal shape. As shown in Figures 7G and 7I, coil bushings 210g and 210i have a hexagonal shape and an octagonal shape, respectively. As shown in Figures 7H and 7J, coil bushings 210h and 210j have a hexagonal donut shape and an octagonal donut shape, respectively. Also, as shown in Figure 7K, a coil bushing 210k has a triangular shape. As described above, the coil bushings 210h and 210j of Figures 7H and 7J, each of which has a vacant central space, can reduce the density of plasma in the centre of a wafer more effectively than the coil bushings 210g and 210i of Figures 7G and 7I. Of course, a coil bushing of the present invention can have various shapes other than the shapes shown in Figures 7A through 7K.

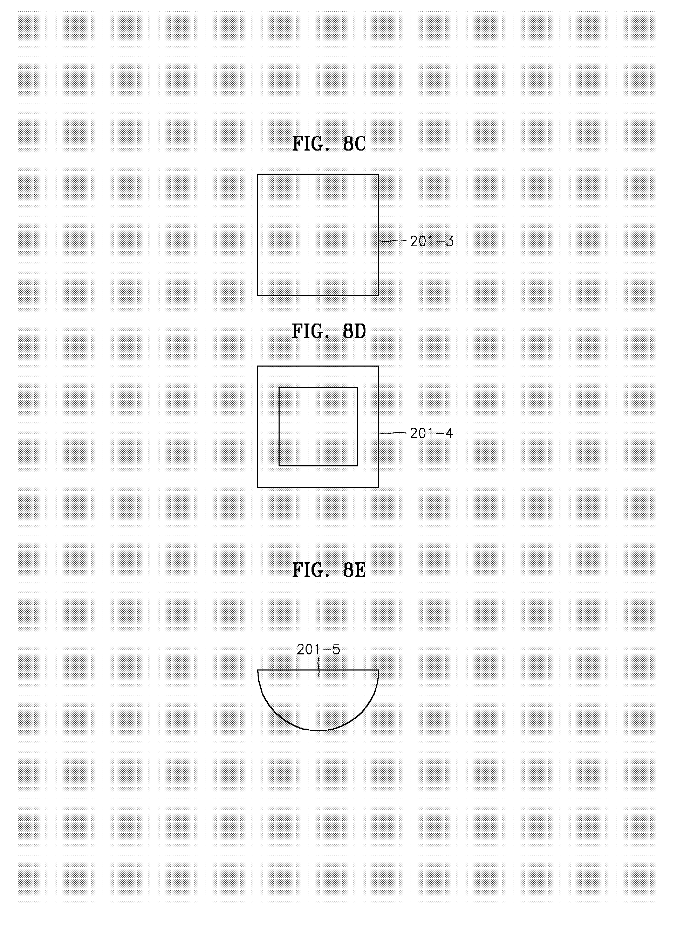

Figures 8A through 8E show various sectional shapes of unit coils of plasma source coils of embodiments of the present invention.

As shown in Figures 8A through 8E, the unit coils of embodiments of the present invention can have various sectional shapes. For example, there are a unit coil 201-1 having a circular sectional shape, a unit coil 201-2 having a circular donut sectional shape, a unit coil 201-3 having a square sectional shape, a unit coil 201-4 having a square donut sectional shape, and a unit coil 201-5 having a semicircular shape. Of course, the unit coil of embodiments of the present invention can have other various sectional shapes.

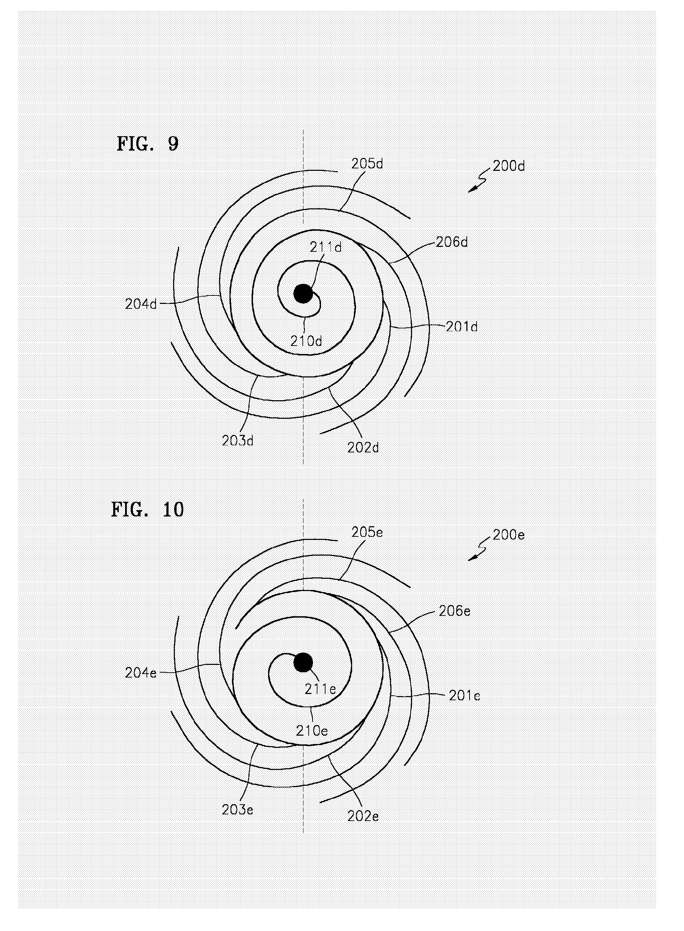

Figures 9 and 10 are plan views of plasma source coils capable of generating plasma uniformly, according to another embodiment of the present invention.

Referring to Figure 9, a plasma source coil 200d is made up of a unit coil 210d located in the centre of the plasma source coil 200d and a plurality of unit coils 201 d, 202d, 203d, 204d, 205d, and 206d, which spirally coil around the unit coil 210d. Referring to Figure 10, a plasma source coil 200e is made up of a unit coil 210e located in the centre of the plasma source coil 200e and a plurality of unit coils 201e, 202e, 203e, 204e, 205e, and 206e, which spirally coil around the unit coil 210e. The plasma source coils 200d and 200e are obtained by replacing the coil bushing 210 of Figure 2 by the unit coils 210d and 210e, respectively. As shown in Figure 9, the unit coil 210d may coil counterclockwise. Alternatively, as shown in Figure 10, the unit coil 210e may coil clockwise. In any case, the plurality of unit coils 201d, 202d, 203d, 204d, 205d, and 206d or 201e, 202e, 203e, 204e, 205e, and 206e extend from the outermost portions of the unit coil 210d or 210e and coil around the unit coil 210d or 210e. The present invention is not limited to the above-described number (i.e., 6) of unit coils that coil around the central unit coil 210d or 210e.

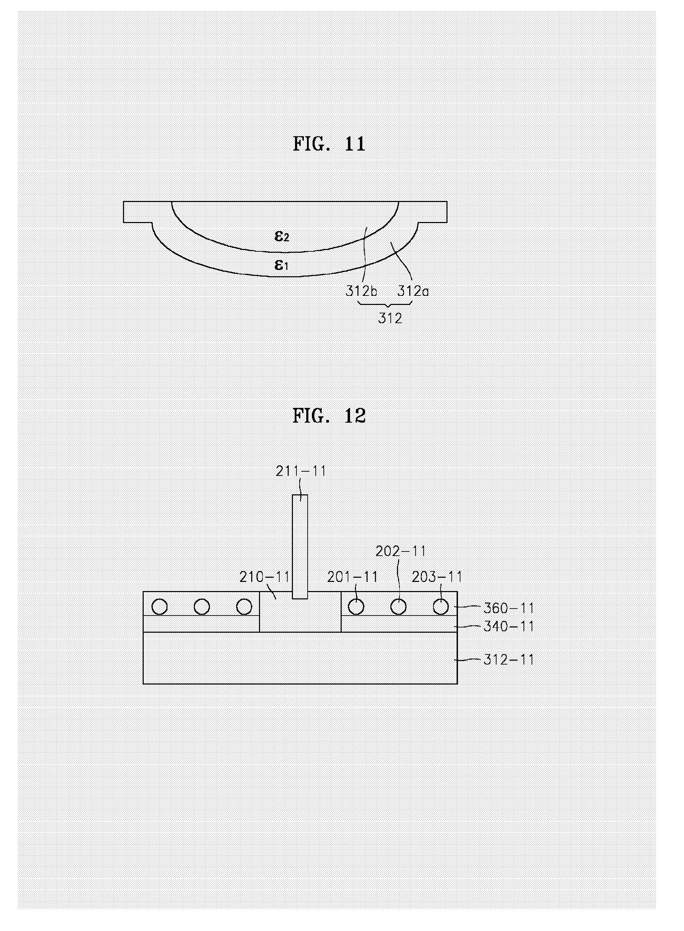

Figure 11 is a cross-sectional view of the dome of the plasma chamber of Figure 3.

Referring to Figure 11, the dome 312 of the plasma chamber (300 of Figure 3) according to an embodiment of the present invention is comprised of two material layers having different dielectric constants $\varepsilon 1$ and $\varepsilon 2$, respectively. More specifically, the dome 312 has a lower dome 312a and an upper dome 312b. A bottom of the lower dome 312a faces the semiconductor wafer (308 of Figure 3) and is exposed to the inner space (304 of Figure 3). A top surface of the upper dome 312b is exposed out of the plasma chamber 300. A top surface of the lower dome 312a is in contact with a bottom of the upper dome 312b. The top surface and bottom of the lower dome 312a and the bottom of the upper dome 312b protrude toward the inner space 304 of the plasma chamber 300. The lower dome 312a is formed of a material having a predetermined first dielectric constant $\varepsilon 1$, for example, alumina ($Al_2O_3$) having a dielectric constant of 9.3 to 9.8. The upper dome 312b is formed of a material having a predetermined second dielectric constant $\varepsilon 2$ that is smaller than the first dielectric constant $\varepsilon 1$, for example, ceramic. It is obvious that the plasma chamber 300 having the dome 312 of Figure 11 can have one of the above-described plasma source coils according to embodiments of the present invention.

Figures 12 through 45 are cross-sectional views of domes and plasma source coils of plasma chambers according to embodiments of the present invention.

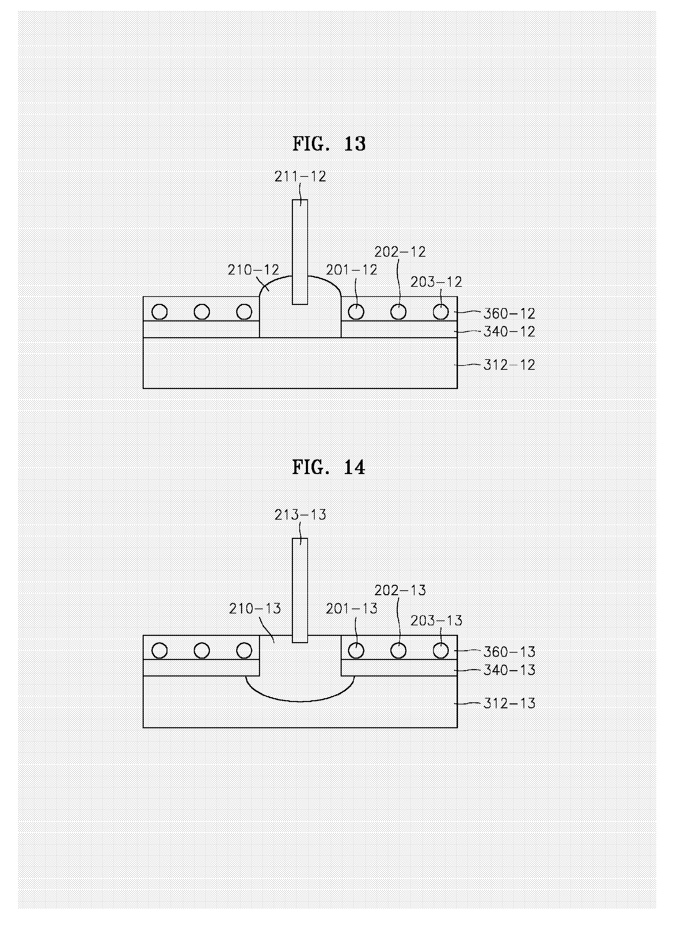

Referring to Figure 12, a coil bushing 210-11 and a planarizer 340-11 are disposed on a top surface of a dome 312-11, which is the reverse side of a bottom of the dome 312-11 that faces an inner space of a plasma chamber. The planarizer 340-11 is typically formed of plastic or ceramic or may be air that fills a vacant space, according to circumstances. The coil bushing 210-11 is located in the centre of the dome 312-11, and the planarizer 340-11 is disposed to surround the coil bushing 210-11. The dome 312-11 is formed of alumina. A support bar 211-11 is located in the centre of a top surface of the coil bushing 210-11. The dome 312-11 has planar bottom and top surfaces, and the coil bushing 210-11 also has planar bottom and top surfaces. A heat emissive layer 360-11 is disposed on the planarizer 340-11, and a plurality of unit coils 201-11, 202-11, and 203-11 are located inside the heat emissive layer 340-11. Of course, the plasma source coils that are described with reference to Figures 2, 4A, 5A, 6A, 9, and 10 can be applied not only to the plasma source coil of Figure 12, which is made up of the plurality of unit coils 201-11, 202-11, and 203-11, the coil bushing 210-11, and the support bar 211-11, but also to plasma source coils that will be described hereinafter with reference to Figures 13 through 46.

Referring to Figure 13, a coil bushing 210-12 is located in the centre of a top surface of a dome 312-12. While a bottom of the coil bushing 210-12 is planar, a top surface thereof has a convex form. A support bar 211-12 is located in the centre of the convex top surface of the coil bushing 210-12. Unlike the coil bushing 210-12, the dome 312-12 has planar bottom and top surfaces. A planarizer 340-12 and a heat emissive layer 360-12 are sequentially disposed on the top surface of the dome 312-12 where the coil bushing 210-12 is not located, so as to surround the coil bushing 210-12. A plurality of unit coils 201-12, 202-12, and 203-12 are located inside the heat emissive layer 360-12.

Referring to Figure 14, a coil bushing 210-13 is located in the centre of a top surface of a dome 312-13. While a bottom of the coil bushing 210-13 has a concave form, a top surface thereof is planar. A support bar 211-13 is located in the centre of the planar top surface of the coil bushing 210-13. The dome 312-13 has a planar bottom, but has a concave portion of the top surface, which contacts the bottom of the coil bushing 210-13. A planarizer 340-13 and a heat emissive layer 360-13 are sequentially disposed to surround the coil bushing 210-13. A plurality of unit coils 201-13, 202-13, and 203-13 are located inside the heat emissive layer 360-13.

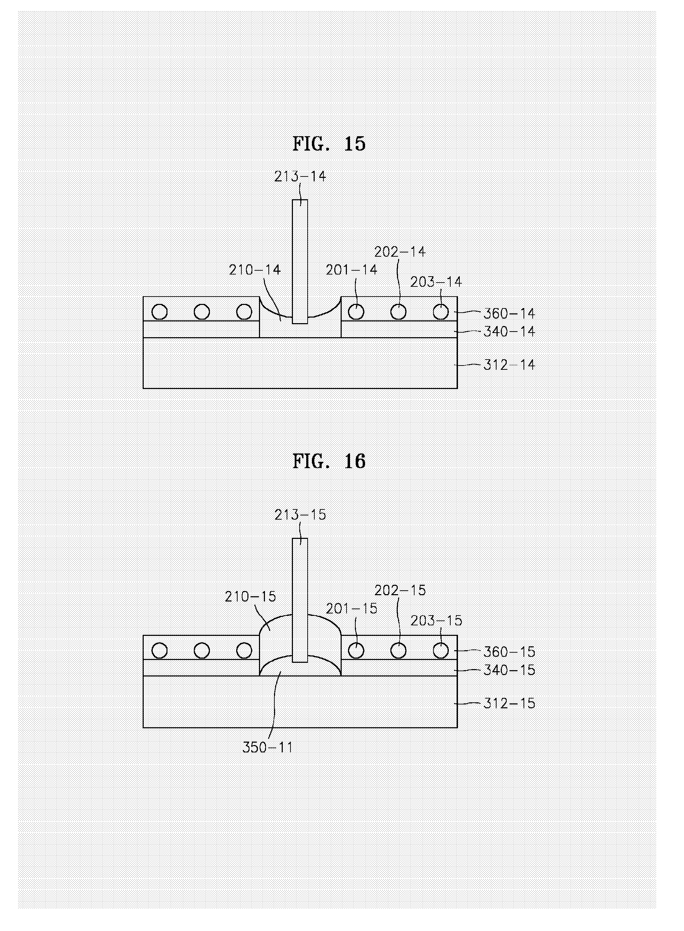

Referring to Figure 15, a coil bushing 210-14 is located in the centre of a top surface of a dome 312-14. While a bottom of the coil bushing 210-14 is planar, a top surface thereof has a concave form. A support bar 211-14 is located in the centre of the concave top surface of the coil bushing 210-14. Unlike the coil bushing 210-14, the dome 312-14 has planar bottom and top surfaces. A planarizer 340-14 and a heat emissive layer 360-14 are sequentially disposed to surround the coil bushing 210-14. A plurality of unit coils 201-14, 202-14, and 203-14 are located inside the heat emissive layer 360-14.

Referring to Figure 16, a dielectric layer 350-11 and a coil bushing 210-15 are sequentially disposed in the centre of a top surface of a dome 312-15. The dielectric layer 350-11 may be formed of plastic or ceramic or may be air that fills a vacant space, according to circumstances. The dome 312-15 has planar bottom and top surfaces, and the dielectric layer 350-11 has a planar bottom surface. However, a top surface of the dielectric layer 350-11 has a convex form. Similarly, a top surface of the coil bushing 210-15 has a convex form. Thus, a bottom of the coil bushing 210-15, which contacts the top surface of the dielectric layer 350-11, also has a convex form. A support bar 211-15 is located in the centre of the convex top surface of the coil bushing 210-15. A planarizer 340-15 and a heat emissive layer 360-15 are sequentially disposed to surround the coil bushing 210-15. A plurality of unit coils 201-15, 202-15, and 203-15 are located inside the heat emissive layer 360-15.

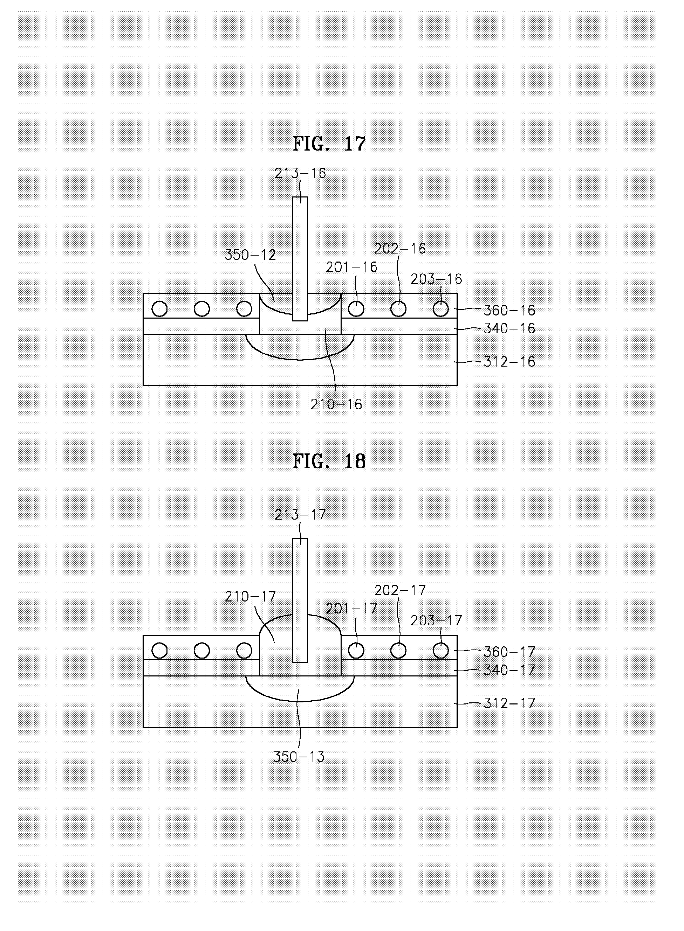

Referring to Figure 17, a ceramic layer 360-11 is inserted into a central portion of a top surface of a dome 312-16, and a coil bushing 210-16 and a dielectric layer 350-12 are sequentially disposed on the ceramic layer 360-11. The ceramic layer 360-11 may be replaced by another insulating material layer. The dielectric layer 350-12 may be formed of plastic or ceramic or may be air that fills a vacant space, according to circumstances. The dome 312-16 has a planar bottom surface, and the ceramic layer 360-11 has a planar top surface. A top surface of the coil bushing 210-16 located on the ceramic layer 360-11 has a concave form. A top surface of the dielectric layer 350-12 located on the coil bushing 210-16 is planar. A support bar 211-16 is located in the centre of the planar top surface of the dielectric layer 350-12. A planarizer 340-16 and a heat emissive layer 360-16 are sequentially disposed to surround the coil bushing 210-16. A plurality of unit coils 201-16, 202-16, and 203-16 are located inside the heat emissive layer 360-16.

Referring to Figure 18, a dielectric layer 350-13 and a coil bushing 210-17 are sequentially disposed in the centre of a top surface of a dome 312-17. The dome 312-17 has a planar bottom surface, but has a concave portion in the centre of the top surface. The dielectric layer 350-13 is disposed on the concave portion and has a planar top surface. A top surface of the coil bushing 210-17 located on the dielectric layer 350-13 has a convex form. A support bar 211-17 is located in the centre of the convex top surface of the coil bushing 210-17. A planarizer 340-17 and a heat emissive layer 360-17 are sequentially disposed to surround the coil bushing 210-17. A plurality of unit coils 201-17, 202-17, and 203-17 are located inside the heat emissive layer 360-17.

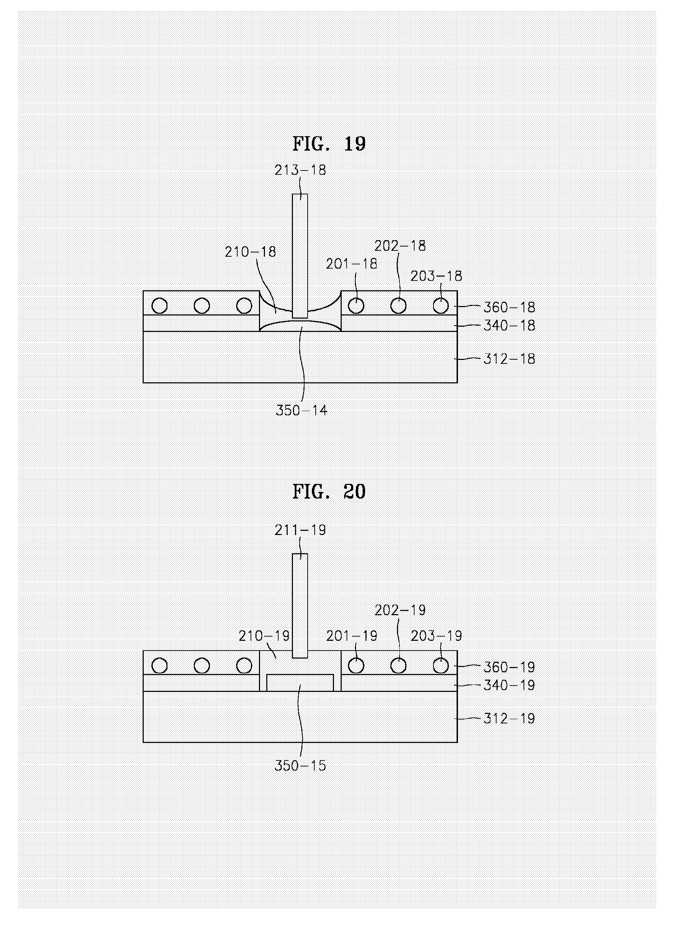

Referring to Figure 19, a dielectric layer 350-14 and a coil bushing 210-18 are sequentially disposed in the centre of a top surface of a dome 312-18. The dome 312-18 has planar bottom and top surfaces. A top surface of the dielectric layer 350-14 located on the dome 312-18 has a convex form. A top surface and bottom surface of the coil bushing 210-18 located on the dielectric layer 350-14 have a concave form and convex form, respectively. A support bar 211-18 is located in the centre of the concave top surface of the coil bushing 210-18. A planarizer 340-18 and a heat emissive layer 360-18 are sequentially disposed to surround the coil bushing 210-18. A plurality of unit coils 201-18, 202-18, and 203-18 are located inside the heat emissive layer 360-18.

Referring to Figure 20, a dielectric layer 350-12 is disposed in the centre of a top surface of a dome 312-19. A coil bushing 210-19 is located on the top surface of the dome 312-19 to completely cover the dielectric layer 350-15. The dome 312-19, the dielectric layer 350-15, and the coil bushing 210-19 each have planar bottom and top surfaces. A support bar 211-19 is located in the centre of the planar top surface of the coil bushing 210-19. A planarizer 340-19 and a heat emissive layer 360-19 are sequentially disposed to surround the coil bushing 210-19. A plurality of unit coils 201-19, 202-19, and 203-19 are located inside the heat emissive layer 360-19.

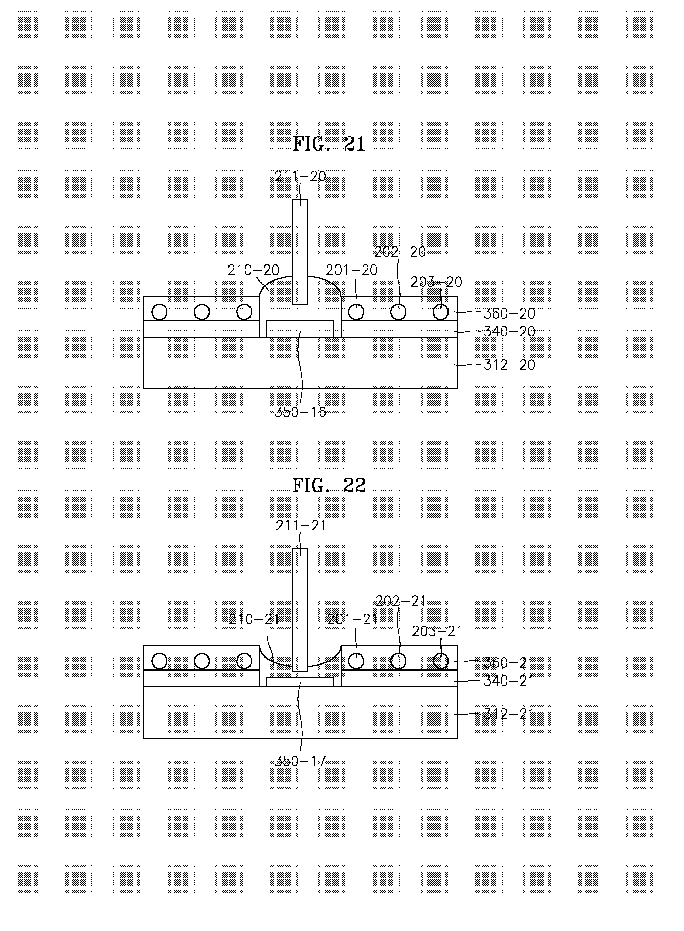

Referring to Figure 21, a dielectric layer 350-16 is disposed in the centre of a top surface of a dome 312-20. A coil bushing 210-20 is located on the top surface of the dome 312-20 to completely cover the dielectric layer 350-16. The dome 312-20 and the dielectric layer 350-16 each have planar bottom and top surfaces. While a bottom surface of the coil bushing 210-20 is planar, a top surface thereof has a convex form. A support bar 211-20 is located in the centre of the convex top surface of the coil bushing 210-20. A planarizer 340-20 and a heat emissive layer 360-20 are sequentially disposed to surround the coil bushing 210-20. A plurality of unit coils 201-20, 202-20, and 203-20 are located inside the heat emissive layer 360-20.

Referring to Figure 22, a dielectric layer 350-17 is disposed in the centre of a top surface of a dome 312-21. A coil bushing 210-21 is located on the top surface of the dome 312-21 to completely cover the dielectric layer 350-17. The dome 312-21 and the dielectric layer 350-17 each have planar bottom and top surfaces. While a bottom surface of the coil bushing 210-21 is planar, a top surface thereof has a concave form. A support bar 211-21 is located in the centre of the concave top surface of the coil bushing 210-21. A planarizer 340-21 and a heat emissive layer 360-21 are sequentially disposed to surround the coil bushing 210-21. A plurality of unit coils 201-21, 202-21, and 203-21 are located inside the heat emissive layer 360-21.

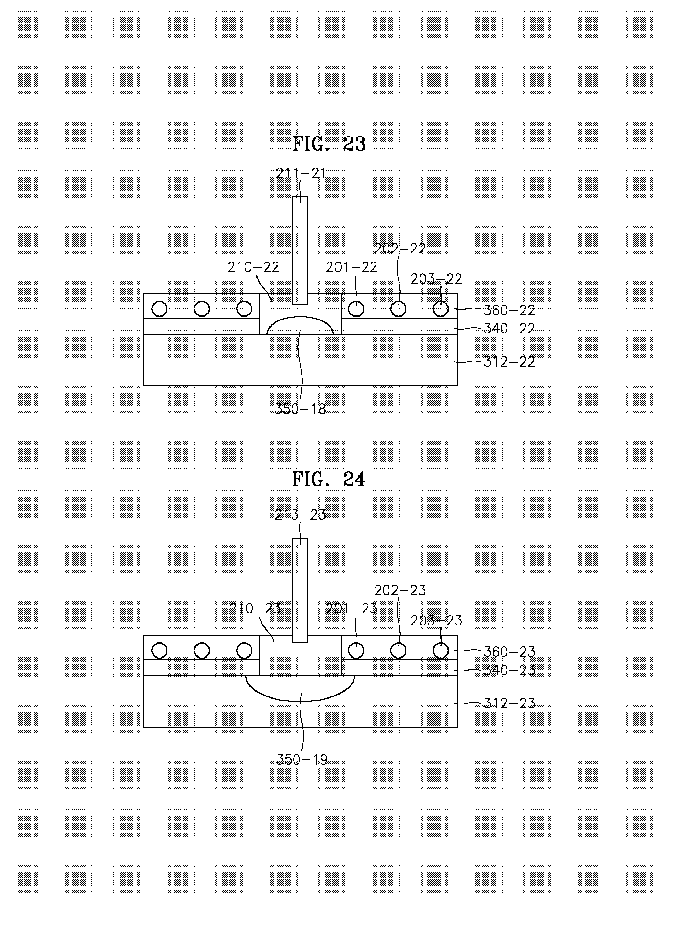

Referring to Figure 23, a dielectric layer 350-18 is disposed in the centre of a top surface of a dome 312-22. A coil bushing 210-22 is located on the top surface of the dome 312-22 to completely cover the dielectric layer 350-18. The dome 312-22 has planar bottom and top surfaces. A bottom surface of the dielectric layer 350-18 and a top surface of the coil bushing 210-22 are planar. However, a top surface of the dielectric layer 350-18 has a convex form. Also, a portion of a bottom surface of the coil bushing 210-22, which contacts the top surface of the dielectric layer 350-18, also has a convex form. A support bar 211-22 is located in the centre of the top surface of the coil bushing 210-22. A planarizer 340-22 and a heat emissive layer 360-22 are sequentially disposed to surround the coil bushing 210-22. A plurality of unit coils 201-22,202-22, and 203-22 are located inside the heat emissive layer 360-22.

Referring to Figure 24, a dielectric layer 350-19 and a coil bushing 210-23 are sequentially disposed in the centre of a top surface of a dome 312-23. While a bottom surface of the dome 312-23 is planar, a central portion of a top surface thereof has a concave form. A top surface of the dielectric layer 350-19 located on the concave portion is planar. A top surface of the coil bushing 210-23 located on the dielectric layer 350-19 also is planar. A support bar 211-23 is located in the centre of the planar top surface of the coil bushing 210-23. A planarizer 340-23 and a heat emissive layer 360-23 are sequentially disposed to surround the coil bushing 210-23. A plurality of unit coils 201-23, 202-23, and 203-23 are located inside the heat emissive layer 360-23.

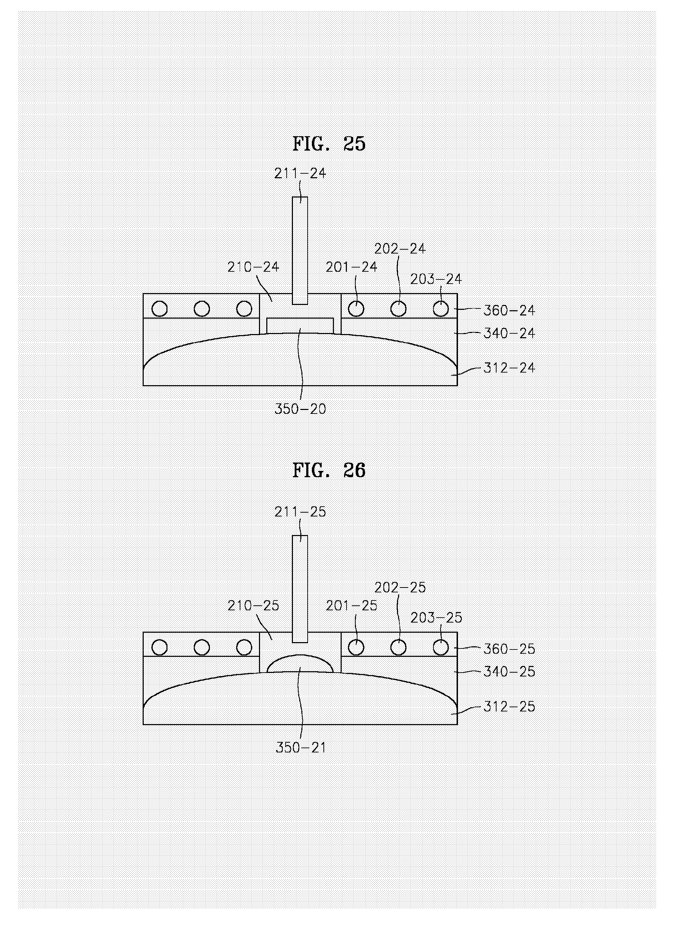

Referring to Figure 25, while a bottom surface of a dome 312-24 is planar, a top surface thereof has a convex form. A dielectric layer 350-20 is disposed in the centre of the convex top surface of the dome 312-24. A coil bushing 210-24 is located on the top surface of the dome 312-24 to completely cover the dielectric layer 350-20. The dielectric layer 350-20 and the coil bushing 210-24 each have a planar top surface. A support bar 211-24 is located in the centre of the planar top surface of the coil bushing 210-24. A planarizer 340-24 and a heat emissive layer 360-24 are sequentially disposed to surround the coil bushing 210-24. A plurality of unit coils 201-24,202-24, and 203-24 are located inside the heat emissive layer 360-24.

Referring to Figure 26, while a bottom surface of a dome 312-25 is planar, a top surface thereof has a convex form. A dielectric layer 350-21 is disposed in the centre of the convex top surface of the dome 312-25. A coil bushing 210-25 is located on the top surface of the dome 312-25 to completely cover the dielectric layer 350-21. Like the dome 312-25, a top surface of the dielectric layer 350-21 has a convex form. However, a top surface of the coil bushing 210-25 is planar. A support bar 211-25 is located in the centre of the planar top surface of the coil bushing 210-25. A planarizer 340-25 and a heat emissive layer 360-25 are sequentially disposed to surround the coil bushing 210-25. A plurality of unit coils 201-25, 202-25, and 203-25 are located inside the heat emissive layer 360-25.

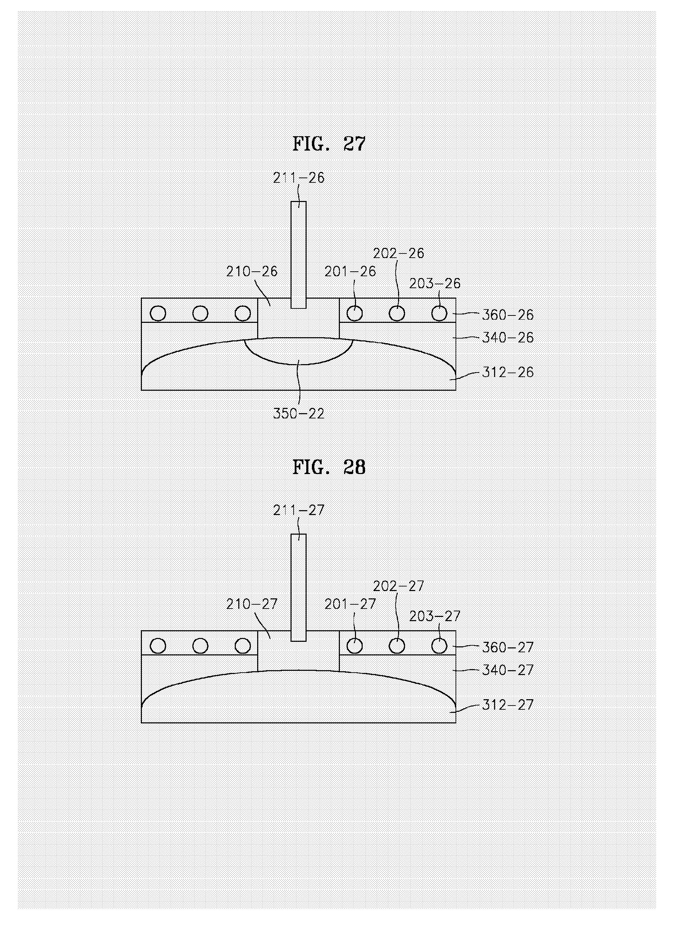

Referring to Figure 27, while a bottom surface of a dome 312-26 is planar, a top surface thereof has a convex form. A dielectric layer 350-22 is inserted into the centre of the convex top surface of the dome 312-26.

A bottom surface of this dielectric layer 350-22 has a concave form. A coil bushing 210-26 is located on the dielectric layer 350-22. A bottom surface of the coil bushing 210-26, which contacts the top surface of the dielectric layer 350-22, has a convex form. However, a top surface of the coil bushing 210-26 is planar. A support bar 211-26 is located in the centre of the top surface of the coil bushing 210-26. A planarizer 340-26 and a heat emissive layer 360-26 are sequentially disposed to surround the coil bushing 210-26. A plurality of unit coils 201-26, 202-26, and 203-26 are located inside the heat emissive layer 360-26.

Referring to Figure 28, while a bottom surface of a dome 312-27 is planar, a top surface thereof has a convex form. A coil bushing 210-27 is located in the centre of the top surface of the dome 312-27. While a bottom surface of the coil bushing 210-27 has a concave form, a top surface thereof is planar. A support bar 211-27 is located in the centre of the planar top surface of the coil bushing 210-27. A planarizer 340-27 and a heat emissive layer 360-27 are sequentially disposed to surround the coil bushing 210-27. The planarizer 340-27 has a planar top surface, but has a curved bottom surface that contacts the top surface of the dome 312-27. A plurality of unit coils 201-27, 202-27, and 203-27 are located inside the heat emissive layer 360-27.

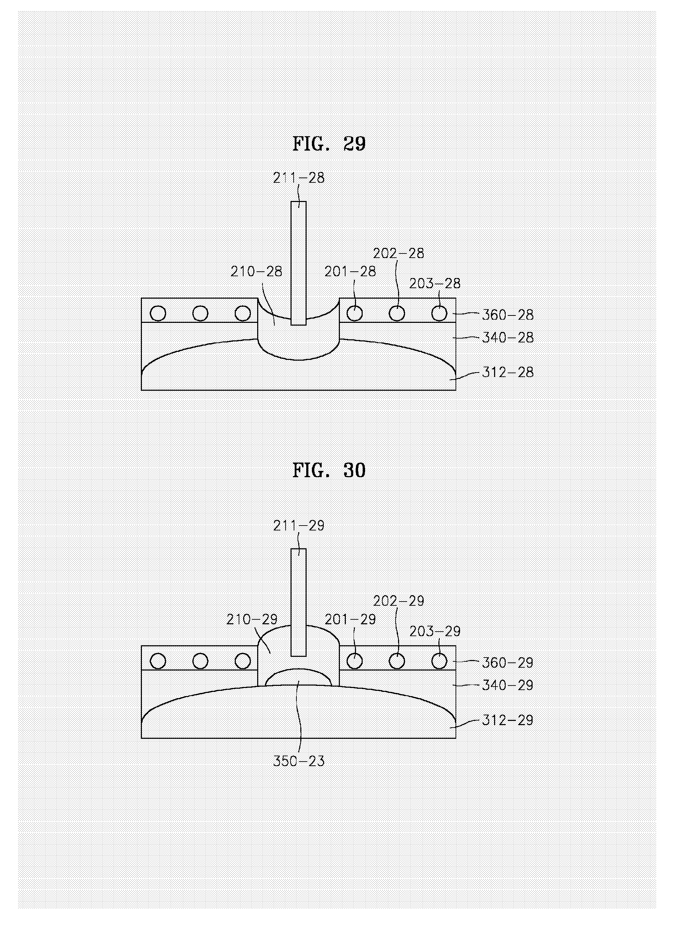

Referring to Figure 29, while a bottom surface of a dome 312-28 is planar, a top surface thereof has a convex form. However, a central portion of the top surface of the dome 312-28 has a concave form. A coil bushing 210-28 is located on the concave portion. Thus, a bottom surface of the coil bushing 210-28 also has a concave form along a surface of the concave portion. Also, a top surface of the coil bushing 210-28 has a concave form. A support bar 211-28 is located in the centre of the concave top surface of the coil bushing 210-28. A planarizer 360-28 and a heat emissive layer 340-28 are sequentially disposed to surround the coil bushing 210-28. The planarizer 340-28 has a planar top surface, but has a curved bottom surface that contacts the top surface of the dome 312-28. A plurality of unit coils 201-28, 202-28, and 203-28 are located inside the heat emissive layer 360-28.

Referring to Figure 30, while a bottom surface of a dome 312-29 is planar, a top surface thereof has a convex form. A dielectric layer 350-23 is located in the centre of the convex top surface of the dome 312-29. A coil bushing 210-29 is located on the top surface of the dome 312-29 to completely cover the dielectric layer 350-23. Like the dome 312-29, a top surface of the dielectric layer 350-23 has a convex form. Also, a top surface of the coil bushing 210-29 has a convex form. A support bar 211-29 is inserted into the central top surface of the coil bushing 210-29. A planarizer 340-29 and a heat emissive layer 360-29 are sequentially disposed to surround the coil bushing 210-29. A plurality of unit coils 201-29, 202-29, and 203-29 are located inside the heat emissive layer 360-29.

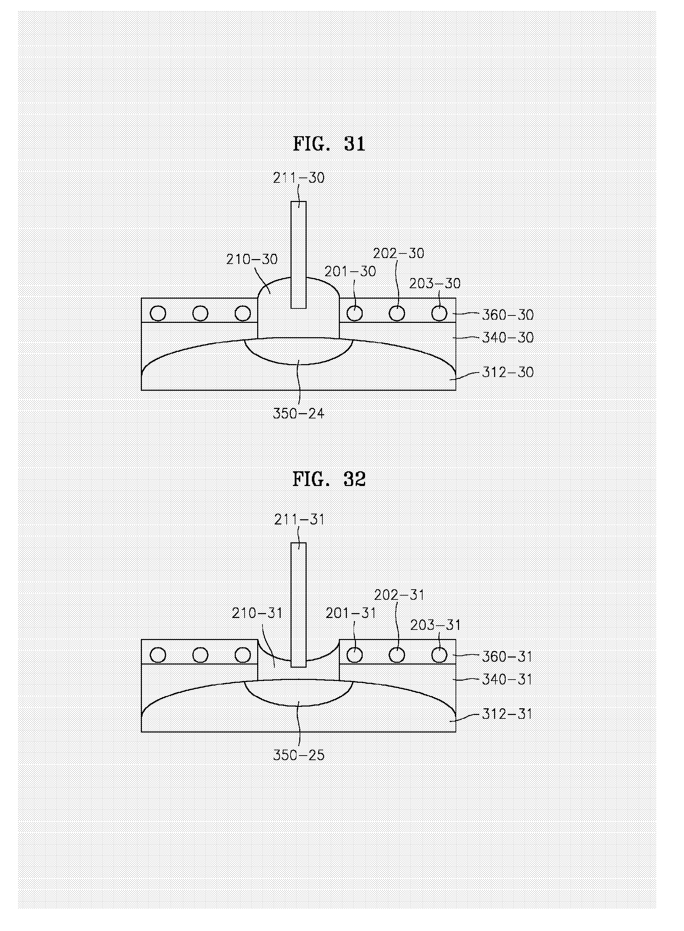

Referring to Figure 31, while a bottom surface of a dome 312-30 is planar, a top surface thereof has a convex form. A dielectric layer 350-40 is inserted into the central top surface of the dome 312-30. A bottom surface of the dielectric layer 350-24 has a concave form. A coil bushing 210-30 is located on the dielectric layer 350-24. A bottom surface of the coil bushing 210-30, which contacts the top surface of the dielectric layer 350-24, has a convex form. A top surface of the coil bushing 210-30 has a convex form. A support bar 211-30 is located in the centre of the convex top surface of the coil bushing 210-30. A planarizer 340-30 and a heat emissive layer 360-30 are sequentially disposed to surround the coil bushing 210-30. The planarizer 340-30 has a planar top surface, but has a curved bottom surface that contacts the top surface of the dome 312-30. A plurality of unit coils 201-30, 202-30, and 203-30 are located inside the heat emissive layer 360-30.

Referring to Figure 32, while a bottom surface of a dome 312-31 is planar, a top surface thereof has a convex form. A dielectric layer 350-25 is inserted into the central top surface of the dome 312-31. A bottom surface of the dielectric layer 350-25 has a concave form. A coil bushing 210-31 is located on the dielectric layer 350-25. A bottom surface of the coil bushing 210-31, which contacts a top surface of the dielectric layer 350-25, has a convex form. A top surface of the coil bushing 210-31 has a concave form. A support bar 211-31 is located in the centre of the concave top surface of the coil bushing 210-31. A planarizer 340-31 and a heat emissive layer 360-31 are sequentially disposed to surround the coil bushing 210-31. The planarizer 340-31 has a planar top surface, but has a curved bottom surface that contacts the top surface of the dome 312-31. A plurality of unit coils 201-31, 202-31, and 203-31 are located inside the heat emissive layer 360-31.

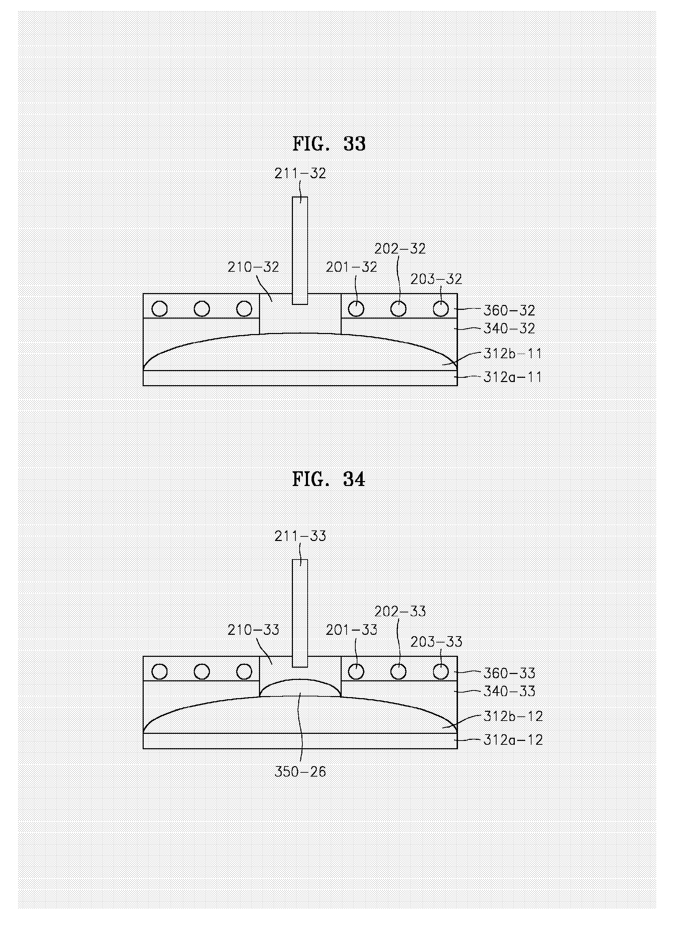

Referring to Figure 33, a lower dome 312a-11 and an upper dome 312b-11 are sequentially disposed. The lower dome 312a-11 is formed of alumina and the upper dome 312b-11 is formed of ceramic, but the present invention is not limited thereto. A bottom surface of the lower dome 312a-11 is exposed to an inner space of a plasma chamber, and a top surface thereof is in contact with a bottom surface of the upper dome 312b-11. The lower dome 312a-11 has planar top and bottom surfaces. However, while the bottom surface of the upper dome 312b-11 is planar, a top surface thereof has a convex form. A coil bushing 210-32 is located on the upper dome 312b-11. A bottom surface of the coil bushing 210-32, which contacts the top surface of the upper dome 312b-11, also has a convex form. A top surface of the coil bushing 210-32 is planar. A support bar 211-32 is located in the planar top surface of the coil bushing 210-32. A planarizer 340-32 and a heat emissive layer 360-32 are sequentially disposed to surround the coil bushing 210-32. The planarizer 340-32 has a planar top surface, but has a curved bottom surface that contacts the top surface of the upper dome 312b-11. A plurality of unit coils 201-32, 202-32, and 203-32 are located inside the heat emissive layer 360-32.

Referring to Figure 34, a lower dome 312a-12 and an upper dome 312b-12 are sequentially disposed. The lower dome 312a-12 has planar top and bottom surfaces. While a bottom surface of the upper dome 312b-12 is planar, a top surface thereof has a convex form. A dielectric layer 350-12 and a coil bushing 21-33 are sequentially disposed in the centre of the top surface of the upper dome 312b-12. Like the top surface of the upper dome 312b-12, a top surface of the dielectric layer 350-26 has a convex form. A top surface of the coil bushing 210-33 is planar. A support bar 211-33 is located on the planar top surface of the coil bushing 210-33. A planarizer 340-33 and a heat emissive layer 360-33 are sequentially disposed to surround the coil bushing 210-33. The planarizer 340-33 has a planar top surface, but has a curved bottom surface that contacts the top surface of the upper dome 312b-12. A plurality of unit coils 201-33, 202-33, and 203-33 are located inside the heat emissive layer 360-33.

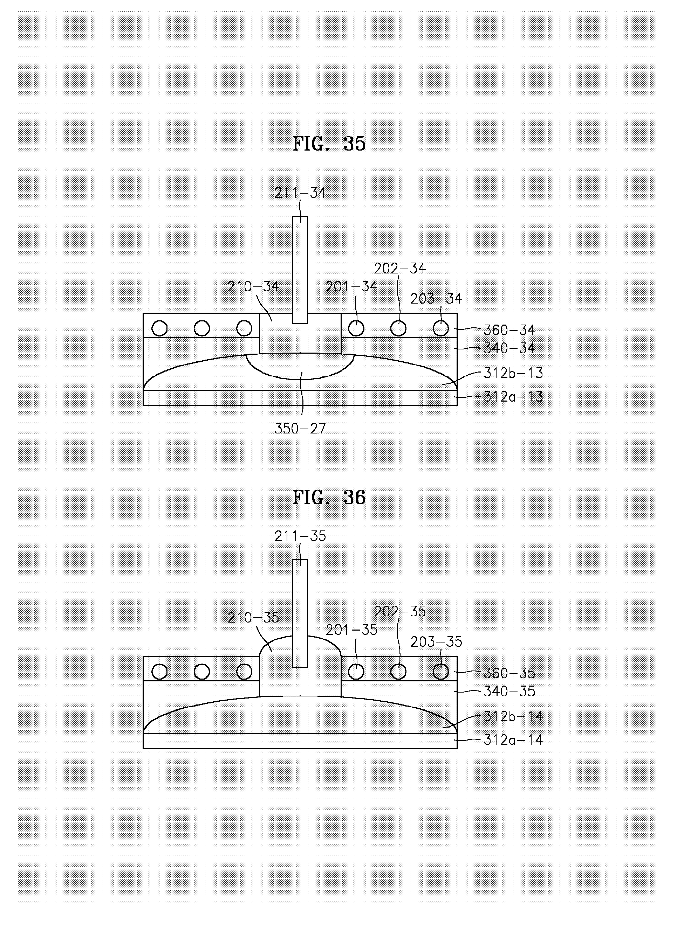

Referring to Figure 35, a lower dome 312a-13 and an upper dome 312b-13 are sequentially disposed. The lower dome 312a-13 has planar top and bottom surfaces. While a bottom surface of the upper dome 312b-13 is planar, a top surface thereof has a convex form. A dielectric layer 350-27 is inserted into the central top surface of the upper dome 312b-13. A bottom surface of the dielectric layer 350-27 has a concave form. A coil bushing 210-34 is located on a top surface of the dielectric layer 350-27. A bottom surface of the coil bushing 210-34, which contacts the top surface of the dielectric layer 350-27, has a convex form, but a top surface thereof is planar. A support bar 211-34 is located in the central top surface of the coil bushing 210-34. A planarizer 340-34 and a heat emissive layer 360-34 are sequentially disposed to surround the coil bushing 210-34. The planarizer 340-34 has a planar top surface, but has a curved bottom surface that contacts the top surface of the upper dome 312b-13. A plurality of unit coils 201-34, 202-34, and 203-34 are located inside the heat emissive layer 360-34.

Referring to Figure 36, a lower dome 312a-14 and an upper dome 312b-14 are sequentially disposed. A bottom surface of the lower dome 312a-14 is exposed to an inner space of a plasma chamber, and a top surface thereof is in contact with a bottom surface of the upper dome 312b-14. The lower dome 312a-14 has planar top and bottom surfaces. While the bottom surface of the upper dome 312b-14 is planar, a bottom surface thereof has a convex form. A coil bushing 210-35 is located on the upper dome 312b-14. A bottom surface of the coil bushing 210-35, which contacts the top surface of the upper dome 312b-14, has a convex form. A top surface of the coil bushing 210-35 has a convex form. A support bar 211-35 is inserted into the central top surface of the coil bushing 210-35. A planarizer 340-35 and a heat emissive layer 360-35 are sequentially disposed to surround the coil bushing 210-35. The planarizer 340-35 has a planar top surface, but has a curved bottom surface that contacts the top surface of the upper dome 312b-14. A plurality of unit coils 201-35,202-35, and 203-35 are located inside the heat emissive layer 360-35.

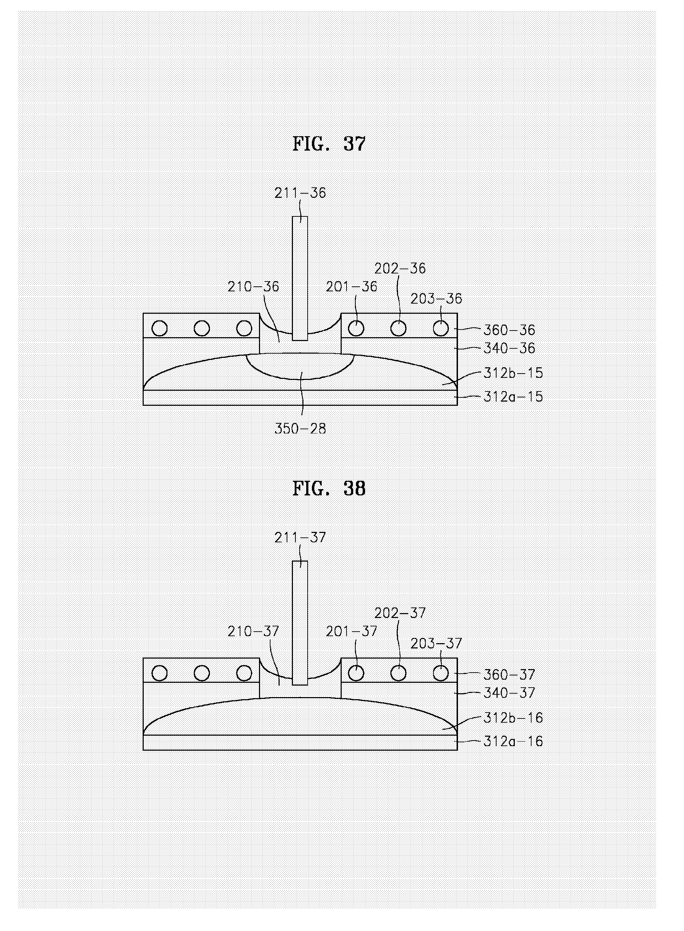

Referring to Figure 37, a lower dome 312a-15 and an upper dome 312b-15 are sequentially disposed. The lower dome 312a-15 has planar top and bottom surfaces. While a bottom surface of the upper dome 312b-15 is planar, a top surface thereof has a convex form. A dielectric layer 350-28 is inserted into the central top surface of the upper dome 312b-15. A bottom surface of the dielectric layer 350-28 has a concave form. A coil bushing 210-36 is located on a top surface of the dielectric layer 350-28. A bottom surface of the coil bushing 210-36, which contacts the top surface of the dielectric layer 350-28, has a convex form, but a top surface thereof has a concave form. A support bar 211-36 is located in the centre of the top surface of the coil bushing 210-36. A planarizer 340-36 and a heat emissive layer 360-36 are sequentially disposed to surround the coil bushing 210-36. The planarizer 340-36 has a planar top surface, but has a curved bottom surface that contacts the top surface of the upper dome 312b-15. A plurality of unit coils 201-36,202-36, and 203-36 are located inside the heat emissive layer 360-36.

Referring to Figure 38, a lower dome 312a-16 and an upper dome 312b-16 are sequentially disposed. The lower dome 312a-16 has planar top and bottom surfaces. While a bottom surface of the upper dome 312b-16 is planar, a top surface thereof has a convex form. A coil bushing 210-37 is located on the upper dome 312b016. A bottom surface of the coil bushing 210-37, which contacts the top surface of the upper dome 312b-16, has a convex form, but a top surface thereof has a concave form. A support bar 211-37 is inserted into the central top surface of the coil bushing 210-37. A planarizer 340-37 and a heat emissive layer 360-37 are sequentially disposed to surround the coil bushing 210-37. The planarizer 340-37 has a planar top surface, but has a curved bottom surface that contacts the top surface of the upper dome 312b-16. A plurality of unit coils 201-37, 202-37, and 203-37 are located inside the heat emissive layer 360-37.

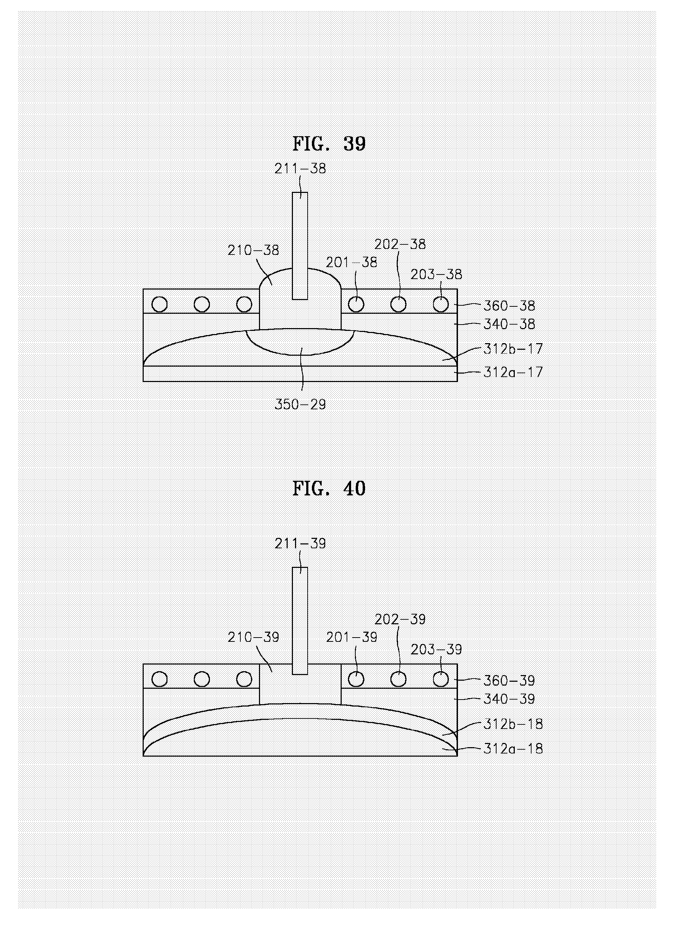

Referring to Figure 39, a lower dome 312a-17 and an upper dome 312b-17 are sequentially disposed. The lower dome 312a-17 has planar top and bottom surfaces. While a bottom surface of the upper dome 312b-17 is planar, a top surface thereof has a convex form. A dielectric layer 350-29 is inserted into the central top surface of the upper dome 312b-15. A bottom surface of the dielectric layer 350-29 has a concave form. A coil bushing 210-38 is located on the dielectric layer 350-29. A bottom surface of the coil bushing 210-38, which contacts a top surface of the dielectric layer 350-29, has a convex form. Also, a top surface of the coil bushing 210-38 has a convex form. A support bar 211-38 is inserted into the central top surface of the coil bushing 210-38. A planarizer 340-38 and a heat emissive layer 360-38 are sequentially disposed to surround the coil bushing 210-38. The planarizer 340-38 has a planar top surface, but has a curved bottom surface that contacts the top surface of the upper dome 312b-17. A plurality of unit coils 201-38, 202-38, and 203-38 are located inside the heat emissive layer 360-38.

Referring to Figure 40, a lower dome 312a-18 and an upper dome 312b-18 are sequentially disposed. While a bottom surface of the lower dome 312a-18 is planar, a top surface thereof has a convex form. The upper dome 312b-18 has convex top and bottom surfaces. A coil bushing 210-39 is located on the upper dome 312b-18. A bottom surface of the coil bushing 210-39, which contacts the top surface of the upper dome 312b-18, has a convex form, but a top surface thereof is planar. A support bar 211-39 is inserted into the central top surface of the coil bushing 210-39. A planarizer 340-39 and a heat emissive layer 360-39 are sequentially disposed to surround the coil bushing 210-39. The planarizer 340-39 has a planar top surface, but has a curved bottom surface that contacts the top surface of the upper dome 312b-18. A plurality of unit coils 201-39, 202-39, and 203-39 are located inside the heat emissive layer 360-39.

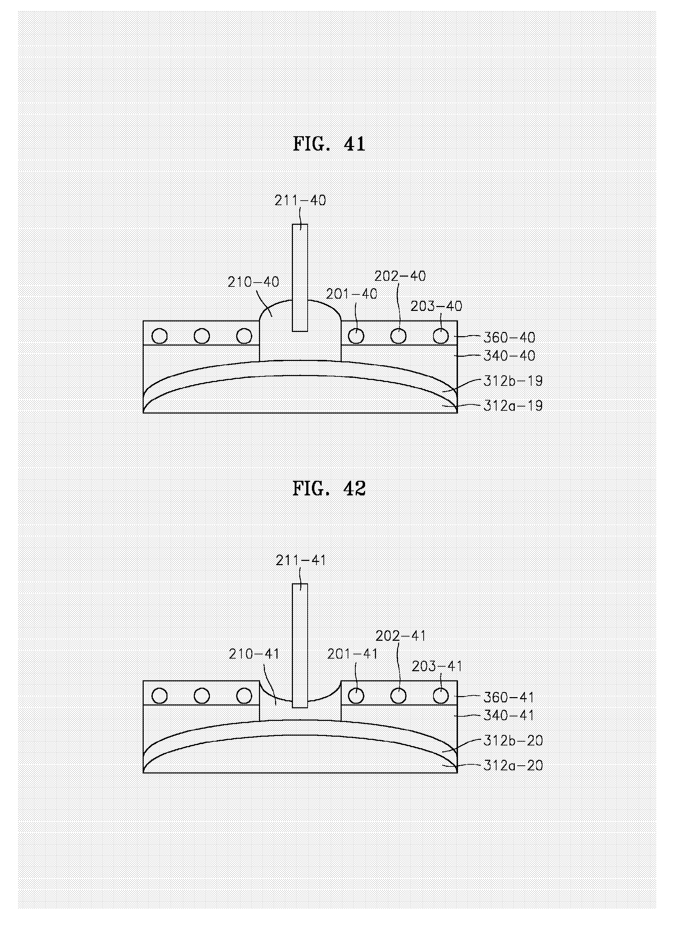

Referring to Figure 41, a lower dome 312a-19 and an upper dome 312b-19 are sequentially disposed. While a bottom surface of the lower dome 312a-19 is planar, a top surface thereof has a convex form. The upper dome 312b-19 has convex top and bottom surfaces. A coil bushing 210-40 is located on the upper dome 312b-19. A bottom surface of the coil bushing 210-40, which contacts the top surface of the upper dome 312b-19, has a convex form. Also, a top surface of the coil bushing 210-40 has a convex form. A support bar 211-40 is inserted into the central top surface of the coil bushing 210-40. A planarizer 340-40 and a heat emissive layer 360-40 are sequentially disposed to surround the coil bushing 210-40. The planarizer 340-40 has a planar top surface, but has a curved bottom surface that contacts the top surface of the upper dome 312b-19. A plurality of unit coils 201-40, 202-40, and 203-40 are located inside the heat emissive layer 360-40.

Referring to Figure 42, a lower dome 312a-20 and an upper dome 312b-20 are sequentially disposed. While a bottom surface of the lower dome 312a-20 is planar, a top surface thereof has a convex form. The upper dome 312b-20 has convex top and bottom surfaces. A coil bushing 210-41 is located on the upper dome 312b-20. A bottom surface of the coil bushing 210-41, which contacts the top surface of the upper dome 312b-20, has a convex form, but a top surface thereof has a concave form. A support bar 211-41 is inserted into the central top surface of the coil bushing 210-41. A planarizer 340-41 and a heat emissive layer 360-41 are sequentially disposed to surround the coil bushing 210-41. The planarizer 340-41 has a planar top surface, but has a curved bottom surface that contacts the top surface of the upper dome 312b-20. A plurality of unit coils 201-41, 202-41, and 203-41 are located inside the heat emissive layer 360-41.

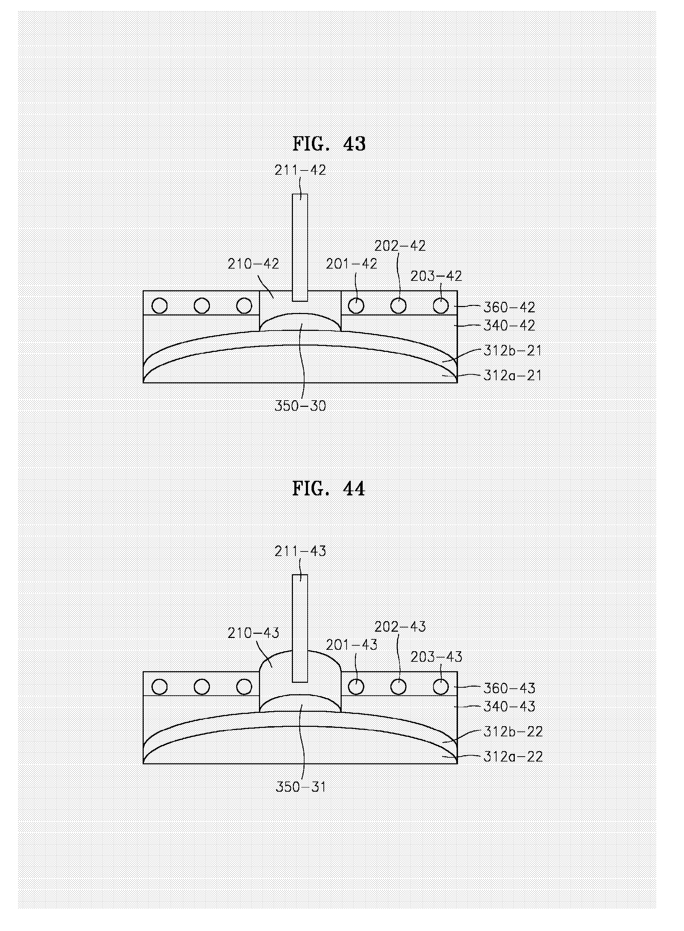

Referring to Figure 43, a lower dome 312a-21 and an upper dome 312b-21 are sequentially disposed. While a bottom surface of the lower dome 312a-21 is planar, a top surface thereof has a convex form. The upper dome 312b-21 has convex top and bottom surfaces. A dielectric layer 350-30 and a coil bushing 210-42 are sequentially disposed in the centre of the top surface of the upper dome 312b-21. Like the top surface of the upper dome 312b-21, a top surface of the dielectric layer 350-30 has a convex form. A top surface of the coil bushing 210-42 is planar. A support bar 211-42 is inserted into the central top surface of the coil bushing 210-42. A planarizer 340-42 and a heat emissive layer 360-42 are sequentially disposed to surround the coil bushing 210-42. The planarizer 340-42 has a planar top surface, but has a curved bottom surface that contacts the top surface of the upper dome 312b-21. A plurality of unit coils 201-42, 202-42, and 203-42 are located inside the heat emissive layer 360-42.

Referring to Figure 44, a lower dome 312a-22 and an upper dome 312b-22 are sequentially disposed. While a bottom surface of the lower dome 312a-22 is planar, a top surface thereof has a convex form. The upper dome 312b-22 has convex top and bottom surfaces. A dielectric layer 350-31 and a coil bushing 210-43 are sequentially disposed in the centre of the top surface of the upper dome 312b-22. Like the top surface of the upper dome 312b-22, a top surface of the dielectric layer 350-31 has a convex form. Also, a top surface of the coil bushing 210-43 has a convex form. A support bar 211-43 is inserted into the central top surface of the coil bushing 210-43. A planarizer 340-43 and a heat emissive layer 360-43 are sequentially disposed to surround the coil bushing 210-43. The planarizer 340-43 has a planar top surface, but has a curved bottom surface that contacts the top surface of the upper dome 312b-22. A plurality of unit coils 201-43, 202-43, and 203-43 are located inside the heat emissive layer 360-43.

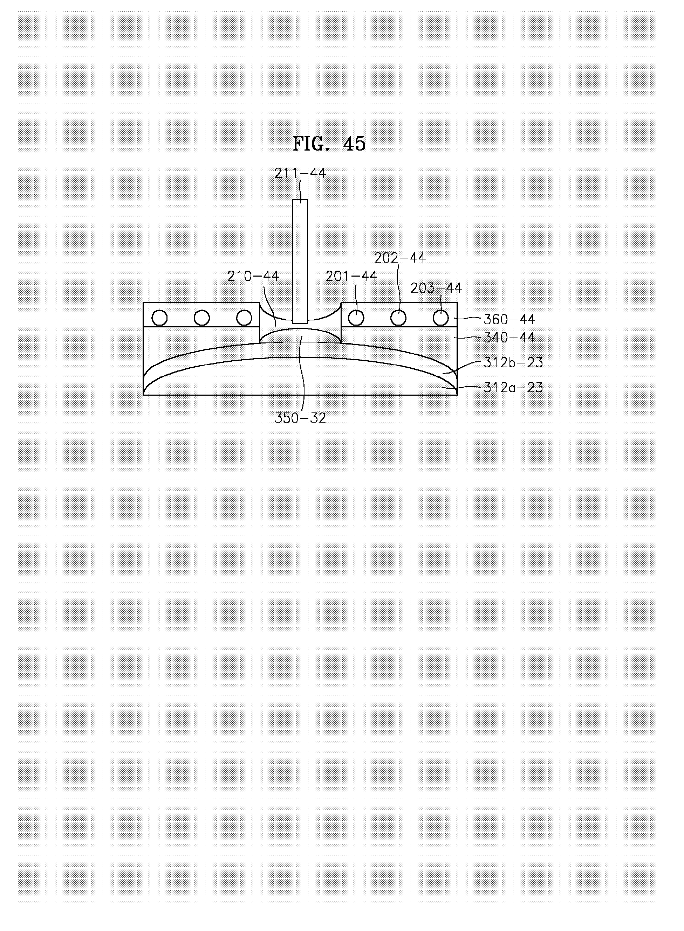

Referring to Figure 45, a lower dome 312a-23 and an upper dome 312b-23 are sequentially disposed. While a bottom surface of the lower dome 312a-23 is planar, a top surface thereof has a convex form. The upper dome 312b-23 has convex top and bottom surfaces. A dielectric layer 350-32 and a coil bushing 210-44 are sequentially disposed in the centre of the top surface of the upper dome 312b-23. Like the top surface of the upper dome 312b-23, a top surface of the dielectric layer 350-32 has a convex form. However, a top surface of the coil bushing 210-44 has a concave form. A support bar 211-44 is located in the centre of the concave top surface of the coil bushing 210-44. A planarizer 340-44 and a heat emissive layer 360-44 are sequentially disposed to surround the coil bushing 210-44. The planarizer 340-44 has a planar top surface, but has a curved bottom surface that contacts the top surface of the upper dome 312b-23. A plurality of unit coils 201-44, 202-44, and 203-44 are located inside the heat emissive layer 360-44.

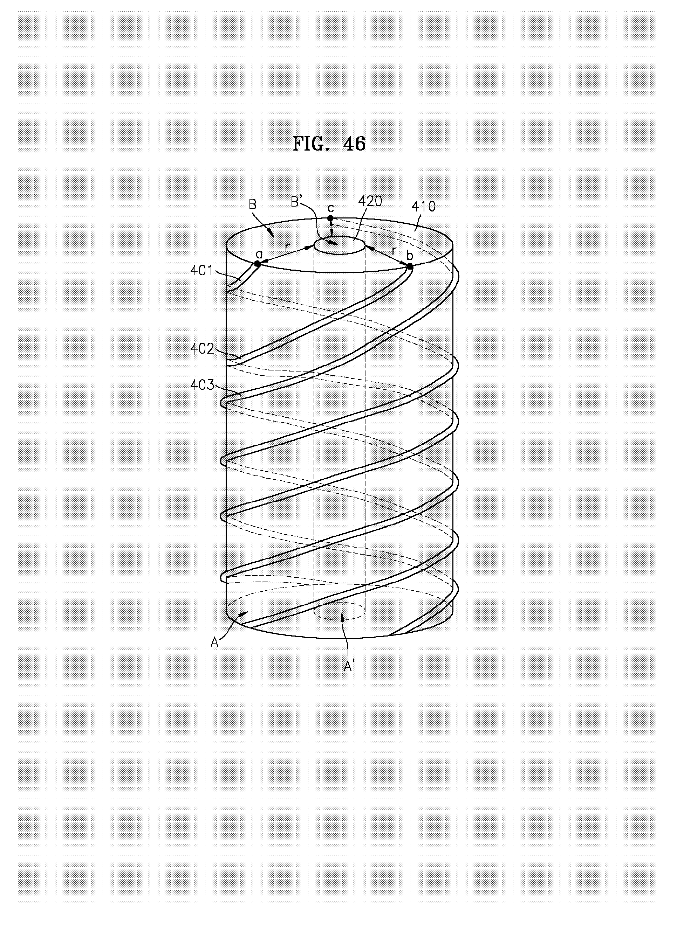

Figure 46 shows a plasma source coil according to another embodiment of the present invention.

Referring to Figure 46, the plasma source coil is comprised of an insulating pillar 410 having a bottom surface A and a top surface B. This insulating pillar 410 is a circular cylinder, through which a conductive bushing pillar 420 is located in a vertical direction. Although the insulating pillar 410 and the bushing pillar 420 are illustrated as circular cylinders in Figure 46, the present invention is not limited thereto. According to circumstances, the insulating pillar 410 or the bushing pillar 420 can be replaced by other various pillars, such as square pillars or polygonal pillars. Also, the insulating pillar 410 may be replaced by a vacant space. A bottom surface A' of the bushing pillar 420 is on the same plane with the bottom surface A of the insulating pillar 410, and a top surface B' of the bushing pillar 420 is on the same plane with the top surface B of the insulating pillar 410.

A plurality of unit coils, for example, a first unit coil 401, a second unit coil 402, and a third unit coil 403, diverge from the circumference of the top surface B' of the bushing pillar 420 and have curved shapes on the top surface B of the insulating pillar 410. Although only three unit coils are shown in Figure 46, which is intended merely to be illustrative, a greater number of unit coils than m coils (here, $m \geq 2$, m is an integer) can be used. The first, second, and third unit coils 401, 402, and 403 are located in a spiral shape along the circumference of the top surface B of the insulating pillar 410. Each of the first, second, and third unit coils 401, 402, and 403 has a number n of turns (here, n is a positive real number) and coils around the bushing pillar 420. Once each of the first, second, and third unit coils 401, 402, and 403 respectively reaches a certain point a, b, and c that is positioned at an edge of the insulating pillar 410 at radius (r) apart from the bushing pillar 420, the first, second, and third unit coils 401, 402, and 403 follow a helical trajectory around a lateral surface of the insulating pillar 410 until they reach the bottom surface A.

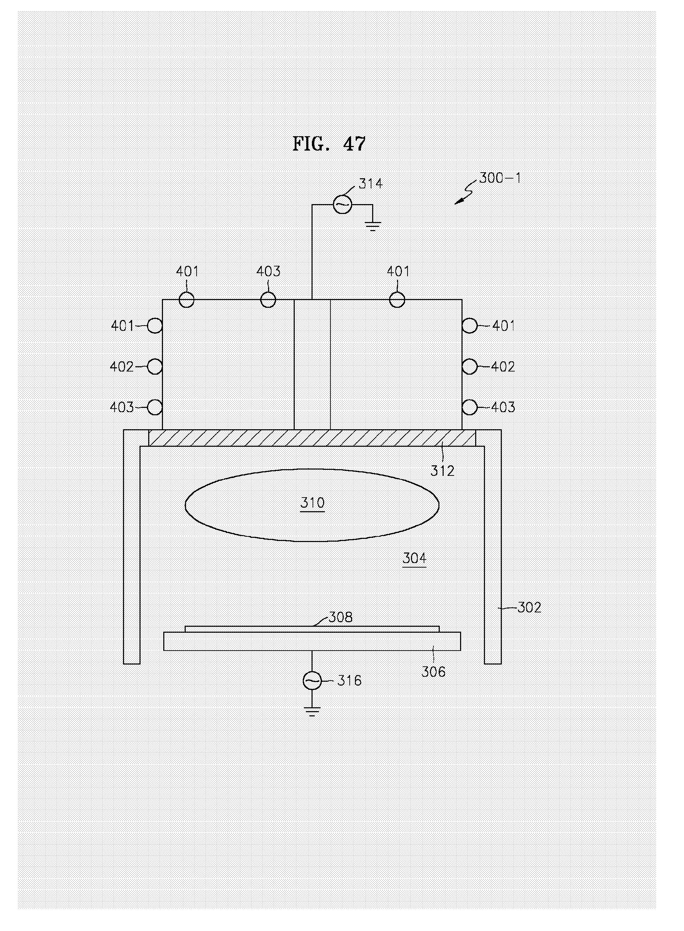

Figure 47 is a cross-sectional view of a plasma chamber using the plasma source coil of Figure 46.

Referring to Figure 47, the structure of a plasma chamber 300-1 is similar to that of the plasma chamber 300 of Figure 3 with the exception of a plasma source coil. In the plasma chamber 300-1, a certain size of inner space 304 is defined by outer walls 302 and a dome 312. Although the inner space 304 of the plasma chamber 300-1 is externally open in the drawing for simplicity, the inner space 304 is externally closed for practical use to maintain vacuum in the plasma chamber 300-1. A wafer support 306 is located at a lower portion of the inner space 304 to support semiconductor wafers 308 having certain patterns. An RF power supply 316 is connected to the wafer support 306. An insulating pillar 410, a bushing pillar 420, and unit coils 401, 402, and 403, which constitute a plasma source coil, are arranged in a certain structure on an outer surface of the dome 312. According to circumstances, the insulating pillar 410 may be a vacant space. Since the structure of the plasma source coil was described with reference to Figure 46, a description thereof will not be repeated here.

In this plasma chamber 300-1, the coil bushing 411 leads the density of plasma to reduce in the centre of a wafer such that the plasma is uniformly distributed irrespective of positions of the wafer. Also, since the plasma chamber 300-1 has a 3-dimensional shape, the density of plasma can be increased, and the resistance can be increased due to the extending lengths of coils. Thus, the plasma chamber 300-1 according to embodiments of the present invention enhances various characteristics, such as etch selectivity, etch rate, and reproducibility.

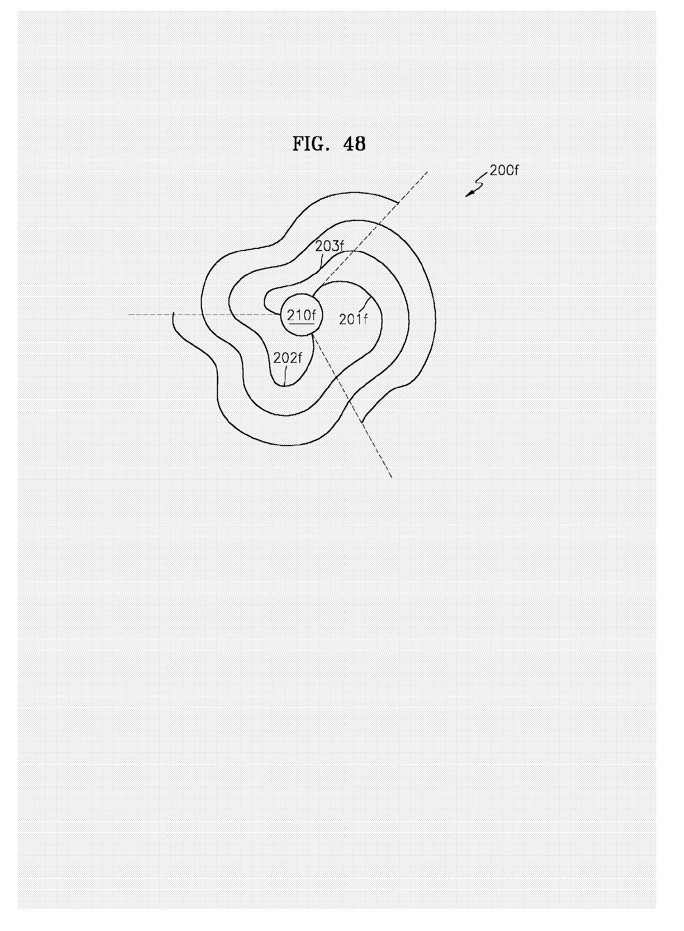

Figure 48 is a plan view of a plasma source coil according to another embodiment of the present invention.

Referring to Figure 48, the plasma source coil is comprised of a coil bushing 210f located in the centre thereof and a plurality of unit coils 201f, 202f, and 203f. The coil bushing 210f is formed of a conductive material, for example, copper. Although not shown in the drawing, the coil bushing 210f is connected to an RF power supply to receive power. Also, Figure 48 shows that the coil bushing 210f has a circular shape, but the present invention is not limited to the circular shape of the coil bushing 210f. Of course, the coil bushing 210f can have various circular shapes, such as a circle and a circular donut, or polygonal shapes, such as a square, a square donut, a hexagon, a hexagonal donut, an octagon, an octagonal donut, and a triangle.

A first unit coil 201f, a second unit coil 202f, and a third unit coil 203f are arranged to diverge from the coil bushing 210f and spirally coil around the coil bushing 210f. In the present embodiment, three unit coils were exemplarily used, but the present invention is not limited to the foregoing number of unit coils. That is, the plasma source coil can include m unit coils (here, $m \geq 2$, and m is an integer). Each of the unit coils 201f, 202f, and 203f has a number n of turns (here, n is a positive real number). Since the first, second, and third unit coils 201f, 202f, and 203f diverge from the coil bushing 210f, the power that has been supplied to the coil bushing 210f are supplied to the first, second, and third unit coils 201f, 202f, and 203f.

Each of the first, second, and third unit coils 201f, 202f, and 203f coils around the coil bushing 210f while forming a wave-shaped curve instead of maintaining a certain interval apart from the centre of the coil bushing 210f. Thus, each of the first, second, and third unit coils 201f, 202f, and 203f may be relatively far from or relatively close to the centre of the coil bushing 210f according to positions. However, it is preferable to maintain a certain interval between any two of the first, second, and third unit coils 201f, 202f, and 203f. For each of the first, second, and third unit coils 201f, 202f, and 203f, the overall length L, the intensity H of magnetic field, and the impedance Z can be expressed as shown in Equations 1, 2, and 3, respectively.

$$L = 2n\pi R_e \qquad (1)$$

$$H = \frac{nI}{2\pi R_e} \qquad (2)$$

$$Z = 2\pi n\omega R_e \qquad (3)$$

In Equations 1, 2, and 3, I denotes the amount of current that flows through each of the unit coils 201f, 202f, and 203f, $R_e$ denotes an effective radius of each coil from the centre of the coil bushing 210f, n denotes the number of turns, and w denotes the resonance frequency.

As can be seen from Equation 1, the entire length L is proportional to the effective radius $R_e$. In the plasma source coil according to embodiments of the present invention, since unit coils coil around a coil bushing located in the centre of the plasma source coil and are curved in wave shapes, each unit coil has a longer entire length L than in typical single plasma source coils. As the entire length L increases, when the number n of turns is constant, the effective radius $R_e$ also increases. As can be seen from Equation 2, the effective radius $R_e$ is inversely proportional to the intensity H of magnetic field. Also, as can be seen from Equation 3, the effective radius $R_e$ is proportional to the impedance Z. Hence, as the effective radius $R_e$ increases, the intensity H of magnetic field decreases, but the impedance Z increases.

As is well known, the intensity H of magnetic field is proportional to the density of plasma in a plasma chamber or the ion flux, whereas the impedance Z is inversely proportional to the density of plasma or the ions flux. Here, the ion flux may refer to an ion flux in a coil or an ion flux in a plasma chamber. Since the ion flux in a coil is proportional to the ion flux in a plasma chamber in a certain range, it is not necessary to distinguish one from the other. As the ion flux is reduced with a decrease in the intensity H of magnetic field and an increase in the impedance Z, the density of plasma in an edge of a wafer also decreases. A decrease in the density of plasma leads to a slowdown of the etch rate. As a result, even if the diffusing speed of removing by-products caused by chemical reactions during an etch process is high, since the etch rate also slows down, the rate ΔCD of change in critical dimension (CD) is reduced.

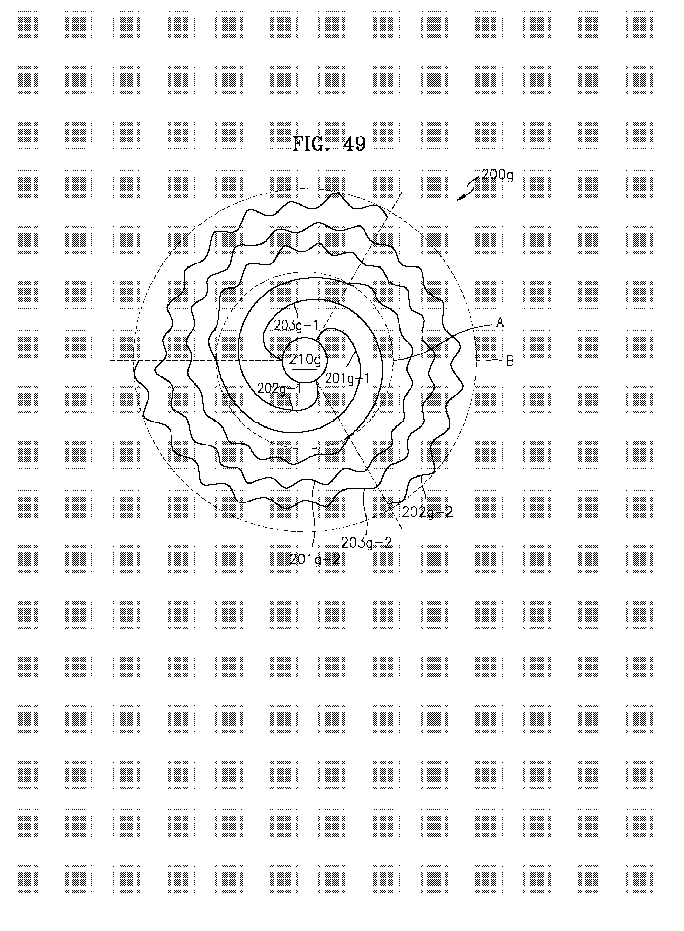

Figure 49 is a plan view of a plasma source coil according to another embodiment of the present invention.

Referring to Figure 49, the plasma source coil is comprised of a coil bushing 210g located in the centre thereof, and a first plasma source coil portion A and a second plasma source coil portion B, which sequentially surround the coil bushing 210g. The first plasma source coil portion A comprises first unit coils 201g-1, 202g-1, and 203g-1, which diverge from the coil bushing 210g and coil around the coil bushing 210g. The second plasma source coil portion B comprises second unit coils 201g-2, 202g-2, and 203g-2, which extend from the first unit coils 201g-1, 202g-1, and 203g-1, respectively, and coil around the first plasma source coil portion A.

More specifically, the coil bushing 210g, located in the centre of the first plasma source coil portion A, is formed of a conductive material, for example, copper. The first unit coils 201g-1, 202g-1, and 203g-1, which are also formed of a conductive material, for example, copper, diverge from the coil bushing 210g. Although only three unit coils 201g-1, 202g-1, and 203g-1 are shown in the drawing, which is intended merely to be illustrative, it is obvious that a greater number of unit coils than m coils (m ≥ 2, and m is an integer) can be used. The first unit coils 201g-1, 202g-1, and 203g-1 are located in a spiral shape along the circumference of the coil bushing 210g. Each of the first unit coils 201g-1, 202g-1, and 203g-1 has a number n of turns (n is a positive real number) and coils around the coil bushing 210g.

The second unit coils 201g-2, 202g-2, and 203g-2, located in the second plasma source coil portion B, diverge from the first unit coils 201g-1, 202g-1, and 203g-1, respectively. That is, the second unit coil 201g-2 diverges from the first unit coil 201g-1, the second unit coil 202g-2 diverges from the first unit coil 202g-1, and the second unit coil 203g-2 diverges from the first unit coil 203g-1. The second unit coils 201g-2, 202g-2, and 203g-2 are curved in wave shapes and coil around the first plasma source coil portion A. Thus, the second unit coils 201g-2, 202g-2, and 203g-2 may be relatively far from or relatively close to the first plasma source coil portion A according to positions. However, it is preferable to maintain a certain interval between any two of the second unit coils 201g-2, 202g-2, and 203g-2.

In the present embodiment, since the second unit coils 201g-2, 202g-2, and 203g-2 in the second plasma source coil portion B are curved in wave shapes and coil around the first plasma source coil portion A, the plasma source coil has a longer entire length L than conventional single plasma source coils. As the entire length L increases, when the number n of turns is constant, the effective radius $R_e$ also increases. As the effective radius $R_e$ increases, the intensity H of magnetic field decreases, but the impedance Z increases. Hence, as the ion flux is reduced with a decrease in the intensity H of magnetic field and an increase in the impedance Z, the density of plasma in an edge of a wafer also decreases. As described with reference to Figure 48, a decrease in the density of plasma leads to a slowdown of the etch rate. As a result, even if the diffusing speed of removing by-products caused by chemical reactions during an etch process is high, since the etch rate also slows down, the rate ΔCD is reduced.

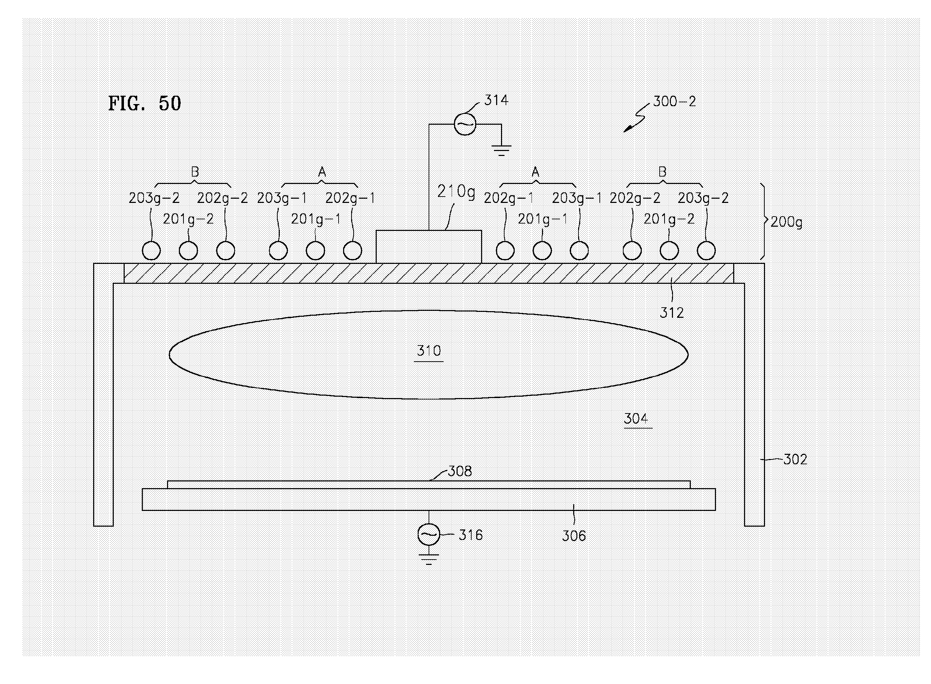

Figure 50 is a cross-sectional view of a plasma chamber using the plasma source coil of Figure 49.

Referring to Figure 50, the structure of a plasma chamber 300-2 is similar to that of the plasma chamber 300 of Figure 3 with the exception of a plasma source coil 200g. Since the operation and effect of the plasma chamber 300-2 are the same as those of the plasma chamber 300 as described with reference to Figure 3, a description thereof will not be repeated here. The plasma chamber 300-2 comprises the plasma source coil 200g, which is made up of a first plasma source coil portion A and a second plasma source coil portion B. Since the plasma source coil 200g of Figure 50 is the same as the plasma source coil as described with reference to Figure 49, a description thereof will not be repeated here.

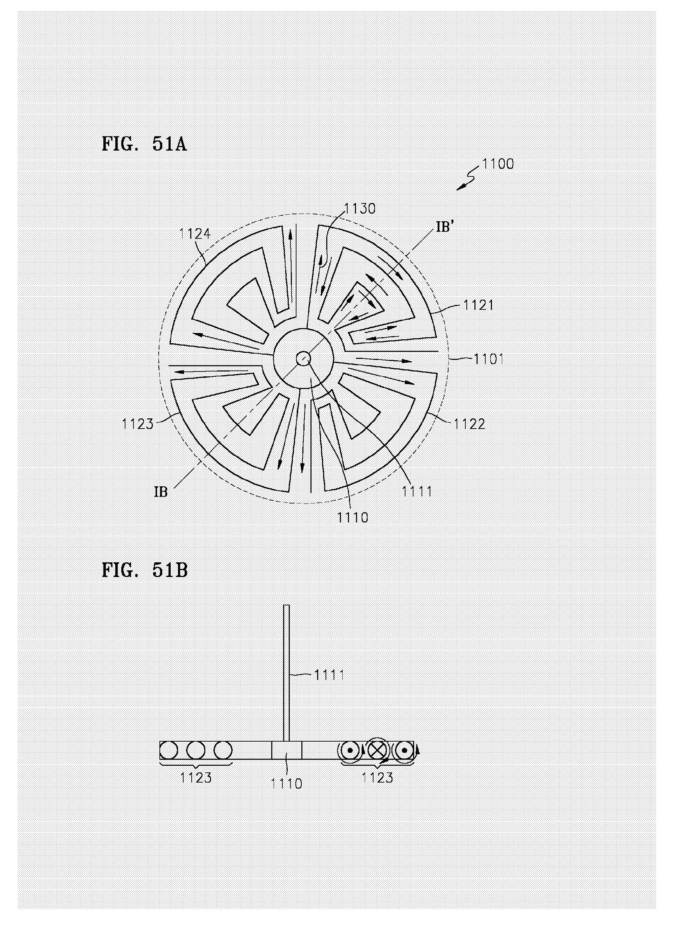

Figure 51A is a plan view of a plasma source coil according to another embodiment of the present invention, and Figure 51B is a cross-sectional view taken along line IB-IB' of Figure 51A.

Referring to Figures, 51A and 51B, a plasma source coil 1100 of the present embodiment comprises a conductive bushing 1110. The conductive bushing 1110 is connected to a power applying line 1111, through which an RF current flows from an RF power supply into the conductive bushing 1110. Four coil lines 1121, 1122, 1123, and 1124 diverge from edges of the conductive bushing 1110 and are located inside a circular boundary line 1101. An RF current flows from the conductive bushing 1110 into the respective coil lines 1121, 1122, 1123, and 1124. The first coil line 1121 and the third coil line 1123 are located in an opposite direction, and the second coil line 1122 and the fourth coil line 1124 are located in an opposite direction.

The first coil line 1121, which diverges from the conductive bushing 1110, extends from a point A toward a circular boundary line 1101, which is illustrated with a dotted line and defines the area of the plasma source coil 1100, and turns at a certain position to extend along the boundary line 1101. After that, the first coil line 1121 extends further as indicated by arrows 1130 of Figure 51A and finally is grounded (not shown) adjacent to the boundary line 1101, i.e., at a point B.

The second coil line 1122 diverges from the conductive bushing 1110 adjacent to a position of the plasma source coil 1100, where the first coil line 1121 extends toward the boundary line 1101 and is grounded. The arrangement of the second coil line 1122 is similar to that of the first coil line 1121. The third coil line 1123 diverges from the conductive bushing 1110 at a position of the plasma source coil 1100, where the second coil line 1122 extends toward the boundary line 1101 and is grounded. Likewise, the fourth coil line 1124 diverges from the conductive bushing 1110 at a position of the plasma source coil 1100, where the third coil line 1123 extends toward the boundary line 1101 and is grounded. The arrangement of the third coil line 1123 or the fourth coil line 1124 is the same as that of the first coil line 1121 or the second coil line 1122.

In this plasma source coil 1100, RF currents flow through adjacent portions of each coil line in the opposite directions. For example, in the first coil line 1121, as indicated by the arrows 1130, RF currents flow through adjacent portions of the first coil line 1121 in the opposite directions. Hence, as indicated by arrows of Figure 51B, magnetic fields generated by the RF currents that flow through the adjacent portions of the first coil line 1121 are in the same direction. Consequently, the magnetic fields do not counterbalance one another but are reinforced.

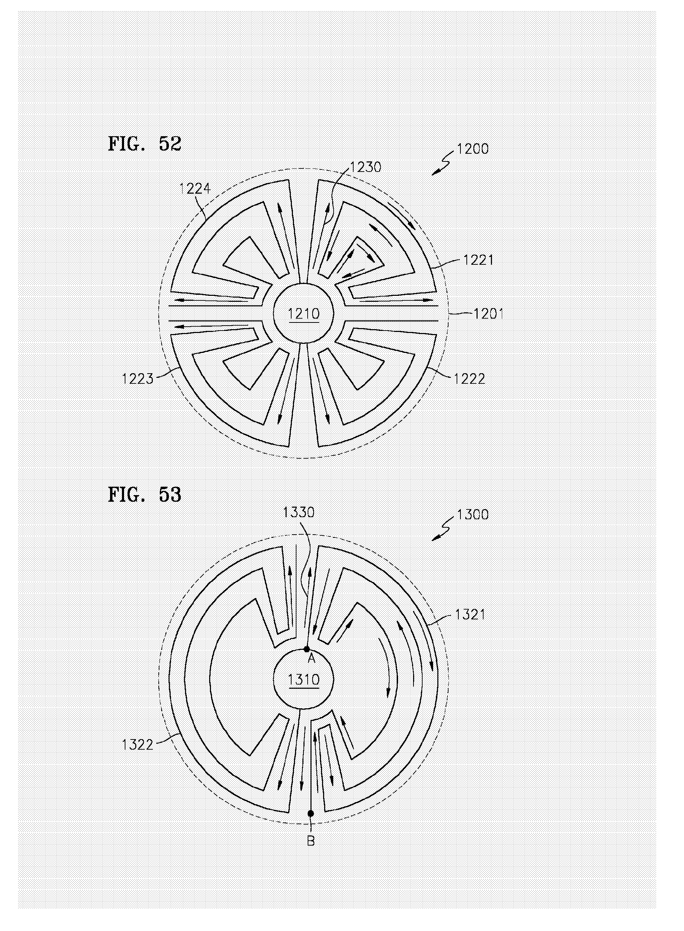

Figure 52 is a plasma source coil according to another embodiment of the present invention.

Referring to Figure 52, the structure of the plasma source coil 1200 is similar to that of the plasma source coil of Figure 51A with the exception of a position where each coil line diverges from a conductive bushing 1210. Specifically, in the plasma source coil 1100 of Figure 51A, positions where the coil lines 1121, 1122, 1123, and 1124 diverge from the conductive bushing 1110 are spaced a regular interval apart from one another. However, in the plasma source coil 1200 of the present embodiment, positions where first through fourth coil lines 1221, 1222, 1223, and 1224 diverge from the conductive bushing 1210 are not located at regular intervals. The first coil line 1221 pairs with the fourth coil line 1224, and the second coil line 1222 pairs with the third coil line 1223. A pair of coil lines diverge from the conductive bushing 1210 at adjacent positions. The first and fourth coil lines 1221 and 1224 diverge from the conductive bushing 1210 at adjacent positions, and the second and third coil lines 1222 and 1223 diverge from the conductive bushing 1210 at adjacent positions. The plasma source coil 1200 of the present embodiment has the same effect as the plasma source coil 1100. That is, as indicated by arrows 1230, RF currents flow through adjacent portions of each coil line in the opposite directions. As a result, the intensity of magnetic field increases.

Figure 53 is a plan view of a plasma source coil according to another embodiment of the present invention.

Referring to Figure 53, the structure of the plasma source coil 1300 is similar to that of the plasma source coil 1100 of Figure 51A, with the exception of the number of coil lines that diverge from a conductive bushing 1310. That is, while the plasma source coil 1100 includes four coil lines that diverge from the conductive bushing 1110, the plasma source coil 1300 of the present embodiment includes two coil lines that diverge from the conductive bushing 1310. The plasma source coil 1300 comprises the conductive bushing 1310, from which a first coil line 1321 and a second coil line 1322 diverge. A position of the plasma source coil 1300 where the first coil line 1321 diverges from the conductive bushing 1310 is directly opposite to a position where the second coil line 1322 diverges therefrom. The first coil line 1321 is located on the right of the plasma source coil 1300, and the second coil line 1322 is located on the left thereof.

The first coil line 1321, which diverges from the conductive bushing 1310, extends from a point A toward a circular boundary line, which is illustrated with a dotted line and defines the area of the plasma source coil 1300, and turns at a certain position adjacent to the boundary line to extend along the boundary line. After that, the first coil line 1321 extends further as indicated by arrows 1330 and finally is grounded (not shown) adjacent to the boundary line, i.e., at a point B. The arrangement of the second coil line 1322 is the same as that of the first coil line 1321. The plasma source coil 1300 of the present embodiment has the same effect as the plasma source coils of other foregoing embodiments. That is, as indicated by arrows 1330, RF currents flow through adjacent portions of each coil line in the opposite directions. As a result, the intensity of magnetic field increases.

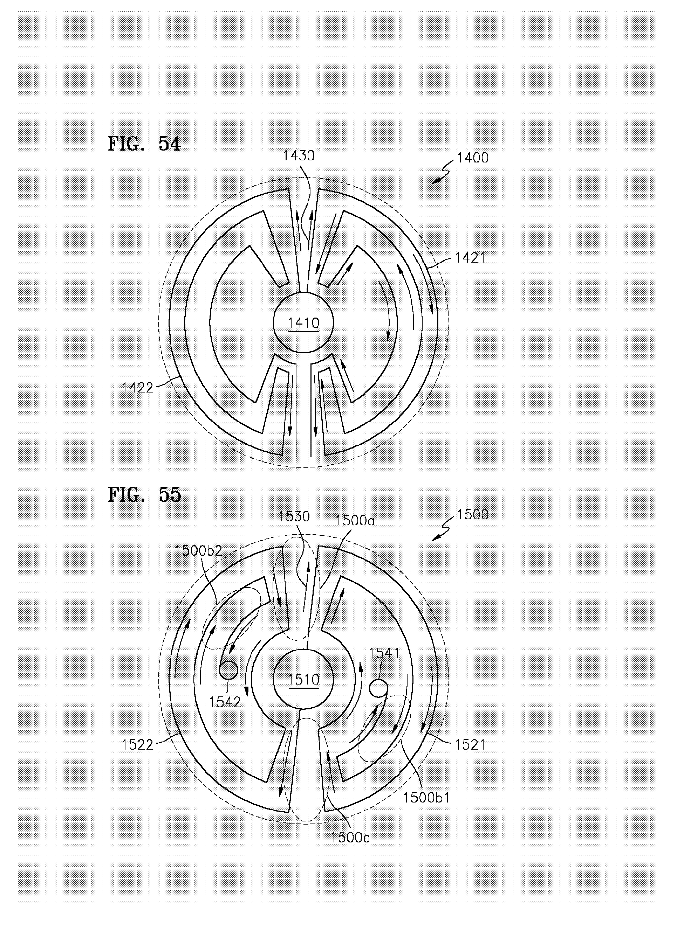

Figure 54 is a plan view of a plasma source coil according to another embodiment of the present invention.

Referring to Figure 54, the structure of the plasma source coil 1400 is similar to that of the plasma source coil 1300 of Figure 53, with the exception of a position where each coil line diverges from a conductive bushing 1410. Specifically, in the plasma source coil 1300 of Figure 53, a position where the first coil line 1321 diverges from the conductive bushing 1310 is directly opposite to a position where the second coil line 1322 diverges therefrom. However, in the plasma source coil 1400 of the present embodiment, a position where a first coil line 1421 diverges from the conductive bushing 1410 is adjacent to a position where a second coil line 1422 diverges therefrom. The first and second coil lines 1421 and 1422 diverge from adjacent positions of the conductive bushing 1410 and extend in the opposite directions. That is, the first coil line 1421 extends on the right of the conductive bushing 1410, and the second coil 1422 extends on the left thereof. Since the arrangement of the plasma source coil 1400 is similar to that of the plasma source coil 1300 of Figure 53, a description thereof will not be repeated here. The plasma source coil 1400 of the present embodiment has the same effect as other foregoing plasma source coils. That is, as indicated by arrows 1430, RF currents flow through adjacent portions of each coil line in the opposite directions. As a result, the intensity of magnetic field increases.

Figure 55 is a plan view of a plasma source coil according to another embodiment of the present invention.

Referring to Figure 55, the plasma source coil 1500 of the present embodiment comprises a conductive bushing 1510, from which a first coil line 1521 and a second coil line 1522 diverge. A position where the first coil line 1521 diverges from the conductive bushing 1510 is directly opposite to a position where the second coil line 1522 diverges therefrom. The first coil line 1521 diverges from an upper position of the conductive bushing 1510 and is located in a right semicircle of a circular boundary line, which is illustrated with a dotted line and defines the area of the plasma source coil 1500. The second coil line 1522 diverges from a lower position of the conductive bushing 1510 and is located in a left semicircle of the boundary line. Here, the first coil line 1521 extends spirally in the right semicircle and the second coil line 1522 extends spirally in the right semicircle inside the circular boundary line.

More specifically, the first coil line 1521, which diverges from the conductive bushing 1510, extends toward the boundary line and turns at a certain position adjacent to the boundary line to extend along the boundary line. After that, the first coil line 1521 extends spirally as indicated by arrows 1530 and finally is connected to a first ground line 1541 that is located in the centre of the right semicircle of the boundary line. Similarly, the second coil line 1522 diverges from the conductive bushing 1522, extends spirally in the left semicircle, and finally is connected to a second ground line 1542 that is located in the centre of the left semicircle of the boundary line.

In the plasma source coil 1500 of the present embodiment, RF currents flow through some adjacent portions of the first coil line 1521 or the second coil line 1522 in the same direction. However, the RF current flows through the first coil line 1521 in the opposite direction from the RF current that flows through the second coil line 1522 at a portion 1500a where the first coil line 1521 is adjacent to the second coil line 1522. Thus, the intensity of magnetic field increases at the portion 1500a. Also, RF currents flow through adjacent portions of the first coil line 1541 in the opposite directions at a portion 1500b1 adjacent to the first ground line 1541. Similarly, RF currents flow through adjacent portions of the second coil line 1542 in the opposite directions at a portion 1500b2 adjacent to the second ground line 1542. The intensity of magnetic field increases at the portions 1500b1 and 1500b2.

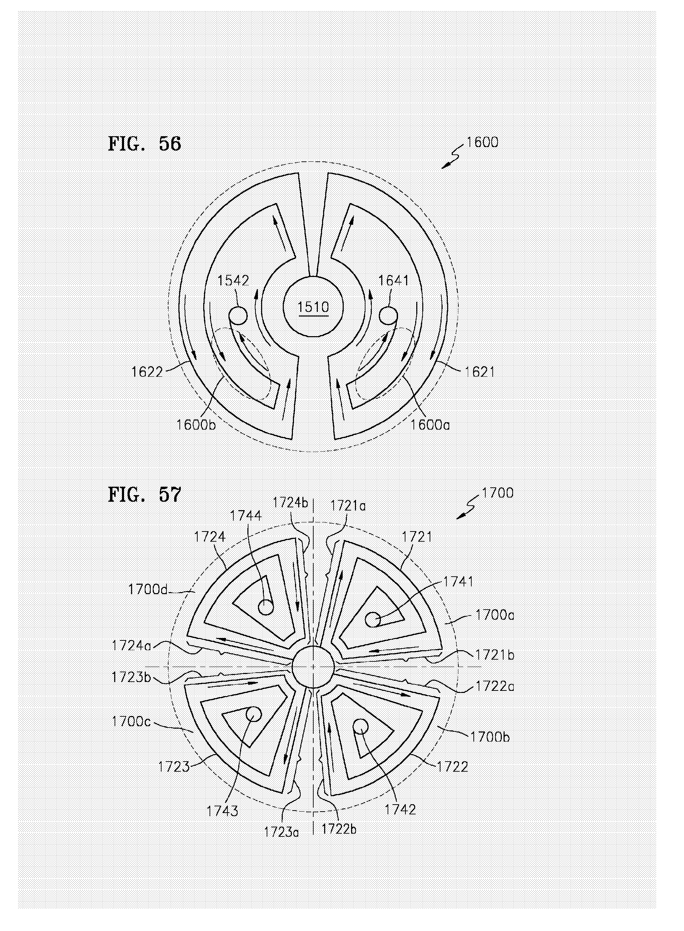

Figure 56 is a plan view of a plasma source coil according to another embodiment of the present invention.

Referring to Figure 56, the structure of the plasma source coil 1600 is similar to that of the plasma source coil 1500 of Figure 55 with the exception of a position where each coil line diverges from a conductive bushing 1610. Specifically, in the plasma source coil 1500 of Figure 55, a position where a first coil line 1521 diverges from the conductive bushing 1510 is directly opposite to a position where a second coil line 1522 diverges therefrom. However, in the plasma source coil 1600, a position where a first coil line 1621 diverges from the conductive bushing 1510 is adjacent to a position where a second coil line 1622 diverges therefrom. The first coil line 1621, which diverges from the conductive bushing 1610, extends toward a circular boundary line, which is illustrated with a dotted line, and turns to the right at a certain position adjacent to the boundary line. After that, the first coil line 1621 extends spirally as indicated by arrows and finally is connected to a first ground line 1641. Likewise, the second coil line 1622 diverges from the conductive bushing 1610 at a position adjacent to the position where the first coil line 1621 diverges, extends spirally in a left semicircle of the boundary line, and finally is connected to a second ground line 1642.

In the plasma source coil 1600, RF currents flow through adjacent portions of the first coil line 1641 in the opposite directions at a portion 1600a adjacent to the first ground line 1641. Similarly, RF currents flow through adjacent portions of the second coil line 1642 in the opposite directions at a portion 1600b adjacent to the second ground line 1642. The intensity of magnetic field increases at the portions 1600a and 1600b.

Figure 57 is a plan view of a plasma source coil according to another embodiment of the present invention.

Referring to Figure 57, the plasma source coil 1700 of the present embodiment comprises a conductive bushing 1710 and has an area defined by a circular boundary line, which is illustrated with a dotted line and spaced a certain radius apart from the conductive bushing 1710. The area defined by the circular boundary line is divided into four regions, i.e., a first region 1700a, a second region 1700b, a third region 1700c, and a fourth region 1700d. A first coil line 1721 diverges from the conductive bushing 1710 and is located in the first region 1700a. A second coil line 1722 diverges from the conductive bushing 1710 and is located in the second region. A third coil line 1723 diverges from the conductive bushing 1710 and is located in the third region 1700c. Also, a fourth coil line 1724 diverges from the conductive bushing 1710 and is located in the fourth region 1700d.

The first coil line 1721 diverges from the conductive bushing 1710 and extends in a fan blade shape to reach a first ground line 1741 located in the centre of the first region 1700a. The second coil line 1722 diverges from the conductive bushing 1710 and extends in a fan blade shape to reach a second ground line 1742 located in the centre of the second region 1700b. The third coil line 1723 diverges from the conductive bushing 1710 and extends in a fan blade shape to reach a third ground line 1743 located in the centre of the third region 1700c. Also, the fourth coil line 1724 diverges from the conductive bushing 1710 and extends in a fan blade shape to reach a fourth ground line 1744 located in the centre of the fourth region 1700d. More specifically, each of the first, second, third, and fourth coil lines 1721, 1722, 1723, and 1724 extends radially from the conductive bushing 1710 toward the boundary line, then extends parallel to the boundary line, then goes back toward the conductive bushing 1710, then extends parallel to the conductive bushing 1710, and then repeats the above trajectory to reach the first, second, third, or fourth ground line 1741, 1742,1743, or 1744.

In this arrangement, a first portion 1721a of the first coil line 1721 is located adjacent to a second portion 1724b of the fourth coil line 1724, and a second portion 1721b of the first coil line 1721 is located adjacent to a first portion 1722a of the second coil line 1722. A second portion 1722b of the second coil line 1722 is located adjacent to a first portion 1723a of the third coil line 1723, and a second portion 1723b of the third coil line 1723 is located adjacent to a first portion 1724a of the fourth coil line 1724. As indicated by arrows, RF currents flow through these adjacent portions (1721a and 1724b, 1721b and 1722a, 1722b and 1723a, and 1723b and 1724a) of the coil lines 1721, 1722, 1723, and 1724, in the opposite directions. Thus, the intensity of magnetic field increases between the first portion 1721a of the first coil line 1721 and the second portion 1724b of the fourth coil 1724, the second portion 1721b of the first coil line 1721 and the first portion 1722a of the second coil line 1722, the second portion 1722b of the second coil line 1722 and the first portion 1723a of the third coil line 1723, and the second portion 1723b of the third coil line 1723 and the first portion 1724a of the fourth coil line 1724.

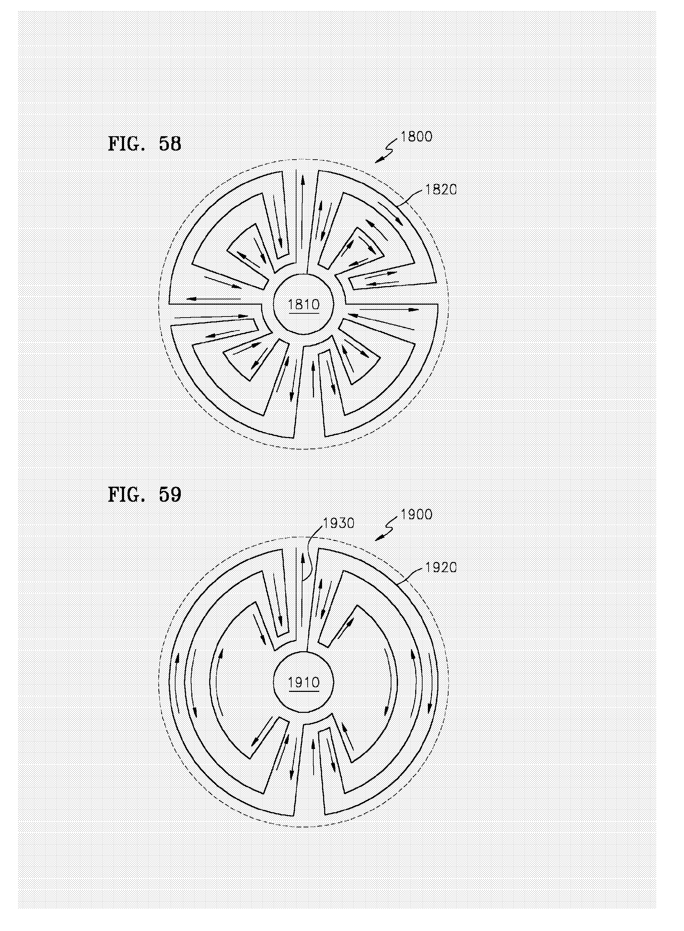

Figure 58 is a top plan view of a plasma source coil according to another embodiment of the present invention.

Referring to Figure 58, the plasma source coil 1800 of the present embodiment is different from the above-described other embodiments in that only one coil line 1820 diverges from a conductive bushing 1810. That is, the coil line 1820 diverges from the conductive bushing 1810 and extends in the shape of four fan blades in a circular boundary line, which is illustrated with a dotted line. More specifically, the coil line 1820 extends from the conductive bushing 1810 toward the boundary line and then extends parallel to the boundary line. After extending by less than a 1/4 the circumference of the boundary line, the coil line 1820 goes back toward the conductive bushing 1810, then extends parallel to the conductive bushing 1810, and then repeats the above trajectory of a fan blade. The coil 1820 repeats this process four times as indicated by arrows. In this arrangement, many portions of the coil line 1820 are located adjacent to one another, and RF currents flow through the adjacent portions in the opposite directions. Thus, the intensity of magnetic field increases between the adjacent portions of the coil line 1820.

Figure 59 is a plan view of a plasma source coil according to another embodiment of the present invention.

Referring to Figure 59, the structure of the plasma source coil 1900 of the present embodiment is similar to that of the plasma source coil 1800 of Figure 58, except that the plasma source coil 1900 has the shape of two semicircles. That is, in the plasma source coil 1900, one coil line 1920 diverges from a conductive bushing 1910 and extends inside a circular boundary line, which is illustrated with a dotted line. The coil line 1920 extends in a right semicircle of the boundary line to form a fan blade shape and then extends in a left semicircle of the boundary line to form another fan blade shape. In the plasma source coil 1900, as indicated by arrows 1930, RF currents flow through adjacent portions of the coil line 1920 in the opposite directions. Thus, the intensity of magnetic field increases between the adjacent portions of the coil line 1920.

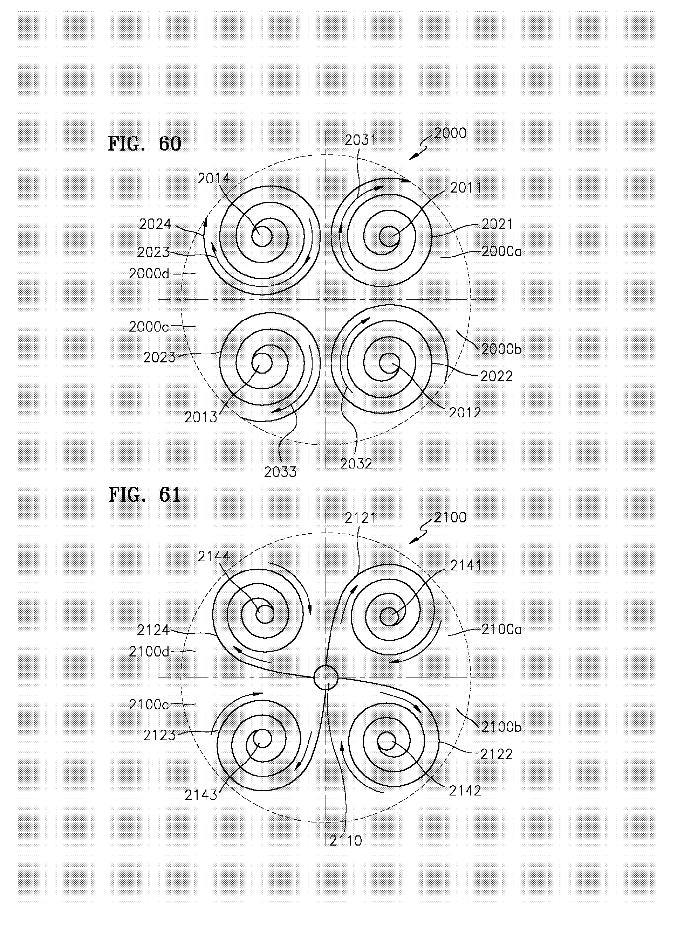

Figure 60 is a plan view of a plasma source coil according to another embodiment of the present invention.

Referring to Figure 60, in the plasma source coil 2000 of the present embodiment, an area is defined by a circular boundary line, which is illustrated with a dotted line and divided into a first region 2000a, a second region 2000b, a third region 2000c, and a fourth region 2000d. A first conductive bushing 2011 is located in the centre of the first region 2000a, and a second conductive bushing 2012 is located in the centre of the second region 2000b. A third conductive bushing 2013 is located in the centre of the third region 2000c, and a fourth conductive bushing 2014 is located in the centre of the fourth region 2000d. A first coil line 2021 diverges from the first conductive bushing 2011 and turns spirally clockwise inside the first region 2000a to reach the boundary line. Likewise, a second coil line 2022 diverges from the second conductive bushing 2012 and turns spirally clockwise inside the second region 2000b to reach the boundary line. Third and fourth coil lines 2023 and 2024 extend in the same manner as the first and second coil lines 2021 and 2022.

In this arrangement, RF currents flow through adjacent portions of each of the coil lines 2021, 2022, 2023, and 2024 in the same direction. Thus, the intensity of magnetic field does not increase in the adjacent portions of each coil line. However, there are a portion where the first coil line 2021 is adjacent to the second coil line 2022 between the first region 2000a and the second region 2000b, a portion where the second coil line 2022 is adjacent to the third coil line 2023 between the second region 2000b and the third region 2000c, a portion where the third coil line 2023 is adjacent to the fourth coil line 2024 between the third region 2000c and the fourth region 2000d, and a portion where the fourth coil line 2024 is adjacent to the first coil line 2021 between the fourth region 2000d and the first region 2000a. As indicated by arrows, RF currents flow through two adjacent coil lines between two regions, in the opposite directions. Thus, the intensity of magnetic field increases at each of the portions where one coil line is adjacent to another coil line between the two regions.

Figure 61 is a plan view of a plasma source coil according to another embodiment of the present invention.

Referring to Figure 61, in the plasma source coil 2100 of the present embodiment, an area is defined by a circular boundary line, which is illustrated with a dotted line, and divided into a first region 2100a, a second region 2100b, a third region 2100c, and a fourth region 2100d. A conductive bushing 2110 is located in the centre of the plasma source coil 2100. A first ground line 2141 is located in the centre of the first region 2100a, and a second ground line 2142 is located in the centre of the second region 2100b. A third ground line 2143 is located in the centre of the third region 2100c, and a fourth ground line 2144 is located in the centre of the fourth region 2100d. A first coil line 2121 diverges from the conductive bushing 2110 and extends spirally inside the first region 2100a to reach the first ground line 2141. Likewise, the second coil line 2122 diverges from the conductive bushing 2110 and extends spirally inside the second region 2100b to reach the second ground line 2142. Third and fourth coil lines 2123 and 2124 extend in the same manner as the first and second coil lines 2121 and 2122.

In this arrangement, RF currents flow through adjacent portions of each of the coil lines 2121, 2122, 2123, and 2124 in the same direction. Thus, the intensity of magnetic field does not increase in the adjacent portions of each coil line. However, there are a portion where the first coil line 2121 is adjacent to the second coil line 2122 between the first region 2100a and the second region 2100b, a portion where the second coil line 2122 is adjacent to the third coil line 2123 between the second region 2100b and the third region 2100c, a portion where the third coil line 2123 is adjacent to the fourth coil line 2124 between the third region 2100c and the fourth region 2100d, and a portion where the fourth coil line 2124 is adjacent to the first coil line 2121 between the fourth region 2100d and the first region 2100a. As indicated by arrows, RF currents flow through two adjacent coil lines between two regions, in the opposite directions. Thus, the intensity of magnetic field increases at each of the portions where one coil line is adjacent to another coil line between the two regions.

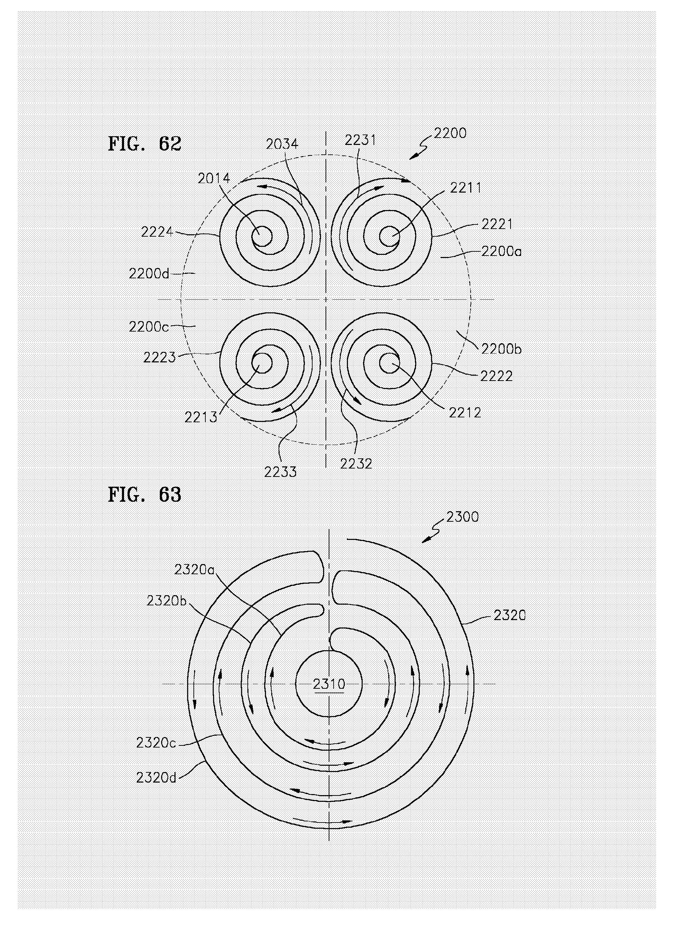

Figure 62 is a plan view of a plasma source coil according to another embodiment of the present invention.

Referring to Figure 62, the structure of the plasma source coil 200 is similar to that of the plasma source coil 2000 of Figure 60, except that the plasma source coil 2200 comprises both clockwise coil lines and counterclockwise coil lines. More specifically, in the plasma source coil 2200, an area is defined by a circular boundary line, which is illustrated with a dotted line, and divided into a first region 2200a, a second region 2200b, a third region 2200c, and a fourth region 2200d. A first conductive bushing 2211 is located in the centre of the first region 2200a, and a second conductive bushing 2212 is located in the centre of the second region 2200b. A third conductive bushing 2213 is located in the centre of the third region 2200c, and a fourth conductive bushing 2214 is located in the centre of the fourth region 2200d.

A first coil line 2221 diverges from the first conductive bushing 2211 and turns spirally clockwise inside the first region 2200a to reach the boundary line. A second coil line 2222 diverges from the second conductive bushing 2212 and turns spirally counterclockwise inside the second region 2200b to reach the boundary line. A third coil line 2223 diverges from the third conductive bushing 2213 and turns spirally clockwise inside the third region 2200c. A fourth coil line 2224 diverges from the fourth conductive bushing 2214 and turns spirally counterclockwise inside the fourth region 2200d. That is, the first and third coil lines 2221 and 2223 each have a clockwise spiral structure, and the second and fourth coil lines 2222 and 2224 each have a counterclockwise spiral structure.

In this arrangement, RF currents flow through adjacent portions of each of the coil lines 2221, 2222, 2223, and 2224 in the same direction. Thus, the intensity of magnetic field does not increase in the adjacent portions of each coil line. However, a direction 2231 in which the RF current flows through the first coil line 2221 is opposite to a direction 2233 in which the RF current flows through the third coil line 2223 at a portion between the first region 2200a and the third region 2200c. Also, a direction 2232 in which the RF current flows through the second coil line 2222 is opposite to a direction 2234 in which the RF current flows through the fourth coil line 2224 at a portion between the second region 2200b and the fourth region 2200d. Accordingly, the intensity of magnetic field increases at these portions between opposite regions.

Figure 63 is a plan view of a plasma source coil according to another embodiment of the present invention.

Referring to Figure 63, the plasma source coil 2300 of the present embodiment comprises a conductive bushing 2310, from which one coil line 2320 extends so as to form a plurality of circular layers around the conductive bushing 2310. Specifically, the coil line 2320 diverges from the conductive bushing 2310 and extends around the conductive bushing 2310 so as to form a first circular layer 2320a. After making a turn, the coil line 2320 turns back and extends around the first circular layer 2320a so as to form a second circular layer 2320b. After making another turn, the coil line 2320 turns back and extends around the second circular layer 2320b so as to form a third circular layer 2320c. Also, after making yet another turn, the coil line 2320 turns back and extends around the third circular layer 2320c so as to form a fourth circular layer 2320d.

In this arrangement, as indicated by arrows, RF currents flow through adjacent ones of the circular layers 2320a, 2320b, 2320c, and 2320d, in the opposite directions. Thus, the intensity of magnetic field increases between adjacent circular layers.

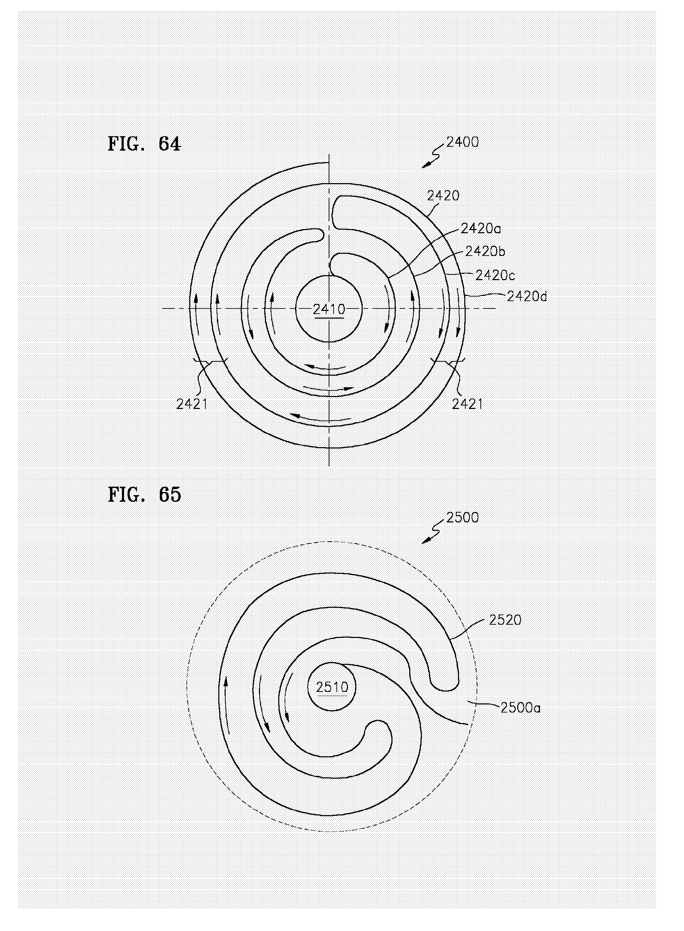

Figure 64 is a plan view of a plasma source coil according to another embodiment of the present invention.

Referring to Figure 64, the structure of the plasma source coil 2400 is similar to that of the plasma source coil 2300 of Figure 63, except that a coil line 2420 makes two or more turn in the same direction once. Specifically, the coil line 2420 diverges from the conductive bushing 2410 and extends around a conductive bushing 2410 so as to form a first circular layer 2420a. After making a turn, the coil line 2420 turns back and extends around the first circular layer 2420a so as to form a second circular layer 2420b. After making another turn, the coil line 2420 turns back and extends around the second circular layer 2420b so as to form a third circular layer 2420c. After making yet another turn, the coil line 2420 does not turn back and keeps extending around the third circular layer 2420c so as to form a fourth circular layer 2420d. As indicated by arrows, RF currents flow through adjacent ones of the circular layers 2420a, 2420b, and 2420c in the opposite directions, whereas RF currents flow through the third circular layer 2420c and the fourth circular layer 2420d in the same direction.

Figure 65 is a plan view of a plasma source coil according to another embodiment of the present invention.

Referring to Figure 65, the plasma source coil 2500 of the present embodiment comprises a conductive bushing 2510. A coil line 2520 diverges from the conductive bushing 2510 and extends around the conductive bushing 2510 while making a big turn. After that, the coil line 2520 turns back, extends around the conductive bushing 2510 while making a small turn, and repeats it until the coil line 2520 almost reaches the conductive bushing 2510. Then, the coil line 2520 extends from the vicinity of the conductive bushing 2510 toward a circular boundary line. In the plasma source coil 2500, as indicated by arrows, RF currents flow through adjacent portions of the coil line 2520 in the opposite directions. Thus, the intensity of magnetic field increases at the adjacent portions of the coil lines 2520.

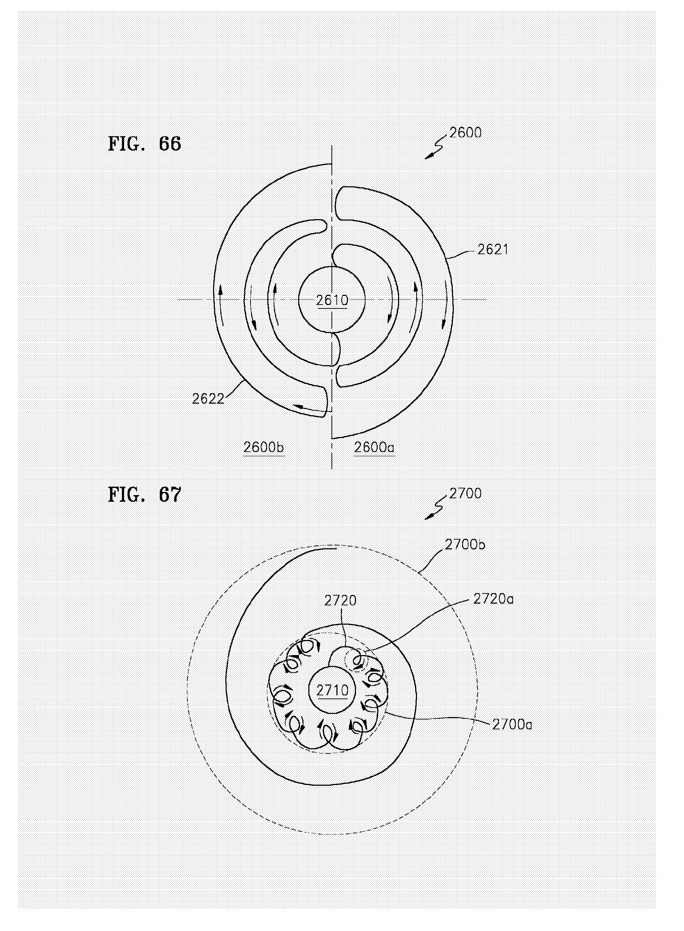

Figure 66 is a plan view of a plasma source coil according to another embodiment of the present invention.

Referring to Figure 66, the structure of the plasma source coil 2600 is similar to that of the plasma source coil 2400 of Figure 64. However, in the plasma source coil 2600, two coil lines, i.e., a first coil line 2621 and a second coil line 2622 diverge from a conductive bushing 2610 symmetrically with respect to the conductive bushing 2610. Also, each of the first coil line 2621 and the second coil line 2622 extends around the conductive bushing 2610, makes a half turn, turns back, and then repeats it. The first coil line 2621 extends in an opposite direction to a direction in which the second coil line 2621 extends. In this plasma source coil 2600, RF currents flow through adjacent portions of the first coil line 2621 or the second coil line 2622 in the opposite directions. Thus, the intensity of magnetic field increases between the adjacent portions of the first coil line 2621 or the second coil line 2622.

Figure 67 is a plan view of a plasma source coil according to another embodiment of the present invention.

Referring to Figure 67, the plasma source coil 2700 of the present embodiment comprises a conductive bushing 2710, which is located in the centre of a first region 2700a having a relatively small radius and a second region 2700b having a relatively large radius. A coil line 2720 diverges from a conductive bushing 2710, is arranged in a spring shape in the first region 2700a, and then arranged to simply surround the first region 2700a in the second region 2700b. In the first region 2700a of the plasma source coil 2700, a direction in which the RF current flows through a portion 2720a where the coil line 2720 is twisted is opposite to directions in which the RF current flows through adjacent portions where the coil line 2720 is twisted as indicated by arrows. Thus, the intensity of magnetic field increases between adjacent portions where the coil line 2720 is twisted.

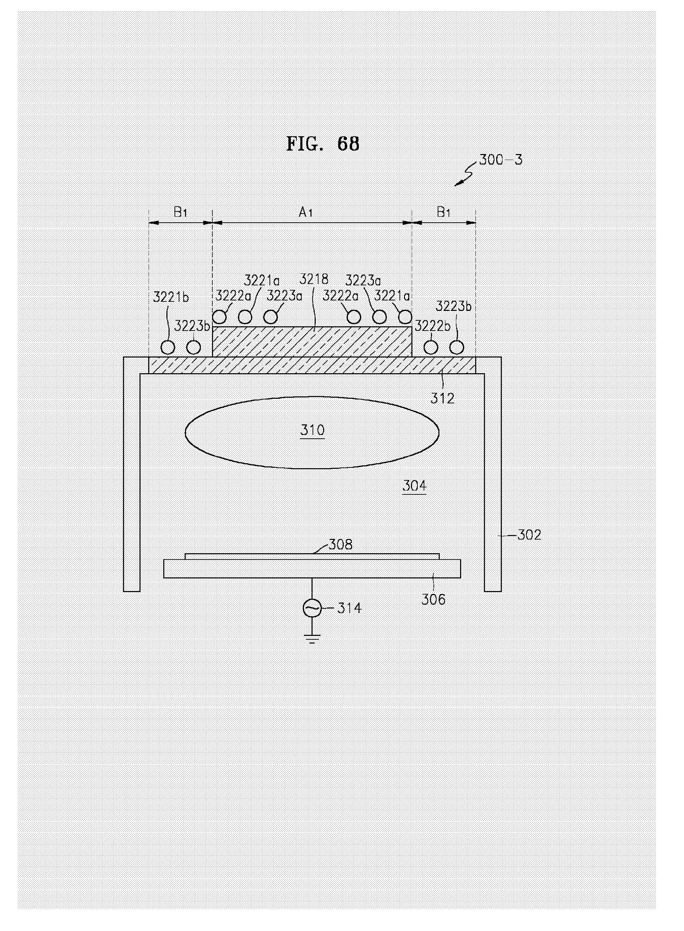

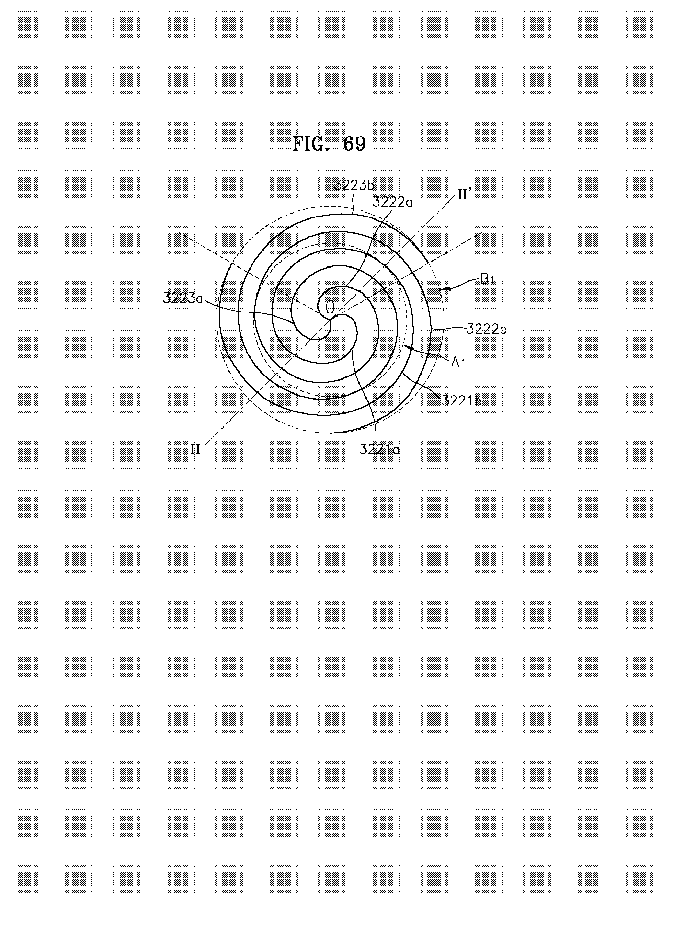

Figure 68 is a cross-sectional view of a plasma chamber according to another embodiment of the present invention. Figure 69 shows an example of a plasma source coil of the plasma chamber of Figure 68. The cross-sectional view of Figure 68 is taken along line II - II' of Figure 69.

Referring to Figures 68 and 69, the plasma chamber 300-3 of the present embodiment is similar to the plasma chamber 300 of Figure 2 with the exception of the plasma source coil. In the plasma chamber 300-3, the plasma source coil for generating plasma is located on an outer surface of a dome 312. The plasma source coil is comprised of a plurality of unit coils, for example, first unit coils 3221a and 3221b, second unit coils 3222a and 3222b, and third unit coils 3223a and 3223b, which diverge from a central point O. In particular, these unit coils are distributed throughout a first region A1, which is located above, and a second region B2, which is located below. More specifically, the first, second, and third unit coils 3221a, 3222a, and 3223a are arranged in a spiral shape around the central point O in the first region A1, which is located farther from the top surface of the dome 312 than the second region B1. For this, the first, second, and third unit coils 3221a, 3222a, and 3223a are arranged on an insulating material layer, for example, a ceramic layer 3218, located on the top surface of the dome 312. In this case, the first, second, and third unit coils 3221a, 3222a, and 3223a are spaced at least the thickness of the ceramic layer 3218 apart from the top surface of the dome 312. The ceramic layer 3218 may be replaced by air according to circumstances. If air replaces the ceramic layer 3218, the plasma chamber 300-3 may further require a support portion for supporting the first, second, and third unit coils 3221a, 3222a, and 3223a.

In the second region B1, which is located closer to the top surface of the dome 312 than the first region A1, the first, second, and third unit coils 3221b, 3222b, and 3223b extend from the first, second, and third unit coils 3221a, 3222a, and 3223a, respectively, and are arranged in a spiral shape. Thus, the second region B1 surrounds the first region A1. As a result, the first region A1 is located to correspond to a central portion of a wafer 308 loaded in the plasma chamber 300-3, and the second region B1 is located to correspond to an edge of the wafer 308. Although not shown in the drawing, the unit coils 3221a, 3221b, 3222a, 3222b, 3223a, and 3223b are connected to an RF power supply (not shown) to receive RF power from the RF power supply.

In the plasma chamber 300-3, the first, second, and third unit coils 3221b, 3222b, and 3223b in the second region B1 corresponding to the edge of the wafer 308 are spaced farther from an inner space 304 of the plasma chamber 300-3, while the first, second, and third unit coils 3221a, 3222a, and 3223a in the first region A1 corresponding to the central portion of the wafer 308 are spaced closer to the inner space 304 of the plasma chamber 300-3. Thus, a relatively high density of plasma in the central portion of the wafer 308 can be reduced, while a relatively high density of plasma in the edge of the wafer 308 can be increased. As a result, the density of plasma can be uniform irrespective of positions of the wafer 308.

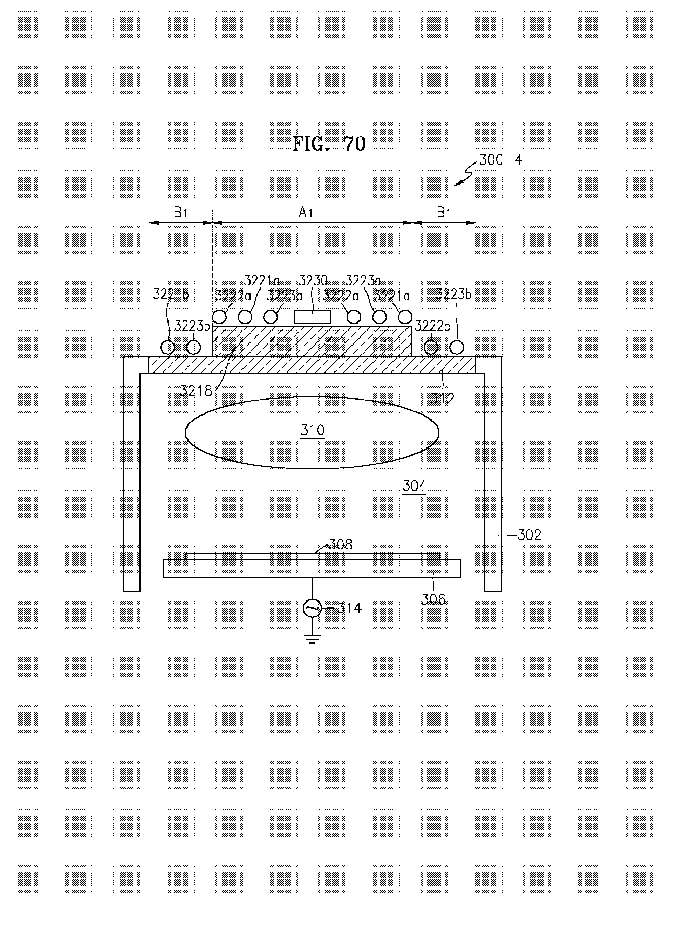

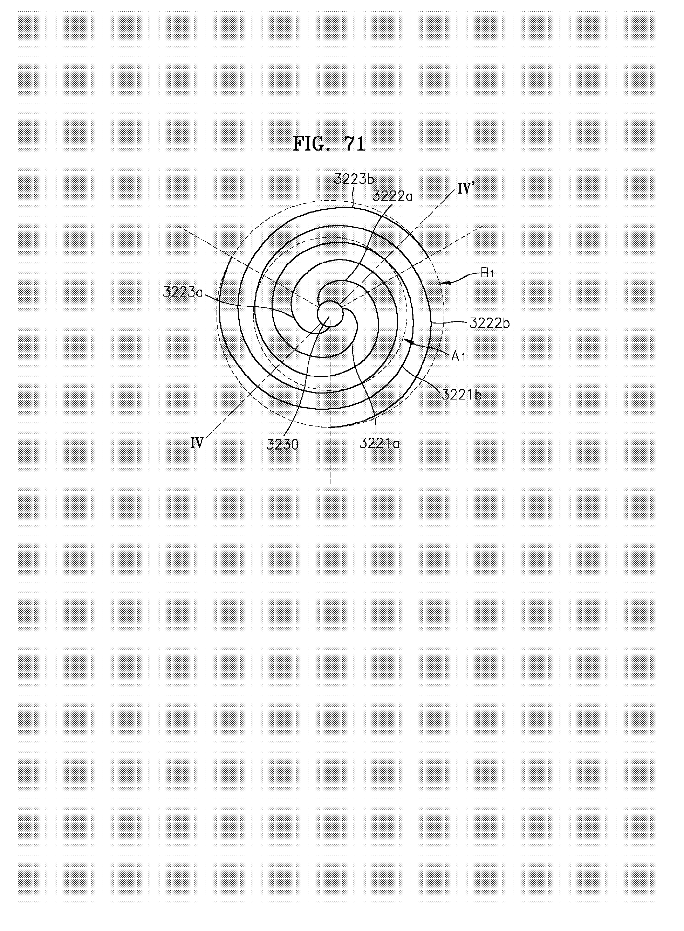

Figure 70 is a cross-sectional view of a plasma chamber according to another embodiment of the present invention. Figure 71 shows an example of a plasma source coil of the plasma chamber of Figure 70. The cross-sectional view of Figure 70 is taken along line IV - IV' of Figure 71. In Figure 70, the same reference numerals are used to denote the same elements as in Figure 68.

Referring to Figures 70 and 71, the structure of the plasma chamber 300-4 is similar to that of the plasma chamber 300-3 of Figure 68, except that the plasma source coil of Figure 70 located on a dome 312 further comprises a coil bushing 3230. That is, a coil bushing 3230 having a certain radius is located in the centre of a first region A, and a first unit coil 3221a, a second unit coil 3222a, and a third unit coil 3223a diverge from the coil bushing 3230 and are located in a spiral shape around the coil bushing 3230. This coil bushing 3230 is formed of a conductive material and connected to an RF power supply (not shown) so as to supply RF power to the first, second, and third unit coils 3221a, 3222a, and 3223a. In the plasma chamber 300-4 of the present embodiment, the coil bushing 3230 is located above a central portion of a wafer 308, thus lowering the density of plasma in the centre of the wafer 308 more effectively. As a result, the density of plasma can be uniform irrespective of positions of the wafer 308.

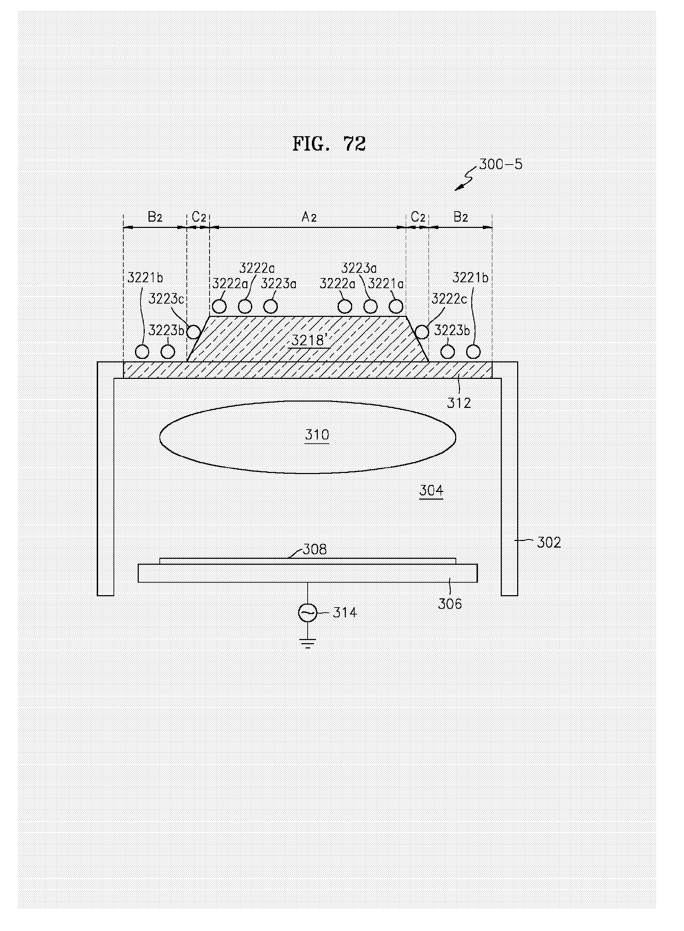

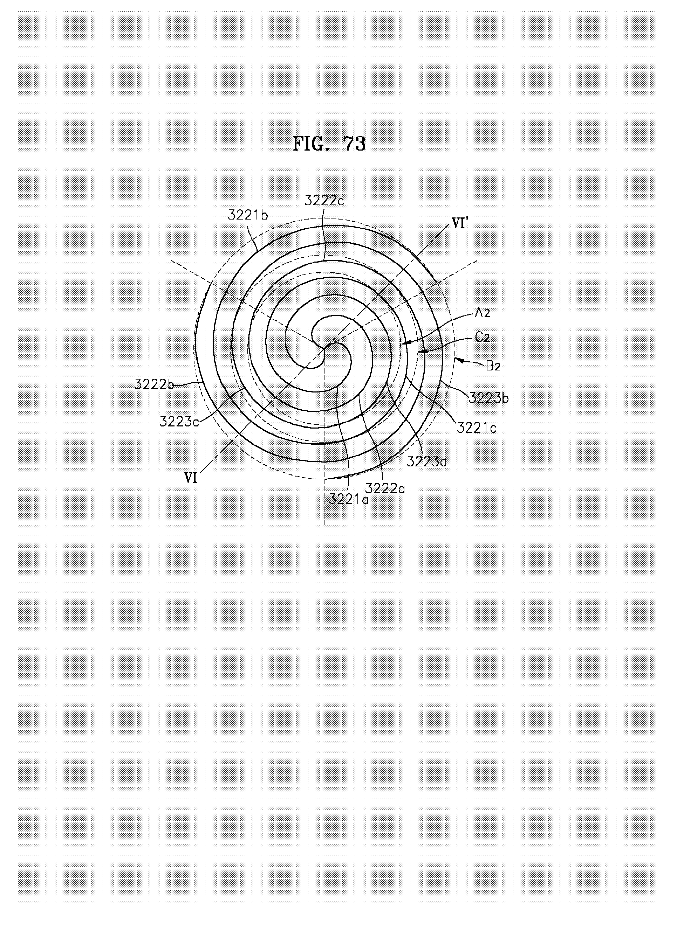

Figure 72 is a cross-sectional view of a plasma chamber according to another embodiment of the present invention. Figure 73 shows an example of a plasma source coil of the plasma chamber of Figure 72. The cross-sectional view of Figure 72 is taken along line VI - VI' of Figure 73. In Figure 72, the same reference numerals are used to denote the same elements as in Figure 68.

Referring to Figures 72 and 73, in the plasma chamber 300-5 of the present embodiment, the structure of a plasma source coil located on an outer surface of a dome 312 is different from those in other embodiments. That is, the plasma source coil is comprised of a plurality of unit coils, for example, first unit coils 3221a, 3221b, and 3221c, second unit coils 3222a, 3222b, and 3222c, and third unit coils 3223a, 3223b, and 3223c, which diverge from a central point O. In particular, these unit coils are distributed throughout a first region A2, which is located above, a second region B2, which is located below, and a third region C2, which is located between the first region A2 and the second region B2. More specifically, the first, second, and third unit coils 3221a, 3222a, and 3223a are arranged in a spiral shape around the central point O in the first region A1, which is located farther from the top surface of the dome 312 than the second or third region B1 or C1. For this, the first, second, and third unit coils 3221a, 3222a, and 3223a are arranged on an insulating material layer, for example, a ceramic layer 3218', located on the top surface of the dome 312. The ceramic layer 3218' has slant lateral surfaces. In this case, the first, second, and third unit coils 3221a, 3222a, and 3223a are spaced at least the thickness of the ceramic layer 3218' apart from the top surface of the dome 312. The ceramic layer 3218' may be replaced by air according to circumstances. If air replaces the ceramic layer 3218', the plasma chamber 300-5 may further require a support portion for supporting the first, second, and third unit coils 3221a, 3222a, and 3223a.

Once the unit coils 3221a, 3222a, and 3223a reach edges of the first region A2, they start extending in a spiral shape along the slant surfaces of the third region C2. That is, the first, second, and third unit coils 3221c, 3222c, and 3223c extend from the first, second, and third unit coils 3221a, 3222a, and 3223a, respectively, and coil the ceramic layer 3218' along the slant lateral surfaces of the ceramic layer 3218' until they reach the second region B2.

In the second region B2, which is located closer to the top surface of the dome 312 than the first and third regions A2 and C2, the first, second, and third unit coils 3221b, 3222b, and 3223b extend from the first, second, third unit coils 3221c, 3222c, and 3223c of the third region C2 and are arranged in a spiral shape. Thus, the second region B2 is located to surround the first region A2 and the third region C2. The first region A2 is located to correspond to a central portion of a wafer 308, the second region B2 is located to correspond to an edge of the wafer 308, and the third region C2 is located between the first and second regions A2 and B2. Although not shown in the drawing, the unit coils 3221a, 3221b, 3221c, 3222a, 3222b, 3222c, 3223a, 3223b, and 3223c are connected to an RF power supply (not shown) to receive RF power from the RF power supply.

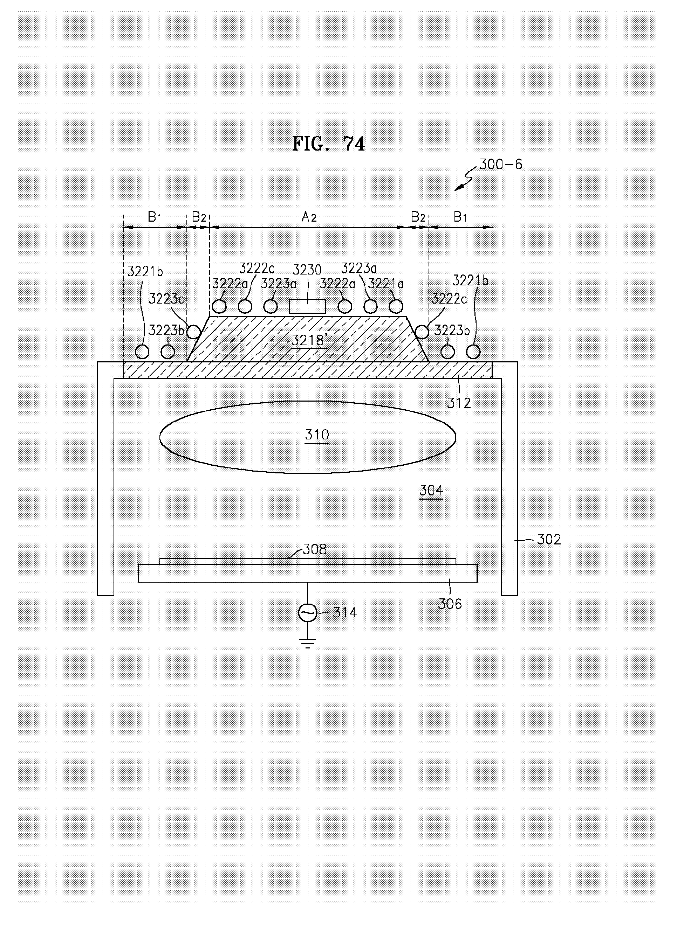

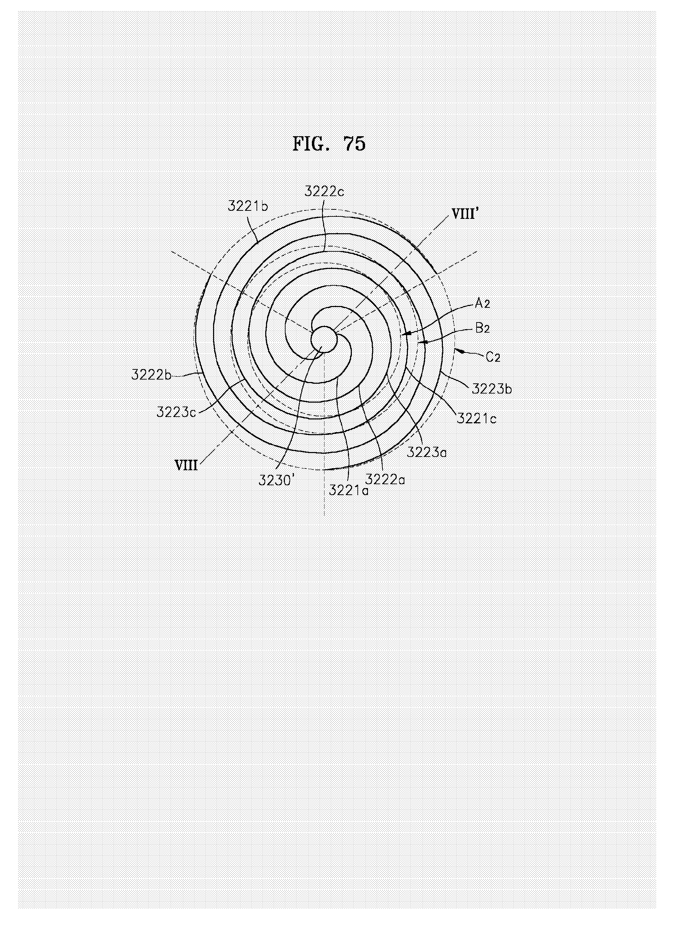

Figure 74 is a cross-sectional view of a plasma chamber according to another embodiment of the present invention. Figure 75 shows an example of a plasma source coil of the plasma chamber of Figure 74. The cross-sectional view of Figure 74 is taken along line VIII - VIII' of Figure 75. In Figure 74, the same reference numerals are used to denote the same elements as in Figure 70.

Referring to Figures 74 and 75, the structure of the plasma chamber 300-6 is similar to that of the plasma chamber 300-5 of Figure 72, except that a plasma source coil located on an outer surface of a dome 312 further comprises a coil bushing 3230'. That is, the coil bushing 3230' having a certain radius is located in the centre of a first region A2. A first unit coil 3221a, a second unit coil 3222a, and a third unit coil 3223a diverge from the coil bushing 3230' and are located in a spiral shape around the coil bushing 3230'. The coil bushing 3230' is formed of a conductive material and connected to an RF power supply (not shown) so as to supply RF power to the first, second, and third unit coils 3221a, 3222a, and 3223a. In the plasma chamber 300-6, the coil bushing 3230' is located above a central portion of a wafer 308, thus lowering the density of plasma in the central portion of the wafer 308 more effectively. As a result, the density of plasma can be uniform irrespective of positions of the wafer 308.

While preferred embodiments of the present invention have been particularly shown and described, it will be understood by those of ordinary skill in the art that various changes in form and details may be made therein without departing from the spirit and scope of the present invention as defined by the following claims.

In this specification, the verb "comprise" has its normal dictionary meaning, to denote non-exclusive inclusion. That is, use of the word "comprise" (or any of its derivatives) to include one feature or more, does not exclude the possibility of also including further features.

The reader's attention is directed to all and any priority documents identified in connection with this application and to all and any papers and documents which are filed concurrently with or previous to this specification in connection with this application and which are open to public inspection with this specification, and the contents of all such papers and documents are incorporated herein by reference.

This application claims the priorities of Korean Patent Applications No. 2003-42111, filed on June 26, 2003, No. 2003-44396, filed on July 1, 2003, No. 2003-45642, filed on July 7, 2003, No. 2003-48645, filed on July 16, 2003 and No. 2003-59138, filed on August 26, 2003 in the Korean Intellectual Property Office, the contents of which are incorporated herein in their entirety by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1.    A plasma source coil for generating plasma in a predetermined reaction space, the plasma source coil comprising:

    m unit coils, each of which has a number n of turns, which extend from a coil bushing having a predetermined radius in the centre of the plasma source coil and are arranged in a spiral shape around the coil bushing,

    wherein m is an integer more than or equal to 2, and n is a positive real number.

2.    A plasma source coil according to claim 1, wherein the coil bushing is formed of the same conductive material as the unit coils.

3.    A plasma source coil according to claim 2, wherein the unit coils and the coil bushing are formed of copper.

4.    A plasma source coil according to claim 1, 2 or 3, wherein the coil bushing has a shape selected from the group consisting of a circle, a circular donut, and polygons, such as a square, a square donut, a hexagon, a hexagonal donut, an octagon, an octagonal donut, and a triangle.

5.    A plasma source coil according to any of the preceding claims, wherein each of the unit coils has a shape selected from the group consisting of a circle, a circular donut, a semicircle, and polygons, such as a square, and a square donut.

6. A plasma source coil according to any of the preceding claims, wherein each of the unit coils is structured such that as the radial distance from the coil bushing increases, the interval between portions of the unit coil in the radial direction decreases.

7. A plasma source coil according to claim 6, wherein as radial distance from the coil bushing increases, the sectional area of the unit coil decreases.

8. A plasma source coil according to any of the preceding claims, wherein each of the unit coils is structured such that as the radial distance from the centre of the coil bushing increases, the sectional area of the unit coil decreases.

9. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil located on the dome of the chamber, the plasma source coil for including m unit coils, each of which has a number n of turns, which extend from a coil bushing having a predetermined radius in the centre of the plasma source coil and are arranged in a spiral shape around the coil bushing, wherein m is an integer more than or equal to 2, and n is a positive real number;

a support bar located in a certain central region of the coil bushing of the plasma source coil; and

an induction coil connected to the support bar, the induction coil for supplying power to the plasma source coil.

10. A plasma chamber according to claim 9, wherein the coil bushing and the support bar each are formed of the same conductive material as the unit coils of the plasma source coil.

11. A plasma chamber according to claim 10, wherein the unit coils, the coil bushing, and the support bar are formed of copper.

12. A plasma chamber according to claim 9, 10 or 11, wherein the coil bushing has a shape selected from the group consisting of a circle, a circular donut, and polygons, such as a square, a square donut, a hexagon, a hexagonal donut, an octagon, an octagonal donut, and a triangle.

13. A plasma chamber according to any of claims 9 to 12, wherein each of the unit coils has a shape selected from the group consisting of a circle, a circular donut, a semicircle, and polygons, such as a square and a square donut.

14. A plasma chamber according to any of claims 9 to 13, wherein each of the unit coils is structured such that as the radial distance from the coil bushing increases, interval between portions of the unit coil in the radial direction decreases.

15. A plasma chamber according to claim 14, wherein as radial distance from the coil bushing increases, the sectional area of the unit coil decreases.

16. A plasma chamber according to any of claims 9 to 15, wherein each of the unit coils is structured such that as the radial distance from the centre of the coil bushing increases, the sectional area of the unit coil decreases.

17. A plasma chamber according to any of claims 9 to 16, wherein the dome is formed of alumina.

18. A plasma chamber according to any of claims 9 to 17, wherein the dome comprises:

a lower dome exposed to the reaction space, the lower dome formed of a material having a first dielectric constant; and
an upper dome located on the lower dome, the upper dome formed of a second dielectric constant that is different from the first dielectric constant.

19. A plasma source coil for generating plasma in a predetermined reaction space, the plasma source coil comprising:

a bushing pillar located in a vertical direction, the bushing pillar having a first surface, which is a lower surface, and a second surface, which is an upper surface; and

m unit coils, which diverge from the bushing pillar on the same plane with the second surface of the bushing pillar and are arranged in a spiral shape along the circumference of the second surface of the bushing pillar, wherein when the two or more unit coils reach a certain radius, the unit coils extend on the same plane with the first surface of the bushing pillar while maintaining the certain radius.

20. A plasma source coil according to claim 19, further comprising an insulating pillar surrounding the bushing pillar between the first surface and the second surface, the insulating pillar being surrounded by the unit coils.

21. A plasma source coil according to claim 19 or 20, wherein m is an integer more than or equal to 2, each of the unit coils has a number n of turns, and n is a positive real number.

22. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil located on the dome of the chamber, the plasma source coil for comprising a bushing pillar located in a vertical direction, the bushing pillar having a first surface, which is a lower surface, and a second surface, which is an upper surface, and m unit coils, which diverge from the bushing pillar on the same plane with the second surface of the bushing pillar and are arranged in a spiral shape along the circumference of the second surface of the bushing pillar, wherein when the m unit coils reach a certain radius, the unit coils extend on the same plane with the first surface of the bushing pillar while maintaining the certain radius, and

an induction power supply connected to the bushing pillar of the plasma source coil, the induction power supply for supplying power to the unit coils.

23. A plasma chamber according to claim 22, further comprising an insulating pillar surrounding the bushing pillar between the first surface and the second surface, the insulating pillar being surrounded by the unit coils.

24. A plasma chamber according to claim 22 or 23, wherein m is an integer more than or equal to 2, each of the unit coils has a number n of turns on the same plane with the second surface of the bushing pillar, and n is a positive real number.

25. A plasma source coil for generating plasma in a predetermined reaction space, the plasma source coil comprising:

a coil bushing for receiving power; and

m unit coils, each of which has a number n of turns, which diverge from the coil bushing and are curved in wave shapes around the coil bushing,

wherein m is an integer more than or equal to 2, and n is a positive real number.

26. A plasma source coil according to claim 25, wherein the unit coils are arranged in a spiral shape around the coil bushing.

27. A plasma source coil for generating plasma in a predetermined reaction space, the plasma source coil comprising:

a first plasma source region including m first unit coils, which diverge from a coil bushing for receiving power and are arranged in a spiral shape around the coil bushing; and

a second plasma source region including m second unit coils, which extend from the first unit coils of the first plasma source region and are curved in wave shapes to surround the first plasma source region,

wherein m is an integer more than or equal to 2.

28. A plasma source coil for generating plasma in a predetermined reaction space, the plasma source coil comprising:

a bushing pillar located in a vertical direction, the bushing pillar having a first surface, which is a lower surface, and a second surface, which is an upper surface; and

m unit coils, which diverge from the bushing pillar on the same plane with the second surface of the bushing pillar and are curved in wave shapes to surround the bushing pillar, wherein when the m unit coils reach a certain radius, the unit coils extend on the same plane with the first surface of the bushing pillar while maintaining the certain radius.

29. A plasma source coil according to claim 28, further comprising an insulating pillar surrounding the bushing pillar between the first surface and the second surface, the insulating pillar surrounded by the unit coils.

30. A plasma source coil according to claim 28 or 29, wherein m is an integer more than or equal to 2, each of the unit coils has a number n of turns on the same plane with the second surface of the bushing pillar, and n is a positive real number.

31. A plasma source coil comprising:

a chamber having outer walls and a dome, a reaction space of the chamber being defined by the outer walls and the dome;

a wafer support located at a lower portion of the chamber, the wafer support for supporting semiconductor wafers;

a coil bushing and a plasma source coil including m unit coils, which diverge from the coil bushing and are arranged to surround the coil bushing, wherein m is an integer more than or equal to 2; and

an induction power supply for supplying power to the unit coils via the coil bushing.

32. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil including a first plasma source region including m first unit coils, which diverge from a coil bushing and are arranged in a spiral shape around the coil bushing and a second plasma source region including m second unit coils, which extend from the first unit coils of the first plasma source region and are curved in wave shapes to surround the first plasma source region, wherein m is an integer more than or equal to 2; and

an induction power supply for supplying power to the unit coils via the coil bushing.

33. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil including a bushing pillar located in a vertical direction, the bushing pillar having a first surface, which is a lower surface, and a second surface, which is an upper surface, and m unit coils, which diverge from the bushing pillar on the same plane with the second surface of the bushing pillar and are curved in wave shapes to surround the bushing pillar, wherein when the m unit coils reach a certain radius, the unit coils extend on the same plane with the first surface of the bushing pillar while maintaining the certain radius; and

an induction power supply connected to the bushing pillar, the induction power supply for supplying power to the unit coils.

34. A plasma chamber according to claim 33, further comprising an insulating pillar surrounding the bushing pillar between the first surface and the second surface, the insulating pillar being surrounded by the unit coils.

35. A plasma chamber according to claim 33 or 34, wherein m is an integer more than or equal to 2, each of the unit coils has a number n of turns, and n is a positive real number.

36. A plasma source coil for generating plasma in a predetermined reaction space, the plasma source coil comprising:

a conductive bushing located in the centre of plasma source coil, the conductive bushing for directly receiving power from a power supply; and

one or more coil lines, which diverge from the conductive bushing and are arranged around the conductive bushing,

wherein each of the coil lines is located such that currents flow through adjacent portions of the coil line in the opposite directions.

37. A plasma source coil according to claim 36, wherein the coil lines diverge from the conductive bushing and are arranged such that clockwise coil lines and counterclockwise coil lines are alternately located.

38. A plasma source coil according to claim 36 or 37, wherein the conductive bushing has a fan blade shape.

39. A plasma source coil according to claim 36, 37 or 38, wherein the coil lines include a plurality of coil lines, which diverge from the conductive bushing and are symmetrical with respect to the conductive bushing.

40. A plasma source coil according to any of claims 36 to 39, wherein the coil lines include a plurality of coil lines, which diverge from adjacent portions of the conductive bushing.

41. A plasma source coil according to any of claims 36 to 40, further comprising a first ground line and a second ground line, which are spaced a predetermined interval apart from the conductive bushing symmetrically with respect to the conductive bushing.

42. A plasma source coil according to claim 41, wherein the coil lines comprise:

a first coil line, which diverges from a first position of the conductive bushing and is located to surround the first ground line in a fan blade shape; and

a second coil line, which diverges from a second position of the conductive bushing, which is opposite to the first position, and is located to surround the second ground line in a fan blade shape.

43. A plasma source coil according to claim 41, wherein the coil lines comprise:

a first coil line, which diverges from a first position of the conductive bushing and is located to surround the first ground line in a fan blade shape; and

a second coil line, which diverges from a second position of the conductive bushing, which is adjacent to the first position, and is located to surround the second ground line in a fan blade shape.

44. A plasma source coil according to any of claims 36 to 40, further comprising a first ground line, a second ground line, a third ground line, and a fourth ground line, which are spaced a predetermined interval apart from the conductive bushing symmetrically with respect to the conductive bushing.

45. A plasma source coil according to claim 44, wherein the coil lines comprise:

a first coil line, which diverges from a first position of the conductive bushing and is located to surround the first ground line in a fan blade shape;

a second coil line, which diverges from a second position of the conductive bushing and is located to surround the second ground line in a fan blade shape;

a third coil line, which diverges from a third position of the conductive bushing and is located to surround the third ground line in a fan blade shape; and

a fourth coil line, which diverges from a fourth position of the conductive bushing and is located to surround the fourth ground line in a fan blade shape.

46. A plasma source coil according to claim 44, wherein the coil lines comprise:

a first coil line, which diverges from a first position of the conductive bushing and is located to surround the first ground line in a spiral shape;

a second coil line, which diverges from a second position of the conductive bushing and is located to surround the second ground line in a spiral shape;

a third coil line, which diverges from a third position of the conductive bushing and is located to surround the third ground line in a spiral shape; and

a fourth coil line, which diverges from a fourth position of the conductive bushing and is located to surround the fourth ground line in a spiral shape.

47. A plasma source coil according to any of claims 36 to 46, wherein the coil lines are arranged to surround the conductive bushing in a spring shape in a first region having a relatively small radius, and the coil lines are arranged to surround the first region in a spiral shape in a second region having a relatively large radius.

48. A plasma source coil for generating plasma in a predetermined reaction space, the plasma source coil comprising:

a plurality of conductive bushings spaced a regular interval apart from one another, the conductive bushings for directly receiving power from a power supply; and

a plurality of coil lines, which diverge from the respective conductive bushings and are arranged to surround the conductive bushings in a spiral shape.

49. A plasma source coil according to claim 48, wherein the coil lines surround the conductive bushings in the same direction.

50. A plasma source coil according to claim 48, wherein only coil lines facing each other among the coil lines are located to surround in the same direction.

51. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil plasma source coil comprising a conductive bushing located in the centre of plasma source coil, the conductive bushing for directly receiving power from a power supply, and one or more coil lines, which diverge from the conductive bushing and are arranged around the conductive bushing, wherein each of the coil lines is located such that currents flow through adjacent portions of the coil line in the opposite directions; and

an induction power supply connected to the conductive busing, the induction power supply for supplying power to the coil lines.

52. A plasma source coil for generating plasma in a predetermined reaction space, the plasma source coil comprising:

a first coil portion comprised of two or more first unit coils, which diverge from a central point of a first region, which corresponds to a centre of the reaction space and is spaced a first distance apart from the reaction space, and are located in a spiral shape around the central point of the first region; and

a second coil portion comprised of two or more second unit coils, which extend from the first unit coils and are located in a spiral shape around the first region in a second region, which corresponds to an edge of the reaction space, surrounds the first region, and is spaced a second distance apart from the reaction space,

wherein the second distance is shorter than the first distance.

53. A plasma source coil for generating plasma, the plasma source coil comprising:

a coil bushing located in the centre of a first region, which corresponds to a central portion of the reaction space and is spaced a first distance apart from the reaction space;

a first coil portion comprised of two or more first unit coils, which diverge from the coil bushing in the first region and are arranged in a spiral shape around the coil bushing; and

a second coil portion comprised of two ore more second unit coils, which extend from the first unit coils and are arranged in a spiral shape around the first region in a second region, which corresponds to an edge of the reaction space, surrounds the first region, and is spaced a second distance apart from the reaction space,

wherein the second distance is shorter than the first distance.

54. A plasma source coil for generating plasma, the plasma source coil comprising:

a first coil portion comprised of two or more first unit coils, which diverge from a central point of a first region, which corresponds to a central portion of the reaction space and is spaced a first distance from the reaction space, and are arranged in a spiral shape around the central point of the first region;

a second coil portion comprised of two or more second unit coils, which are arranged in a spiral shape around the first region in a second region, which corresponds to an edge of the reaction space and is spaced a second distance apart from the reaction space; and

a third coil portion comprised of two or more third unit coils, which extend from the first unit coils to the second unit coils in a vertical direction in a third region, which is formed of slant lateral surfaces of the plasma source coil between the first region and the second region,

wherein the second distance is shorter than the first distance.

55. A plasma source coil for generating plasma, the plasma source coil comprising:

a coil bushing located in the centre of a first region, which corresponds to a central portion of the reaction space and is spaced a first distance apart from the reaction space;

a first coil portion comprised of two or more first unit coils, which diverge from the coil bushing in the first region and are arranged in a spiral shape around the coil bushing;

a second coil portion comprised of two or more second unit coils, which are arranged in a spiral shape around the first region in a second region, which corresponds to an edge of the reaction space and is spaced a second distance apart from the reaction space; and

a third coil portion comprised of two or more third unit coils, which extend from the first unit coils to the second unit coils in a vertical direction in a third region, which is formed of slant lateral surfaces of the plasma source coil between the first region and the second region,

wherein the second distance is shorter than the first distance.

56. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil comprising a first coil portion comprised of two or more first unit coils, which diverge from a central point of a first region, which corresponds to a centre of the reaction space and is spaced a first distance apart from the reaction space, and are located in a spiral shape around the central point of the first region, and a second coil portion comprised of two or more second unit coils, which extend from the first unit coils and are located in a spiral shape around the first region in a second region, which corresponds to an edge of the reaction space, surrounds the first region, and is spaced a second distance apart from the reaction space, wherein the second distance is shorter than the first distance; and

an induction power supply for supplying power to the unit coils via the coil bushing.

57. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil comprised of a coil bushing located in the centre of a first region, which corresponds to a central portion of the reaction space and is spaced a first distance apart from the reaction space, a first coil portion comprised of two or more first unit coils, which diverge from the coil bushing in the first region and are arranged in a spiral shape around the coil bushing, and a second coil portion comprised of two ore more second unit coils, which extend from the first unit coils and are arranged in a spiral shape around the first region in a second region, which corresponds to an edge of the reaction space, surrounds the first region, and is spaced a second distance apart from the reaction space, wherein the second distance is shorter than the first distance;

an induction power supply for supplying power to the unit coils via the coil bushing.

58. A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil comprising a first coil portion comprised of two or more first unit coils, which diverge from a central point of a first region, which corresponds to a central portion of the reaction space and is spaced a first distance from the reaction space, and are arranged in a spiral shape around the central point of the first region, a second coil portion comprised of two or more second unit coils, which are arranged in a spiral shape around the first region in a second region, which corresponds to an edge of the reaction space and is spaced a second distance apart from the reaction space, and a third coil portion comprised of two or more third unit coils, which extend from the first unit coils to the second unit coils in a vertical direction in a third region, which is formed of slant lateral surfaces of the plasma source coil between the first region and the second region, wherein the second distance is shorter than the first distance; and

an induction power supply for supplying power to the unit coils via the coil bushing.

**59.** A plasma chamber comprising:

a chamber having outer walls and a dome, a reaction space of the chamber being defined by the outer walls and the dome;

a wafer support located at a lower portion of the chamber, the wafer support for supporting semiconductor wafers;

a plasma source coil comprised of a coil bushing located in the centre of a first region, which corresponds to a central portion of the reaction space and is spaced a first distance apart from the reaction space, a first coil portion comprised of two or more first unit coils, which diverge from the coil bushing in the first region and are arranged in a spiral shape around the coil bushing, a second coil portion comprised of two or more second unit coils, which are arranged in a spiral shape around the first region in a second region, which corresponds to an edge of the reaction space and is spaced a second distance apart from the reaction space, and a third coil portion comprised of two or more third unit coils, which extend from the first unit coils to the second unit coils in a vertical direction in a third region, which is formed of slant lateral surfaces of the plasma source coil between the first region and the second region, wherein the second distance is shorter than the first distance; and

an induction power supply for supplying power to the unit coils via the coil bushing.

**60.** A plasma chamber comprising:

a chamber having outer walls and a dome, a reaction space of the chamber being defined by the outer walls and the dome, wherein the dome has a protrusion toward the reaction space in a first region corresponding to a central portion of the reaction space such that the thickness of the first region is thicker than the thickness of a second region, which surrounds the first region;

a wafer support located at a lower portion of the chamber, the wafer support for supporting semiconductor wafers;

a plasma source coil comprised of a coil bushing located in the first region of the dome and two or more unit coils, which diverge from the coil bushing in the second region of the dome and are located in a spiral shape around the coil bushing; and

an induction power supply for supplying power to the unit coils via the coil bushing.

**61.** A plasma chamber comprising:

a chamber having outer walls and a dome, a reaction space of the chamber being defined by the outer walls and the dome, wherein the dome includes a protrusion toward the outside of the dome in an opposite direction of the reaction space in a first region corresponding to a central portion of the reaction space such that the thickness of the first region is thicker than a second region, which surrounds the first region;

a wafer support located at a lower portion of the chamber, the wafer support for supporting semiconductor wafers;

a plasma source coil comprised of a coil bushing located in the first region of the dome and two or more unit coils, which diverge from the coil bushing in the second region of the dome and are arranged in a spiral shape around the coil bushing; and

an induction power supply for supplying power to the unit coils via the coil bushing.

**62.** A plasma chamber comprising:

a chamber having outer walls and a dome, a reaction space of the chamber being defined by the outer walls and the dome, wherein the dome includes a protrusion toward the outside of the dome in an opposite direction of the reaction space in a region corresponding to a central portion of the reaction space;

a wafer support located at a lower portion of the chamber, the wafer support for supporting semiconductor wafers;

a coil bushing located in the centre of the region of the dome that corresponds to the centre of the reaction space;

a plasma source coil comprised of first unit coils, which extend from the coil bushing in a first region surrounding the coil bushing and coil around the protrusion in a vertical direction, and second unit coils, which extend from the first unit coils in a second region surrounding the first region and are arranged on the dome so as to surround the first region in a horizontal direction; and

an induction power supply for supplying power to the unit coils via the coil bushing.

FIG. 1

FIG. 2

FIG. 3

FIG. 4A

FIG. 4B

FIG. 5A

FIG. 5B

## FIG. 5C

INTERVAL
(d)

0                                RADIAL DISTANCE
(x)

## FIG. 6

x

A'

d'

210

201c

EP 1 492 154 A2

FIG. 6B

FIG. 6C

FIG. 7A

210a

FIG. 7B

210b'

210b

FIG. 7C

210c

FIG. 7D

210d

FIG. 7E

210e'

210e

FIG. 7F

210f

FIG. 7G

210g

FIG. 7H

210h

FIG. 7I

210i

FIG. 7J

210j

FIG. 7K

210k

FIG. 8A

201−1

FIG. 8B

201−2

FIG. 8C

201-3

FIG. 8D

201-4

FIG. 8E

201-5

FIG. 9

FIG. 10

FIG. 11

$\varepsilon_2$

$\varepsilon_1$

312b    312a

312

FIG. 12

211-11

210-11    201-11    202-11    203-11

360-11

340-11

312-11

FIG. 13

FIG. 14

FIG. 15

FIG. 16

FIG. 17

213-16

350-12

202-16

201-16

203-16

360-16

340-16

312-16

210-16

FIG. 18

213-17

210-17

202-17

201-17

203-17

360-17

340-17

312-17

350-13

## FIG. 19

213-18

210-18
201-18
202-18
203-18

360-18
340-18
312-18

350-14

## FIG. 20

211-19

210-19
201-19
202-19
203-19

360-19
340-19
312-19

350-15

**FIG. 21**

211-20

210-20   201-20   202-20   203-20

360-20
340-20
312-20

350-16

**FIG. 22**

211-21

210-21   201-21   202-21   203-21

360-21
340-21
312-21

350-17

## FIG. 23

## FIG. 24

## FIG. 25

## FIG. 26

## FIG. 27

211-26

210-26  201-26  202-26  203-26

360-26

340-26

312-26

350-22

## FIG. 28

211-27

210-27  201-27  202-27  203-27

360-27

340-27

312-27

FIG. 29

FIG. 30

FIG. 31

FIG. 32

FIG. 33

211-32

210-32    201-32    202-32    203-32

360-32
340-32
312b-11
312a-11

FIG. 34

211-33

210-33    201-33    202-33    203-33

360-33
340-33
312b-12
312a-12

350-26

FIG. 35

211-34

210-34  201-34  202-34  203-34

360-34
340-34
312b-13
312a-13

350-27

FIG. 36

211-35

210-35  201-35  202-35  203-35

360-35
340-35
312b-14
312a-14

## FIG. 37

211-36

210-36  201-36  202-36  203-36

360-36
340-36
312b-15
312a-15

350-28

## FIG. 38

211-37

210-37  201-37  202-37  203-37

360-37
340-37
312b-16
312a-16

FIG. 39

211-38

210-38

201-38

202-38

203-38

360-38
340-38
312b-17
312a-17

350-29

FIG. 40

211-39

210-39

201-39

202-39

203-39

360-39
340-39
312b-18
312a-18

## FIG. 41

211-40

210-40
201-40
202-40
203-40

360-40
340-40
312b-19
312a-19

## FIG. 42

211-41

210-41
201-41
202-41
203-41

360-41
340-41
312b-20
312a-20

**FIG. 43**

**FIG. 44**

FIG. 45

FIG. 46

FIG. 47

FIG. 48

FIG. 49

FIG. 50

EP 1 492 154 A2

**FIG. 51A**

**FIG. 51B**

FIG. 52

FIG. 53

FIG. 54

FIG. 55

EP 1 492 154 A2

FIG. 56

FIG. 57

FIG. 58

FIG. 59

FIG. 60

FIG. 61

FIG. 62

2034    2231    2200
2014    2211
2224    2221
2200d    2200a
2200c
2223    2200b
2222
2213    2212
2233    2232

FIG. 63

2300
2320a
2320b    2320
2310
2320c
2320d

FIG. 64

2400

2420

2420a

2420b

2420c

2420d

2410

2421

2421

FIG. 65

2500

2520

2510

2500a

FIG. 66

FIG. 67

FIG. 68

FIG. 69

FIG. 70

FIG. 71

FIG. 72

FIG. 73

# FIG. 74

FIG. 75